(19) Europäisches Patentamt
European Patent Office
Office européen des brevets

(11) EP 0 797 878 B1

(12) **EUROPEAN PATENT SPECIFICATION**

(45) Date of publication and mention of the grant of the patent:
**27.03.2002 Bulletin 2002/13**

(21) Application number: **95936630.3**

(22) Date of filing: **08.11.1995**

(51) Int Cl.$^7$: **H04L 5/06**

(86) International application number:
**PCT/GB95/02610**

(87) International publication number:
**WO 96/19055 (20.06.1996 Gazette 1996/28)**

(54) **OFDM WITH VARIABLE SUBCARRIER ALLOCATION**

OFDM MIT VERÄNDERBARER UNTERTRÄGERZUWEISUNG

OFDM AVEC ATTRIBUTION DE SOUS-PORTEUSES VARIABLES

(84) Designated Contracting States:
**DE FR IT**

(30) Priority: **15.12.1994 GB 9425327**

(43) Date of publication of application:
**01.10.1997 Bulletin 1997/40**

(60) Divisional application:
**01120129.0 / 1 161 025**

(73) Proprietor: **Inmarsat Ltd.**
**London EC1Y 1AX (GB)**

(72) Inventors:
- **PIERZGA, Wayne, Francis**
  **Cuffley, Herts EN6 4RG (GB)**
- **GUINAND, Paul, Scott**
  **Nepean, Ontario KZB 7T1 (CA)**
- **LODGE, John, Harrison**
  **Kanata, Ontario K2L 2C9 (CA)**
- **CROZIER, Stewart, Newman**
  **Kanata, Ontario K2K 2N9 (CA)**
- **YOUNG, Richard, John**
  **Kanata, Ontario K2M 1V4 (CA)**

(74) Representative: **Musker, David Charles et al**
**R.G.C. Jenkins & Co.**
**26 Caxton Street**
**London SW1H 0RJ (GB)**

(56) References cited:
**WO-A-86/07223**
**WO-A-95/07581**
**GB-A- 2 270 819**
**GB-A- 2 291 314**
**US-A- 5 400 322**

- **ELECTRONICS LETTERS, vol. 29, no. 15, 22 July 1993, pages 1354-1355, XP002001147 MESTDAGH ET AL.: "Effect of amplitude clipping in DMT-ADSL transceivers"**
- **ELECTRONICS LETTERS, vol. 30, no. 25, 8 December 1994, pages 2098-2099, XP002001148 JONES ET AL: "Block coding scheme for reduction of peak to mean envelope power ratio of multicarrier transmission schemes"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

FIELD OF THE INVENTION

This invention relates to apparatus and methods of frequency multiplexed communication; particularly, but not exclusively, to orthogonal frequency division multiplexing (OFDM); particularly, but not exclusively, to broadcasting using such multiplexing; particularly, but not exclusively, to broadcasting digital information.

DESCRIPTION OF THE BACKGROUND ART

In frequency division multiplexing, one or more information bearing signals are communicated by modulating them onto a plurality of frequency subcarriers at different frequencies. In general, the carrier frequencies are separated by an interval at least equal to the bandwidth of the information carrying signal on each carrier frequency, although in orthogonal frequency division multiplexing (OFDM) this constraint can be relaxed slightly; in OFDM, the carriers are separated in frequency by $\Delta=1/T$, where T is the duration of each transmitted information signal, such that the centre of one band lies in the first null in the neighbouring band. Thus, although the bands around each carrier do overlap, they can nonetheless be separated by appropriate filtering as they are mutually orthogonal.

It is known to employ frequency division multiplexing together with redundant error correcting encoding, time interleaving of each information carrying signal, and distribution of each information carrying signal over the different carrier frequencies; this is disclosed in, for example, "Evaluation of error correction block encoding for high speed HF Data" - Brayer, K. and Cardinale, O.; IEEE Transactions on Communication Technology vol. COM - 15 No. 3, June 1967, "A combined coding and modulation approach for communication over dispersive channels" - Chase, D.; IEEE Transactions on Communications vol. COM - 21 No. 3, March 1973, and "Performance of selected block and convolutional codes on a fading HF channel" - Cohn D., Levesque, A.H., Meyn, J.H., Pierce, A.W.; IEEE Transactions on Information Theory, vol. IT = 14, No. 5, September 1968. More recent examples are US 4881241, US 4884139, US 5191576, US 5197061, US 5228025, US 5274629, US 5307376 and WO-A-860723.

SUMMARY OF THE INVENTION

In broadcast communications, a receiver may attempt to acquire the signal at any stage, without the transmitter being aware of this. Aspects of the present invention are defined in claims 1, 14, 15, 18, 20, 25, 29 and 30. The present invention, in one aspect, provides a frequency multiplex communication broadcast system in which the transmitter can vary the number of subcarriers in the multiplexed signal from time to time, and transmits periodically, on a particular subcarrier at a predetermined frequency, a signal specifying the number of subcarriers present in the multiplex (and, optionally, other information useful to a receiver).

Conveniently, the subcarrier carrying this information (hereafter termed the main reference subcarrier) is located at a constant frequency which forms one edge of the multiplex. Thus, the receiver is always able to acquire the data specifying the number of subcarriers, even during an existing broadcast.

Thus, transmitters are able to assign capacity amongst the different services sharing the RF link such that when more capacity is required for one service and less for another, the capacity can be dynamically reallocated. Only the bandwidth required for the currently active services is consumed, thus improving the economy of use of the RF channel.

Preferably, the main reference subcarrier is located at one edge of the multiplex, at a predetermined frequency. Since other subcarriers are located only on one side of the reference subcarrier (along the frequency axis), the amount of interference is thereby reduced where, for example, symbol synchronization (and hence orthogonality) has not been fully acquired).

Preferably, the transmitter includes a transmit filtering circuit, which can selectively apply a plurality of different filtering characteristics in dependence upon the size of the ensemble, each filtering characteristic being arranged to pass a respective ensemble size and attenuate at least some sidelobes of the outer subcarriers of the ensemble. Thus, the relatively wide spectrum of the OFDM signal is constrained to match whichever ensemble size is used. Similarly, at the receiver, additionally or alternatively, a receiver filter is provided which is set to match the size of ensemble indicated to be present by the received signal.

Preferably, each subcarrier carries a number of orthogonal data channels (for example two), each of which can be modulated independently. In the case of two channels per subcarrier, this may conveniently be achieved by providing one channel on the in phase (I) component, and the other on the quadrature (Q) component, of a complex modulator at the transmitter. Thus, when new channels are to be added, additional quadrature/amplitude constellation elements may be added to an existing subcarrier before it is necessary to add a new subcarrier. Where there are two channels per subcarrier, each subcarrier may carry either a single channel (in which case the modulation is binary phase shift keying (BPSK)) or two channels (in which case the modulation is quadrature phase shift keying (QPSK)). Thus, conveniently, the power of each channel is the same in this embodiment.

This aspect of the invention therefore concerns a communications system, the signal generated therein, and the transmitter and receiver for respectively transmitting or receiving the signal.

Viewed another way, this aspect of the invention concerns an OFDM signal (and transmitter and receiver therefore) in which the channels carrying information are each modulated (preferably amplitude modulator) onto one of two orthogonal components on each of the subcarriers.

A further preferred aspect of the invention is concerned with improving the spectral efficiency of OFDM signals. OFDM signals are attractive in that the subcarriers are spaced closely together without substantially interfering with each other due to the property of orthogonality. However, the (sin $\chi/\chi$) spectral shape of the OFDM subcarriers results in a very large number of relatively high amplitude sidelobes extending beyond the centre frequency of the lowest frequency subcarrier and the centre frequency of the highest frequency subcarrier. These sidelobes cannot simply be eliminated by brick wall filtering, because this would degrade the orthogonality of the signal, resulting in co-channel interference at the receiver.

Accordingly, in this preferred aspect of the invention, the OFDM signal is filtered at the transmitter and/or the receiver so as to pass all the subcarriers and at least a portion of the first outer sidelobe of the outer subcarriers. Preferably, the transition frequency of the filter passes through the first sidelobe, so that the attenuation inherent between the first and second sidelobes of the OFDM signal assists the attenuation of the filter. Preferably, the filter has nulls positioned within each of the outer sidelobes to be attenuated, well away from the nulls between the sidelobes. Thus, the filter makes use of the attenuation already present to some extent in the OFDM signal itself. We have found that such filtering at the transmitter and preferably at the receiver greatly improves the spectral efficiency of the OFDM multiplexed signal without too greatly degrading the orthogonality thereof.

Other aspect and embodiments of the invention will be apparent to the skilled reader from the following description and claims.

## BRIEF DESCRIPTION OF THE DRAWINGS

The invention will now be described, by way of example only, with reference to the accompanying drawings in which:

Figure 1 is a block diagram showing schematically the elements of a communications system according to one embodiment of the invention;
Figure 2 is a plan indicating the organisation of information channels in the system of Figure 1;
Figure 3 is a diagram showing a frequency multiplexed signal along the frequency axis, employed in the system of Figure 1;
Figure 4 is a diagram of frequency against time, indicating schematically the contents over time of the multiplexed signal of Figure 3;
Figure 5a-5c are format diagrams illustrating the time multiplexing of information-carrying signals to be modulated onto the multiplexed signal of Figure 3;
Figure 6a is a table indicating, for different arrangements of subcarriers in the multiplexed signal of Figure 3, the position in frequency of data and reference signal-carrying subcarriers;
Figure 6b is a diagram illustrating, over time, the positions of reference and data signals in the multiplexed signal of Figure 3;
Figure 7 is a diagram showing, for one of the subcarriers of Figures 3 to 6, a guard interval around each symbol;
Figure 8 is a block diagram showing schematically the elements of a transmitter station of the system of Figure 1;
Figure 9 is a block diagram showing schematically the data formatting portion of Figure 8;
Figure 10a is flow diagram showing schematically the major steps in signal encoding; and
Figure 10b is a corresponding flow diagram showing the major steps in signal decoding;
Figure 11 is a block diagram showing the contents of a byte interleaver forming part of Figure 9;
Figure 12 is a block diagram showing schematically the structure of a scrambler forming part of Figure 9;
Figure 13 is a block diagram showing schematically the structure of a convolutional coder forming part of Figure 9;
Figure 14 is a block diagram showing schematically the base band processing components of the transmitter of Figure 8;
Figure 15a is a plot of the power spectrum of the signal of Figure 3, before and after filtering, and
Figure 15b shows the frequency response to a filter forming part of Figure 14;
Figure 16a-c are block diagrams showing components of Figure 14 for processing small multiplex signals comprising, respectively, one, two or three subcarriers;
Figure 17 is a block diagram showing schematically the structure of a receiver forming part of the system of Figure 1;

Figure 18 is a block diagram showing the receiver components of Figure 17 in greater detail;

Figure 19 is a block diagram showing in greater detail the symbol timing synchronisation circuit forming part of the receiver of Figure 18;

Figure 20 is a block diagram showing the structure of a frequency tracking circuit forming part of the receiver of Figure 18;

Figure 21 is a block diagram showing in greater detail the structure of a baseband processing circuit forming part of the receiver of Figure 18;

Figure 22 is a block diagram showing in greater detail the structure of a preliminary detector forming part of the base band processing circuit of Figure 21;

Figure 23 is a block diagram showing in greater detail an acquisition circuit forming part of the receiver of Figure 18;

Figure 24 is a block diagram showing in greater detail a frequency acquisition circuit forming part of the acquisition circuit of Figure 23;

Figure 25 is a block diagram showing in greater detail the structure of a frequency estimation circuit forming part of the frequency acquisition circuit of Figure 24;

Figures 26a-c are complex plane diagrams showing the processing of signals within the circuit of Figure 25;

Figure 27 is a block diagram showing the structure of a deformatting circuit forming part of the receiver of Figure 18;

Figure 28 illustrates an alternative baseband processing circuit for coherent detection to that shown in Figure 21; and

Figures 29a-c show alternative preliminary detectors to that shown in Figure 22.

## DESCRIPTION OF PREFERRED EMBODIMENT

### System Overview

Referring to Figure 1, the system according to the present invention comprises at least one earth station, 100a, 100b, 100c, in communication with at least one repeater satellite 200a, 200b, 200c orbiting the earth, and broadcasting to at least one receiver station 300a-300f.

The earth stations 100a-100c comprise conventional satellite tracking and RF transmission components, together with the novel circuitry described hereafter. Each earth station 100a-100c is connected to one or more broadcast data sources 400a-400i, which supply, for example, digital audio channels for broadcasting, each comprising a stream of bits carrying an audio signal.

The satellites 200a-200c may be disposed in intermediate circular orbits or geostationary orbits, or in low earth orbits. Each satellite 200 is generally conventional, and operates to generate a global beam or a plurality of spot beams illuminating different regions of the earth surface beneath the satellite.

Each receiver station 300 may comprise a mobile receiver terminal within, for example, a car, a lorry, an airplane or a boat; or may comprise a fixed receiver terminal.

In addition to, or instead of, audio signals, the earth stations may also be connected to sources of data transmission for data services such as news, sport, weather and stock quote services, the data representing (for example) ASCII codes of text files. Equally, the input data signals to the earth stations 100 may carry facsimile or video data.

In the embodiment to be described, the data signals received by the earth stations 100 are of two types; firstly, data signal streams (e.g. of audio or video data) representing continuous streams of data, and secondly page-type services representing smaller files of data (such as pages of news, stock quotes and weather reports, or other data typically currently transmitted as Teletext). The latter will be referred to hereafter as datagram signals.

The bit rates for each type of data signal may range between 2 kilobits per second to 64 kilobits per second.

The frequency of the broadcast from the satellite 200 may, for example, lie within the MSS band 1524-1559 mHz or the WARC-92 BSS(S) bands 1452-1492 mHz and 2655 to 2670 mHz.

Referring to Figure 2, each beam generated by each satellite 100 carries at least one OFDM multiplexed signal, each multiplexed signal being referred to hereafter as a "station" (by way of analogy with a conventional analogue radio station). Each such station carries one or more services, each corresponding to an information signal input to the earth station 100. One service may occur on several beams, to achieve a desired regional or global coverage. Each composite multiplexed OFDM signal is adjustable, to alter the data rate and bandwidth, as will be discussed in greater detail below. Thus, the requirements of the broadcast system can be adjusted to account for a change in the number of services, or bandwidth required for each service.

### Signal format

Referring to Figure 3, in this embodiment the transmitted multiplexed signal S comprises a plurality of subcarrier signals, at subcarrier frequencies evenly spaced by $\Delta$, where $\Delta$ is the increment for orthogonal frequency displacement. Each frequency f can carry either one or two channels. The number of channels is variable, in use, by varying the number of subcarrier frequencies and by varying the number of channels on each frequency. One subcarrier (the reference subcarrier hereafter) is always present, at a predetermined frequency $f_R$. The number of other subcarriers is variable, and each additional subcarrier occupies a progressively higher frequency. It is possible for the highest frequency subcarrier (i.e. the outer edge subcarrier) to carry either one channel or two channels; all other subcarriers carry two channels. In this way, bandwidth usage is kept to a minimum.

All subcarriers carrying two channels (that is to say, all except the extreme edge subcarrier, and possibly that too) are modulated using quadrature phase shift keying (QPSK). One bit from channel modulates the in phase (I) component of the subcarrier, and one bit from the other channel modulates the quadrature (Q) component, to produce the following bit/symbol mapping:

| Bits (ordered bit(t),bit(t+1)) | Complex symbol,c $\|c\|^2=1$ |
|---|---|
| 00 | +I+j |
| 01 | +I-j |
| 10 | -I+j |
| 11 | -I-j |

Where the extreme edge subcarrier carries only one channel (as shown in Figure 3) the bits from the channel modulate the in phase (I) component, to produce the following bit/symbol mapping:

| Bits (ordered bit(t),bit(t+1)) | Complex symbol,c $\|c\|^2=1$ |
|---|---|
| 1 | +I |
| 0 | -I |

Thus, where a single carrier is present, the modulation is BPSK. The energy of the signal on a subcarrier carrying only one channel is thus half that of the energy of a subcarrier carrying two channels; i.e. in every case, the energy of the multiplexed signal S is proportion to the number of channels c present.

Referring to Figure 4, the multiplexed signal S is transmitted in a regular time-divided fashion, consisting of frames of data each of duration 0.504 seconds and superframes comprising eight such frames and of duration of 4.032 seconds. The superframe length is of the order of several seconds, to permit time interleaving, to distribute burst errors over time and frequency as will be discussed in greater detail below.

Each frame is preceded by the transmission, on the reference frequency $f_R$, of a data signal indicating the current allocation of subcarriers and channels, referred to herein as the "ensemble plan" (EP). Since the number of channels is variable, this information is required by the receiver prior to full reception of the multiplexed signal. In this embodiment, eight bits are required for describing the number of channels, (i.e. half subcarrier increments); and various other bits are used as flags to indicate parity options, coding options and so on, to a total of 42 bits.

The ensemble plan data is prefixed by a so-call "unique word", being a low autocorrelation code word uniquely recognisable by the decoder; for example, a 32 bit word. Prior to the frame which precedes the start of the next superframe, rather than transmitting the unique word, the binary complement of the unique word is transmitted. Thus, by detecting unique words, the receiver can determine frame and superframe boundaries, and subsequently derive the data describing the format of the multiplexed signal S, from the reference subcarrier $f_R$.

The remaining data transmitted within each superframe consists of a time multiplexed format of system information, datagram signals, and stream signals.

Referring to Figure 5, Figure 5a indicates the format of the multiplexed bit stream, comprising packets of system information, followed by packets of datagram signals, followed by a multiplex of one or more streams encoded to provide a minimum bit error rate (BER) of $10^{-6}$ (labelled B6), followed by a multiplex of one or more information streams encoded to provide a minimum bit error rate (BER) of $10^{-4}$ (labelled B4).

The datagram signals (or, at any rate, those which carry system information) are transmitted repeatedly within each superframe, to minimise the impact of channel errors (since the datagrams are not encoded). Carried within the datagram traffic within reserved time channels are the following particular system plan datagrams:

(a) beam plan datagram
(b) station plan datagram
(c) service plan datagram

These packets carry the information shown in Figure 2, enabling the receiver to be aware of which satellite beams are carrying which stations (to enable the user to orient an antenna correctly, and to indicate the coverage area for stations within each beam) within the beam plan datagram; a list of the transmitting stations specifying beam, frequency, station name, station description and timing information in the station plan datagram; and a list of the services with names, descriptions, timing information (for example, service start and finish times), beam and channel information on the service plan datagram.

Referring to Figure 5b, the B4 multiplex consists of a concatenation of some of the input streams received at the earth station 100. Referring to Figure 5c, the B6 multiplex is formed by, firstly, concatenating the input streams received at the earth station 100 (as shown in Figure 5a) and, secondly, encoding the concatenated stream of Figure 5a and interleaving the encoded stream (as will be described in greater detail below).

The multiplexed bit stream shown in Figure 5a is then distributed across the channels of the signal S, to form the OFDM multiplexed signal.

Referring to Figure 6, the multiplexed signal contains reference or pilot components, which enable a receiver to use synchronous detection. The reference signals comprise periodically transmitted samples which are known to the receiver; conveniently, the samples may all have the same value, as in this embodiment (but the possibility of employing different samples at different times is not excluded).

Referring to Figure 6a, the distribution in frequency of the reference samples is shown. Figure 6a illustrates the availability of different configurations for the multiplexed signal, varying from configuration 0 (in which only the main reference subcarrier is present) upwards. Each ensemble configuration corresponds to one channel additional to the immediately preceding ensemble configuration; thus, an additional frequency subcarrier is added each two ensemble configurations. For odd numbered ensemble configurations, the outer subcarrier (i.e. that furthest away in frequency from the main reference subcarrier) carries only one channel and is encoded in BPSK format.

The main reference subcarrier carries, in every fifth symbol period (as shown in Figure 6b), a reference symbol consisting of a sample at a reference phase (for example 0°) and, for example, at the same amplitude as the data symbols.

One every third subcarrier from the main reference subcarrier, reference data is carried, in the form of a pair of modified symbols each consisting of a combination of the data symbol and a reference symbol (for example a sample at zero phase).

As shown in Figure 6b, the form of the combination is, in this embodiment, a sample comprising the sum of the data symbol and the reference symbol in one symbol period, and a sample consisting of the difference between the two in the next symbol period. Thus, at a receiver, the data symbol can be recovered by forming the difference between the two adjacent symbol period samples, and the reference symbol can be recovered by forming the sum thereof.

To normalise the power in the symbol period, preferably, the first combined symbol is formed as the sum of ($R/\sqrt{2} + D_1\sqrt{2}$) and the second symbol is formed as the sum of ($R\sqrt{2} - D_1\sqrt{2}$), where R is the reference symbol and $D_1$ is the data symbol to be transmitted. Thus, the power in the two combined symbol periods on each subcarrier is the same as in the adjacent subcarriers of the preceding or succeeding data samples in the same subcarrier.

Thus, the signal on the reference subcarriers consists of the sum of the data symbol sequence $D_1$, $D_2$ ... and a sequence of reference symbols R, the reference symbol values being zero for three successive values, and equal to R for two intervening values.

Orthogonality between the two sequences is maintained by the fact that, for the non zero reference symbols, Manchester encoding (i.e. the data symbol followed by the negated data symbol) is employed, and the amplitudes of the data and reference symbols are normalised.

In other embodiments, rather than conveying reference signal information on two combined samples, the reference signal information may be spread over a larger number of symbol periods. It will be seen that the above described embodiment provides a 2 x 2 Hadamard matrix, with one row used to code the reference symbol, and the other to code the data bearing symbol, as follows:

$$\begin{pmatrix} 1 & -1 \\ 1 & 1 \end{pmatrix}$$

normalised by the scaling factor of √2.

If it is desired to spread the reference signal over more symbol periods, a larger Hadamard matrix (e.g. 4 x 4) may be used, with three rows for three data bearing symbols, and one row for the reference symbols. In this case, only one symbol period out of every five, on a reference subcarrier, would carry data, the rest carrying combined data and reference symbols.

As shown in Figure 6a, for odd numbered multiplex configurations, where the outermost subcarrier is a reference subcarrier, binary phase shift keying rather than quadrature phase shift keying is used to combine the reference symbol with one data bit. This is represented by a 'r' in Figure 6a.

Referring to Figure 7, on every subcarrier, the bit stream is interrupted between every symbol to provide a guard interval of duration 1/8 that of each symbol, in which the carrier level is set to zero. This enables some relief from the effects of time dispersion in the transmission path, and symbol timing error at the receiver 300.

Earth station and transmitter structure

Referring to Figure 8, the earth station 100 comprises, in addition to conventional components such as the uplink antenna 101 and tracking system 102, input ports 103 for receiving information signal streams from broadcasters, and input ports 104 for receiving information signal datagrams from broadcasters.

The datagram signals are packetised in a data processor 110, and datagram packets are supplied, together with the information signal streams received at the stream interfaces 103, to a formatting circuit 120, which multiplexes, encodes and interleaves the information signals (together with system information) to provide a data stream which is supplied to a base band processing section 130. Within the baseband processing section 130, the data stream is modulated onto the subcarriers at baseband. The frequency multiplexed baseband signal is then supplied to an RF up-convertor circuit 140, and transmitted via the uplink antenna 101 to the satellite 200.

A system control circuit 150 (e.g. a programmable processing device such as a microcontroller) determines the necessary number of channels and subcarriers, and the allocation of services, and supplies system information to the datagram processing circuit 110 to be encoded as datagrams for broadcasting. The system control circuit 150 also supplies the necessary number of carriers to an ensemble management circuit 160 (for example another, or the same, microcontroller) which generates a corresponding ensemble plan, which is supplied to the baseband processing circuit 130 to be modulated onto the reference subcarrier.

Referring to Figure 9, the operation of the formatting circuit 120 will now be described in greater detail.

The formatter 120 comprises an error correction (redundant) encoder (in this embodiment, a Reed-Solomon (192,160) encoder 121); a byte interleaver (in this embodiment a Reed-Solomon (192,x) byte interleaver) 122; and a puncturing circuit 123 which shortens the code for the last Reed-Solomon block in a superframe to a (M+32,M) code (where M is less than 160 bytes).

This last circuit is desirable because the B6 stream from input port 103a will not receive exactly enough bytes to fill an integer number of 160 bytes Reed-Solomon blocks, and so it is necessary to supply additional fill bytes (e.g. set to zero) to pad the stream up to the closest multiple of 160 bytes. By truncating the code in the last block, however, it is possible to lessen the wastage by not transmitting the fill bytes.

The Reed-Solomon coder 121 may be the L64711 ASIC available from LSI Logic in the US.

The (192,160) code is shortened from 255,233 code, i.e. a code over GF (256), the Galois field with 256 elements, whose generator polynomial is:

$$g(\chi) = \prod_{i=0}^{31} (\chi + \alpha^i)$$

where $\alpha$ is a root of the binary primitive polynomial:

$$\chi^8 + \chi^4 + \chi^3 + \chi^2 + 1$$

The Reed-Solomon encoding is synchronised to each superframe.

The byte interleaver comprises a memory and associated addressing circuitry and will be discussed below.

The fill puncture circuit 123 is provided by a microprocessor or other address control circuit arranged to remove contents of the byte interleaver 122.

The B6 streams from input port 103a are switched, in sequence, to the encoder 121 as illustrated in Figure 5c. The B4 streams from input port 103b are concatenated together as shown in Figure 5b, and concatenated together with datagrams from the datagram input port 104 and encoded data from the B6 encoding circuit comprising circuits 121-123, to provide the combined bit stream shown in Figure 5a.

The combined bit stream is supplied to a scrambler circuit 124, the output of which passes through a rate ½ convolutional coder 125 and a code puncturing circuit 126 operating selectively on the B6 stream portions of the combined bit stream to reduce the B6 stream to ½ coding rate. The scrambled, encoded composite bit stream thereafter passes to a bit interleaving circuit 127 (in this embodiment a (64,c) interleaver, where c is the number of channels present) which distributes the bits of the bit stream over the channels to be modulated onto the subcarriers within the baseband processing circuit 130.

Aspects of the formatting circuit 120 will now be discussed in greater detail. Figure 10a illustrates the encoding for the B6 stream. The encoding comprises inner and outer encoding steps 1003, 1001, the convolutional code representing the inner stage and the Reed-Solomon code the outer stage.

Since the convolutional code is applied also to the B4 stream, to simplify multiplexing together the B4 and B6 streams, the two coder rates applied to the two streams are made (at least approximately) the same. The rate of the convolutional coder 125 in this case is ½, and consequently it is desired to make the combined rate of the Reed-Solomon and convolutional coder applied to the B6 stream ½ also.

Thus, the puncturing circuit 126 is arranged to puncture the output of the convolutional coder 125 (step 1004), taking account of the rate of the Reed-Solomon coder 121. Thus, in this embodiment, since the rate of the Reed-Solomon coder 121 is (160/192), the rate of puncturing is 2 bits in every 12 bits, resulting in an increase in the data rate of (6/5)=(192/160).

The puncture mask for the B6 data is given in the following table, and spans 12 bits out of the convolutional encoder; code puncturing begins when the seventh B6 byte has entered the convolutional encoder and continues right to the end of the B6 stream.

| code generator | t | t+1 | t+2 | t+3 | t+4 | t+5 |
|---|---|---|---|---|---|---|
| 133 | | | X | | | |
| 171 | X | | | | | |

Further operation of the puncture circuit 126 is described in "Rate-compatible punctured convolutional codes (RSPC codes) and their applications", Hagenauer, J.; IEEE Trans. COMMUN., vol 36. PP 389-400, April 1988.

The interleaver 122 (stage 1002) is positioned between the outer encoder 121 and the inner encoder 125 because of the tendency of a convolutional encoder to result in error bursts if an error occurs in the channel.

The contents of the RAM memory device comprising the interleaver 122 is shown in greater detail in Figure 11.

The interleaver 122 has 192 rows, and a number of columns equalling the number of blocks required for the superframe. The coded bytes from the coder 121 are read in sequence, column by column into the interleaver 122, and read out across the rows, taking one byte from each of the 192 byte coded blocks (corresponding to the columns) as each row is read.

The block interleaving applied is selectable in four different spans; it may be one, two, four or eight frames (i.e. one superframe) in duration. Data is read out across the rows. The final column is, in general, never completely filled. When reading a row where the final column is not filled, the final byte position is skipped. The next row to be read is determined from the two permutation equation given by:

$$Rj=(Ri*27) \bmod 64$$

where Rj is the next visible row to read and Ri is the logical index of the row to be read which goes from 0 to 63 in increment of 1.

The bit interleaver 127 simply distributes the incoming bits amongst the channels available (i.e. two bits to each subcarrier or one or two bits to the outermost edge subcarrier) at input ports of the baseband processing section 130. A reference symbol adding circuit 128 comprises combining circuits 128a,128b,128c ... for the reference subcarriers, arranged to pass three channel pairs of data bits, and then, on each fourth symbol period, to form the complex sum of the forth pair of data bits and the reference symbol (e.g. a zero phase symbol, (0,1)), each divided by √2; and, in the fifth symbol period, to form the difference between the same pair of data bits and the reference symbol (again, each divided by √2).

The combining circuit 128 also multiplexes the unique word and ensemble plan into the main reference subcarrier once every frame (i.e. every half second), and the inverse unique word and ensemble plan once every superframe period (i.e. once every four seconds).

Referring to Figure 12, the scrambler circuit 124 in this embodiment is a non-self synchronising scrambler implemented with a feedback shift register acting as a pseudo random byte generating. The feedback polynomial for the shift register is $1+X+X_{15}$. The bits thus generated are added to the input data, bitwise. The scrambling has the effect of spreading the spectrum of the signal, and also provides some level of privacy against accidental reception. The initial state of the scrambler 124 is reset at every interleaver block to the value shown in Figure 12. The descrambler at a receiver needs to have the same structure and to have the same initial bit sequence.

Referring to Figure 13, the convolutional encoder is a well known half rate coder with polynomials $G1=133_8$ and $G2=171_8$. The bit resulting from the G1 stream (the first code bit) is transmitted before the byte resulting from the G2 stream (second code bit). The convolutional encoder is set to the all zero state at the start of each superframe, and is flushed with a sequence of 8 zero bits at the end of each interleaver block.

As is conventional, the convolutional encoder comprises a delay line tapped at various points, from which taps the bits are added to one of two branches created from the input bit stream, to create two output bit streams which are alternately selected, so as to double the bit rate relative to the input bit stream.

For example the STEL-2040 ASIC available from Stanford Telecommunications, 2421 Mission College Boulevard, Santa Clara, California, U.S.A. may be employed.

Referring to Figure 14, the baseband processing circuit 130 will now be described in greater detail. The processing is performed chiefly by digital signal processing (DSP) components such as the Motorola DSP 5600 or Western Electric DSP 32C, with an output sample rate of 160 kHz.

The baseband processing comprises firstly, an Inverse Fast Fourier Transformer 131 (for example, operating a 32 point IFFT).

As is well known, the Inverse Fast Fourier Transform (IFFT) will, when provided with an input data stream corresponding to the complex signal amplitude at each of a plurality of spaced frequencies, generate a frame of digital samples representing the complex time domain signal containing these spectral components. In other words the IFFT device 131 frequency multiplexes the input channels into a frequency multiplexed time domain signal comprises real and imaginary digital components.

The main reference subcarrier is provided as the first entry to the IFFT device 131 of the 32 point complex vector input thereto; the next subcarrier is the second entry, and so on. In the corresponding time domain output signal generated by the IFFT device 131, the main reference subcarrier component is centred at 0 Hz. The spacing between the subcarriers is $\Delta$=5kHz, for a data rate of 160kHz, and each subcarrier has a (sin x)/x spectrum, with lobes of one carrier lying in nulls of the neighbouring carriers.

Next, the series of 32 samples making up the wave form corresponding to one symbol period is processed by a peak-to-mean reduction circuit 132, to alleviate the problem either of distortion and intermodulation, or of transmitter power reduction, which can occur where samples within the symbol period have an excessively high peak value compared to the average sample level. The peak-to-mean reduction circuit 132 detects whether any samples within the symbol period are in excess of a predetermined threshold and, if so, the magnitude of all samples within the symbol period is reduced evenly, so as to reduce the magnitude of the symbol. Thus, orthogonality is generally preserved. To avoid excessive attenuation of the symbol, however, the amount of attenuation to the samples is constrained not to exceed a maximum value of -3dB.

The resulting complex signal is supplied to a guard sample insertion circuit 133, which inserts 4 zero valued samples after each 32 symbol samples, to produce the wave form shown in Figure 7.

The symbol rate following the guard sample insertion circuit 133 is 5000*32/36Hz, or roughly 444.44Hz.

Next, a down-convertor circuit 134 frequency shifts the baseband signal down so that it is centred around 0Hz. The amount of frequency shift is equal to $(n-1)\ \Delta/2$, where n is the number of subcarriers present in the multiplex. The object of the frequency shift executed by the down converter 134 is to centre the signal within the pass band of a (lowpass) transmission filter 135, which band limits the OFDM signal (which is, otherwise, associated with high sidelobes).

The transmit filter 135 comprises a FIR filter, the coefficients of the filter being variable in dependence upon the number of subcarriers employed. In the present embodiment, 23 or 25 tap filters were found to be sufficient. The filter is arranged to pass at least part of the first sidelobe of the multiplexed signal, so as to avoid excessive degradation to the edge subcarriers.

In this embodiment, the filter 135 attenuates the signal power to a level 35db below its peak, 10 kHz out from each edge subcarrier. Frequency domain plots showing the power spectrum of the multiplex signal before and after the transmit filter 135 are shown in Figure 15. The coefficients of the transmit filter 135 in this embodiment were derived to meet these constraints, together with the constraints that the amount of ripple in the pass band is less than 0.1db, and that the maximum or average power producible in the stop band (i.e. more than 10kHz from the edge subcarrier of the multiplexed signal) is minimised.

The filter is derived so that its zeros fall between the zeroes within the multiplexed signal (i.e. the zeroes of the filter fall on the sidelobes of the multiplex signal outside the first sidelobe), so as to make use of the attenuation provided by the zeroes of the multiplexed signal. An idealised filter response for the transmit filter 135 for 16 subcarriers is shown in Figure 15b.

Thus, the transmit filter employed for each ensemble size (or, more accurately, each number of subcarriers) is different. Accordingly, the transmit filter 135 further comprises a coefficient store, storing a set of filter coefficients for each ensemble size, the required coefficients being selected and loaded into the FIR filter by the ensemble management circuit 160.

After filtering, some slight distortion will have been introduced due to the elimination of the second and higher sidelobes, but this is not generally significant. The cut off of the filter is positioned in the middle of the first sidelobe, and consequently the outer part of the first sidelobe is attenuated, resulting in a narrowing of the first sidelobe.

To further reduce the peak-to-mean ratio, the filtered signal is processed by a peak clipping circuit 136 operating on samples of the OFDM symbol.

The magnitude of any signal sample above 7.8db (the average sample level being 0db) is truncated to 7.8db (which is preferably slightly higher than the threshold used in the peak to mean circuit 132). This does introduce some distortion, and hence a growth in the out of band power spectral density, and a reduction in orthogonality, but it is found that affects no more than around 0.3% of samples (10% of symbols).

The complex samples then pass to a pair of digital to analogue converters 137a,137b operating at 160 kHz, the analogue outputs of which are filtered by a pair of analogue smoothing filters 138a,138b to attenuate the aliased spectra due to the sampled signal stream. Preferably the smoothing filters 138a,138b have a linear phase characteristic, since the orthogonal frequency divisional multiplex technique is sensitive to delay distortion. The smoothed analogue signals are then supplied to the in- phase and quadrature input ports of a complex up converter 140 which modulates them onto an RF carrier frequency, and the modulated carrier frequency is supplied to the uplink antenna 101 for broadcast to the satellite 200.

In the foregoing, the action of the IFFT is simply to perform sinc pulse filtering process, applying a rectangular time window and generating (sin x)/x subcarriers. Naturally, a bank of filters could be employed instead of the IFFT device 131, if so desired.

Referring to Figure 16, in the special case of very small numbers of subcarriers, the baseband elements 131-135 are replaced by pulse shaping filters which apply non-rectangular pulse shaping, in order to improve the spectral efficiency of the transmitted signal. This need not require any alteration to the receiver.

Accordingly, a non-rectangular filter/modulator device 139 is provided, connected between the components 131-136 of Figure 14 and in parallel therewith, and selected instead of those components when signals consisting of one, two or three subcarriers are to be transmitted.

The filter/modulator 139 comprises three paths; a main reference subcarrier path 139a; a first subcarrier path 139b; and a second subcarrier path 139c, the outputs of which are summed at a complex adder 139d. Selectable delays 139e,139f are selectable within the paths, respectively, of the channel circuits 139a and 139b.

The main reference subcarrier is, in this embodiment, to be positioned at 0Hz. Accordingly as shown in Figure 16a, the main reference subcarrier circuit 139a merely comprises a bit-to-symbol combining element 1391a, grouping two bits together to form a symbol of 36 successive samples. The sample stream is fed to a pulse shaping filter 1392a, which has an impulse response arranged to concentrate the energy of the pulse into the 32 signal samples and away from the four guard samples (which are not explicitly inserted). The filter may comprise an 81 tap FIR filter, for example. By controlling the impulse response of the filter to concentrate energy in the signal period and away from the guard period, and to generate lower sidelobes than the essentially rectangular IFFT filter, more efficient use can be made of the available RF spectrum.

As shown in Figure 16a, where only a single subcarrier (the main reference subcarrier) is transmitted, only the circuit 139a is switched into operation, and operates as discussed above.

Referring to Figure 16b where two subcarriers are employed, the input bits are switched between the circuit 139a and the first subcarrier circuit 139b. This circuit represents an edge subcarrier spaced from the main reference carrier by $\Delta$ (i.e. 5kHz). Accordingly, in addition to the bit- to-symbol converter 1391b (operating in the same manner as the bit to symbol converter 1391a above) and pulse shaping filter 1392b (for performing the same purpose as the filter 1392a), there is provided a frequency translator circuit 1393b, which up- converts the samples from the pulse shaping filter 1392b by 5kHz.

In the circuit 139b, the pulse shaping filter 1392b therefore likewise shapes the input sample stream so as to tend to form a guard band of four samples, which, at the receiver (as will be discussed below), are deleted. However, because frequency translation of this subcarrier occurs after the guard band has effectively been inserted by the pulse shaping filter 1392b, deletion of the guard band at the receiver would result in a phase jump, corresponding to 4/32=⅛ of a circle, or $\pi/4$ radians.

Accordingly, a phase compensation circuit 1394b is provided prior to the pulse shaping filter 1392b, to rotate the phase of each successive symbol by an additional $\pi/4$ radians, prior to pulse shaping in the pulse shaping filter 1392b. In other words, the phase compensation applied by the phase compensation circuit 1394b increases, on each successive symbol by an increment of $\pi/4$. The amount of phase compensation is variable depending on the number of subcarriers as is the frequency translation, as are the filter parameters.

Thus, referring to Figure 16b, where only two subcarriers are present, the two streams of samples generated by the two circuits 139a and 139b are added by the adder 139d, to produce a complex output stream, for up-conversion. In this case, the coefficients of the filter 1392a are replaced with different values to those used when a single subcarrier is present.

Referring to Figure 16c, where three subcarriers are employed, the frequency translation circuit 1393b applies a 2Δ (i.e. 10kHz) frequency translation, and the phase compensation circuit 1394b applies a $\pi/2$ phase increment at each successive symbol.

The operation of the main reference subcarrier circuit 139a is substantially as before. The centre subcarrier at 5kHz is processed by the second subcarrier circuit 139c, which comprises a bit to symbol converter 1391b generating a sample stream; a phase compensation circuit 1394c applying a $\pi/4$ incremental phase rotation on each successive symbol; and a frequency translation circuit 1393c applying a (x8/9) = 4.44kHz frequency translation.

However, rather than applying a non-rectangular pulse shaping filter 1392 as above, in this case, since the subcarrier lies in between the two edge subcarriers, it is acceptable to allow the first sidelobes to pass unsuppressed, since these overlap the neighbouring edge subcarriers. Accordingly, a rectangular pulse shaping filter 1395 is used to filter the phase compensated sample stream, and a guard band insertion circuit 1396 inserts 4 zero valued sample periods as a guard band. A lowpass filter 1397 applies a roll off to the second and subsequent sidelobes prior to frequency translator 1393c. It would, in fact, be possible for the rectangular pulse shaping filter, guard insertion circuit 1396, and lowpass filter 1397 all to be provided by the same digital signal processor (DSP) device.

The delays 139e,139f within the reference subcarrier circuit 139a and first subcarrier circuit 139b are switched in, to compensate the delays in the second subcarrier circuit 139c arising from the lowpass filter.

The values of the coefficients of the filters 1392a are, again, different in this case to the one-or two-subcarrier cases.

In the case where two or three subcarriers are present, the spectral response of the pulse shaping filters 1392a,1392b may be made asymmetrical. This is because the two subcarriers (where only two are present) or the outer two subcarriers (where three are present) are edge subcarriers, each having another subcarrier on one side. The pulse shaping filters for the edge subcarriers therefore may have asymmetrical spectral responses, attenuating the subcarrier spectrum on the outer side of the centre frequency of the edge subcarrier more than on the inner side. Since the spectral responses of the pulse shaping filters are asymmetrical, the filters are required to be complex.

In general, suitable pulse shaping filters may be based on, for example, raised cosine filters of 50% roll off, modified using a design tool such as the Optimisation Toolbox of Matlab (TM).

Thus, by employing pulse shaping filters for the edge subcarriers for a multiplexed signal consisting of one or a small number of subcarriers, it is possible to drastically improve the spectral efficiency of the modulation process, without necessarily requiring any alteration to the receiver.

Receiver

One example of a receiver 300 of the system of Figure 1 will now be described.

Referring to Figure 17, the broadcast multiplex signal S is received by the receiver antenna 301 (which may be an omnidirectional antenna) and amplified by a low noise amplifier 302, both of conventional design. An RF down conversion circuit 340, comprising an RF to intermediate frequency (IF) conversion stage 341 and a controllable IF to baseband conversion circuit 342, convert the RF signal to a baseband signal which is supplied to a baseband processing circuit 330 comprising anti alias filtering and digitising circuits 337,338, and a frequency demultiplexer demodulator circuit 339.

The stream of demodulated samples from the baseband processing circuit 330 is deformatted into channels by a deformatter circuit 320, and the output channels are either supplied to an audio decoder/reproduction circuit, or to other data utilising apparatus (e.g. a computer or a facsimile machine). The ensemble plan, beam plan, station plan, service plan and other control data is supplied from the deformatter 320 to a system control circuit 350 (e.g. a microprocessor), which controls the operation of the IF to baseband conversion circuit 342 and deformatter 320, supplies output display data to a user interface 360 and receives input commands therefrom.

The operation of the components of Figure 17 will now be discussed in greater detail.

Referring to Figure 18, the baseband signal from the down converter 340 comprises real and imaginary components, each of which passes to a respective anti aliasing filter 338a,338b and digital to analogue converter 337a, 337b, the latter being driven at a sampling rate of 160 kHz. The stringency required of the anti aliasing filters 338a, 338b may be relaxed by employing over sampling and noise shaping sigma-delta digital converters 337. For example the DSP 56 ADC 16 bit sigma-delta analogue to digital converter (available from Motorola Incorporated) may be employed.

The digital real and imaginary components are then supplied to a complex multiplier 371, where they are multiplied by a frequency signal from a frequency tracking circuit 372, tracking the offset frequency of the main reference subcarrier, to bring the main reference carrier component of the baseband signal to the centre of the bandwidth of a receiver filter 335 having a bandwidth controlled from an ensemble plan decoder circuit 373, in dependence upon the number of subcarriers decoded as being present in the multiplexed signal.

A timing detector circuit 374 extracts the position in time of the guard samples, and hence the start and finish of each symbol period.

The filter samples are then down converted so that the main reference carrier lies at 0 Hz at a complex multiplier 375.

Next, the signal level and phase on each of the subcarriers over the symbol period is extracted by a Fast Fourier Transform circuit 331 (a commercially available IC, or a DSP device), integrating over 33 samples of the whole 36 samples-plus-guard-time symbol repetition period, as shown in Figure 7, the timing of the samples being controlled by the timing extraction circuit 374.

The signal on the main reference subcarrier is supplied to the frequency tracking circuit 372, and all the subcarrier signals are supplied to a detector and filter circuit 380, the filtered outputs of which are time multiplexed together in a round robin fashion and supplied to the deinterleaver circuit 320.

The main reference subcarrier signal, filtered by the detector filter circuit 380, is supplied to the ensemble plan decoder circuit 373, and to a unique word detector circuit 376 which, upon detection of the unique word or the inverse unique word in the stream of bits on the main reference subcarrier, triggers the ensemble plan decoder circuit 373 to decode the ensemble plan.

The timing from the unique word detector circuit 376 indicating the superframe start and finish points may be used to provide the timing for an audio codec if present in the receiver 300, where, as here, the superframe lengths are in direct proportion to the lengths of standard audio codec frames.

The receive filter 335 rejects out-of-band signals, and may simply have the same spectral response as the transmit filter 135 for each ensemble size (number of subcarriers). Accordingly, it comprises stored information defining a number of different filters, one for each ensemble size, selected in accordance with the ensemble size.

The symbol timing and synchronisation circuit 374 is shown in Figure 19 in greater detail. It comprises an amplitude extraction circuit 3741 which extracts the magnitude (squared) of the complex signal, sample by sample, as the sum of the squares of the real and imaginary parts; a lowpass comb filter circuit 3742 comprising a T-stage feedback delay 3743 (where T is the number of samples per composite symbol period; in this case 36), feeding back signal magnitude samples, through a multiplier 3744 applying a scalar multiplication of close to unity (e.g. c=0.9999), to an adder 3745 where the feedback samples are added to the incoming samples.

The action of this circuit is therefore to perform long time scale averaging of each sample with its predecessor samples in the same sample position in preceding symbol periods. Since the symbols can have varying values, the sample magnitudes in all the 32 sample periods during which symbol information is present each average out to some constant level corresponding to the average signal plus noise magnitude. On the other hand, the four guard sample periods over which only noise is present have a long term average value corresponding to the average noise power. Thus, after long term filtering by the lowpass filter 3742, the four guard samples are easily detected within the 36 samples making up each composite symbol period.

To find the sharp edges defining the beginning and end of the four guard sample period, the lowpass filtered signal is fed to a difference circuit 3746 comprising a feed forward one sample delay 3747, the output of which is subtracted from the filtered signal at a subtraction node 3748. Thus, a sharp bipolar pulse is produced for each guard interval, with a negative going pulse at the beginning of the guard interval and a positive going pulse at the end of the guard interval. A logic circuit 3749 notes the positions in the sample stream of the positive going and negative going pulses, and compares these with predicted positions based on timing of previous pulses, and, where necessary, advances or retards the signal start and end timing.

Thus, it will be seen that in this embodiment, the use of a guard period with a predetermined amplitude different to the average amplitude of the signal (e.g. a zero amplitude), enables the symbol period timing to be extracted by the receiver by detecting the signal envelope, without requiring the signal frequency to be exactly acquired. This independent acquisition of the symbol timing is of considerable value in the signal acquisition process of the receiver according to this embodiment.

Furthermore, by utilising relatively long term (i.e. long time constant) lowpass comb filtering or averaging, processing each sample with its predecessors at the same position within preceding symbol periods, it is possible to operate in extremely high noise environments; for example, in tests, at 0 db, over one million symbols, the standard deviation of the detected position of the start of the symbol was only 0.0025 of a symbol period.

For receivers intended to operate with the above described transmitter in which, for small ensembles consisting of only a few subcarriers, guard bands are not explicitly inserted, it is preferred to have an additional timing detector (since in this case the transition between the beginning and end of the symbol periods of 32 samples may not be sufficiently sharp for the differentiator to produce clear peaks). For example, rather than employing differencing following the lowpass filter, a 36 sample window could be employed, with taps from each cell of the window, and the 32-sample contiguous block yielding the highest energy (i.e. the highest sum of squared sample magnitudes) could be found and used to correspond to the symbol period.

Conveniently, the magnitude extracting circuit 3741, lowpass filter 3742, differencer 3746 and timing logic 3749 are all implemented by a single digital signal processor (DSP) device performing corresponding processing routines.

For most normal transmission channels the timing logic 3749 needs merely signal to commence the symbol period on the positive timing pulse and stop the symbol period on the negative timing pulse. In the presence of strong time dispersion, however, impulses may shift apart as the symbol is stretched by the dispersion, leading to extension of the length of each symbol period. The timing logic 3749 in this case therefore adjusts the length of the symbol period accordingly.

The symbol start and end signals from the timing synchronisation circuit 374 are used to control the integration period of the demodulator 331. Where the demodulator 331 is a Fourier Transform circuit, the start and end signals are used to order the sequence of the samples so as to start the integration on the correct sample. Where the demodulator 331 is a bank of integrate and dump filters, the start and end signals are used to start and end the integration (or, more accurately, summing) periods of the filters.

Referring to Figure 20, the frequency tracking circuit will now be described in greater detail. The frequency tracking circuit utilises the delay-multiply-average (DMA) technique described in "Performance of a simple delay-multiply-average technique for frequency estimation", S. Crozier, K. Moreland; Canadian Conference on Elect. and Conf. Engineering (CCECE '92), Toronto, September 13-16, 1992; and "Implementation of a simply-delay-multiply-average technique for frequency estimation on a fixed point DSP", R. Young, S. Crozier; Personal Indoor and Mobile Radio Communication Conf. (PIMRC) Oct 19-21, 1992, pages 59-63. The technique will briefly be described here.

Referring to Figure 20, the frequency tracking circuit 372 comprises a plurality of cascaded delay-multiply-average branches 372a,372b,372c. The structure of each branch is essentially the same; it consists of a delay 3721 on a feed forward path from the input; a complex conjugator device taking the complex conjugate of the delayed signal (not explicitly shown), a complex multiplier 3722 multiplying the conjugate of the delay signal by the input signal; an integrator 3723 calculating an average of the output of the multiplier 3722; and a rooting circuit 3724 extracting the d'th complex root of the average (where d is the length of the delay 3721 in sample durations).

The operation of each delay-multiple-average circuit 372 is as follows. The effect of the multiplication (multiplier 3722) by the conjugate of the delayed signal is to extract the phase change between the input signal and the delayed signal (i.e. the input signal d samples ago). If the input signal is in the same phase as the signal d samples ago, the phase difference is zero. If not, then the non-zero value represents the rate of change of phase with respect to time, and hence the frequency error.

The integrator 3723 averages, over K (e.g. 100) samples, the phase change (or frequency) phasor. The root circuit 3724 extracts the value per sample delay period of the phasor shift.

The delays in the branches 372a,372b,372c progressively increase in this embodiment. It is found that the length of the delay affects the result in two different ways. Firstly, increasing the length of the delay increases the accuracy with which the phase change is measured. This is because the phase change per sample is effectively averaged over the delay period, so that the accuracy of the phase change measured is proportional to the length of the delay.

Secondly, the bandwidth within which the frequency tracking is effective is inversely proportion to the length of the delay. For a delay of length one sample, the bandwidth is +/- 0.5 times the sample repetition frequency. However, as the delay length increases, the possibility of aliasing effects likewise increases; in other words, the possibility that the phase may change by more than $2\pi$ radians within the delay length is raised. For longer delays there is thus an ambiguity as to whether the phase change per d samples is $\Delta$, $2\pi + \Delta$, ... $2N\pi + \Delta$. The frequency is thus ambiguous, in multiples of the symbol repetition frequency.

In this embodiment the delay $d_1$ in the first DMA circuit 372a is one sample, so that the output of the circuit 372a is unambiguous provided that the frequency offset is within a range of one reference symbol repetition period (i. e. 1.125ms). However, the output is noisy due to the noise on the channel.

The second DMA circuit 372b has a delay, in this embodiment, equal to four samples. The output of the averager 3723b, represents the amount of phase shift in four samples, and is considerably more accurate (i.e. less affected by noise on the channel), but only over 1/4 of the bandwidth, and hence the phasor may either represent the phase shift, or the phase shift plus $2\pi N$ radians (where N is an integer).

This phasor is therefore not directly used, but instead is used to correct the output of the first DMA circuit 372a. To achieve this, the output of the first DMA circuit 372a is fed to an exponentiation circuit 3725b, which raises it to the power $-d_2$, where $d_2$ is the delay of the second DMA circuit (in this case 4), and the result is multiplied by the output of the averager 3723b by a multiplier circuit 3726b.

Thus, the effect of the two circuits 3725b,3726b is to raise the existing frequency estimate to the power $d_2$, which effectively rotates it in the complex plane by an amount equal to that by which the output of the averager 3723b is rotated due to the delay $d_2$, and then to divide the output of the averager 3723b by the thus-rotated existing frequency estimate.

The result therefore has a phase which is the phase difference, over $d_2$ samples, of the initial frequency estimate from the DMA circuit 372a and the estimate generated by the second DMA circuit 372b. This difference is then added to the initial frequency estimate of the first DMA circuit by multiplying the two together at multiplier 3727b, after extracting the $d_2$'th root of the output of the multiplier 3726b in the rooting circuit 3724b, so as to reduce the answer to a phase shift per sample (rather than per four samples).

This process may alternatively be viewed as using the initial phase estimate from the first circuit 372a to select the correct root of the phasor generated by the second DMA circuit 372b.

In exactly the same way (which will not be further described), a third DMA circuit 372c with a delay of 16 samples produces a third, still more precise, phasor which is used to correct the output from the second circuit 372b so as to further improve the accuracy thereof.

It will be apparent that, in fact, yet further circuits 372 could be provided to give yet higher accuracies.

The number of samples K providing the window over which averaging is performed is, in this embodiment, 100. It is necessary for the number of samples K to be significantly greater than the longest delay (in this case, 16 samples) present in the frequency tracking circuit 372, but since the size of the window K dictates the rapidity with which frequency is tracked, it should not be excessively long.

The output of the third DMA circuit 372c, taken from the multiplier 3727c, is a phasor the phase of which is proportional to the frequency offset between the received signal and its correct value, if (as in this embodiment) the phase of each reference symbol is the same as the predecessors.

Thus, the circuit of Figure 20 achieves frequency tracking with a frequency range dictated by the broadest range of the three branches 372a-372c, and an accuracy dictated by the most accurate of the three branches.

It is also possible, as mentioned in the above disclosed references, to raise the incoming signal to a higher power than unity prior to each DMA circuit 372; in this case, the exponents applied in the circuits 3724 and 3725 correspond to the products of the delay and the power, rather than merely the delay as in Figure 20.

The frequency tracking circuit 372 is, in this embodiment, provided by a digital signal processor (DSP) device, performing each of the operations shown separately as hardware elements in Figure 20. This is readily achieved using current digital hardware, because, firstly, the reference symbol rate is relatively low and hence the necessary sample rate is only 888 Hz; and secondly, the frequency estimate is only required ten times each second and the only operations therefore required at this sampling rate are the delay, multiply and averaging operations for each of the three branches; the exponentiation operation is only required once every one hundred milliseconds.

Referring to Figure 21, the baseband demodulation and filtering will now be described.

The bank of (1 to 32) subcarrier estimates output by the demodulator 331 for each subcarrier in each symbol period are each multiplied by the conjugate of an estimate of the channel on each subcarrier, by a bank of corresponding complex multipliers 381a,381b...381g (32 in all). This has the effects of:

(1) removing phase errors due to the phase of the channel; and

(2) weighting each subcarrier sample by the magnitude of the channel (so as to give less emphasis to signals received on weak channels).

The reference subcarriers are extracted to derive the reference information which was inserted into the multiplexed signal at the transmitter, to derive the channel estimates as described in greater detail below. The non reference subcarriers are simply delayed by delays 382b,c,e,f as shown, these delays corresponding to the delay imposed by the extraction of the reference information on the reference subcarriers.

As shown, on each reference subcarrier, there is provided a preliminary detection circuit 383. The preliminary detection circuit 383 outputs, after each sample period, a sample having one of the two or four possible phase values (depending upon whether the subcarrier is carrying one or two channels). The structure of the preliminary detector will be discussed below in greater detail with reference to Figure 22.

Following each preliminary detector 383 is a complex conjugate circuit 384a-384c, the outputs of each of which are fed to a respective complex multiplier circuit 385a-385c. The subcarrier is fed through a delay stage 386a, 386b,386c (of length corresponding to the delay imposed by the preliminary detector circuits 383a,383b,383c).

Thus, in each symbol period, the symbol actually received is multiplied by the conjugate of the symbol which should be present (if the preliminary detector 383 has correctly performed detection). If the channel has imposed no phase shift on the transmitted symbol, the two will be in phase, and hence the output of the multiplier will have a phase angle of zero. If the channel has, on the other hand, imposed a phase shift on the transmitted symbol then the output of the multiplier 385 will have a phase corresponding to that imposed by the channel on the transmitted symbol.

These channel phase samples are fed to lowpass filters 387a-387c, each of which passes the (fading) carrier samples and rejects noise lying outside the band occupied by the faded subcarrier. Each filter 387 may simply be a FIR filter with a length of 41 taps, with tap weights designed to pass the frequency band of the subcarrier and exclude out-of-band noise.

The temporally filtered phase samples from each subcarrier are then supplied from the temporal filters 387 to a frequency domain interpolator 388 which calculates, in each sample period, the intervening subcarrier phase samples between the reference subcarrier phase samples. In this embodiment, the frequency interpolator 388 simply performs linear interpolation; thus, each interpolated channel estimate sample comprises a linear superposition of the neighbouring (in frequency) temporally filtered reference subcarrier channel estimate samples.

The output of the frequency domain interpolator circuit 388 is thus a carrier phase sample for each subcarrier, and the conjugates of these phase samples (generated by conjugation circuits (not shown)) are multiplied by the samples on each subcarrier at the multipliers 381a-381g. To time align the reference subcarriers, they are fed through further delays 389a-389c corresponding to the delay imposed by the temporal interpolation filters 387a-387c and frequency domain interpolator 388. The outputs of the multipliers 381 are therefore corrected for channel phase, and are sampled in turn and fed to the deformatter circuit 320 (described in greater detail with reference to Figure 27).

Referring to Figure 22, each preliminary detector 383 comprises a reference symbol sub-sampling circuit (shown schematically as a switch) 3831, which closes once every five samples to pass a reference sample; and a narrow band filter 3832 comprising a lowpass filter with a stop band above around 250Hz (wide enough to pass any residual error frequency, and the maximum fading frequency). The reference symbols are then up-sampled to the data symbol rate (i.e. by a factor of five) by an up-sampler circuit 3833 repeating each reference symbol five times. Time domain smoothing is performed by an interpolating filter 3834, and the conjugate of each reference sample is taken by a conjugating circuit 3835, the output of which is fed to a multiplier 3836 which receives each input sub carrier sample via a delay 3837, the delay 3837 corresponding in length to the delay of the components 3832-3835.

Thus, the preliminary detectors act as simple coherent demodulators, multiplying the subcarrier by the conjugate of the reference information to produce a sequence of symbols corrected for the phase error due to the channel. These corrected symbol samples are fed to a hard decision circuit 3838 comprising a phase discriminating circuit which detects which of the four possible symbol phases (for a subcarrier carrying to channels) or two possible symbol phases (for a subcarrier carrying one channel) the corrected sample lies closest to, and outputs that phase value as a preliminary decision sample.

Since the reference information is carried over two successive sample periods, there is also provided (not shown) an adder circuit and one sample delay, to add together every fourth and fifth sample to reconstitute the reference symbol on each reference subcarrier (other than the main reference subcarrier).

In order to commence reception, the receiver needs to discover how many channels are present in the frequency multiplexed signal. This information is, in this embodiment, carried on the main reference subcarrier, and in order to decode it the receiver needs to acquire accurately the frequency of the main reference subcarrier, which will vary due to the Doppler effect where the receiver is in a mobile station (e.g. a car or an aeroplane) or where the signal is relayed via a non geostationary satellite 200. Accordingly, the receiver has a signal acquisition phase in which it acquires the frequency of the main reference subcarrier, and then extracts the frame and super-frame timing and thereby decodes the number of channels present in the multiplexed signal S. For this purpose, the receiver includes an acquisition circuit 390, shown in Figure 23.

Referring briefly to Figure 23, the acquisition circuit 390 comprises an RF down converter 391 followed by a filter 393 centred on the frequency employed on the transmitter for the main reference subcarrier, and having a bandwidth of 18kHz; 10kHz for the main lobe of the reference subcarrier and plus/minus 4kHz (80% of the channel spacing).

The acquisition circuit 390 comprises the timing synchronisation circuit 374 shown in Figure 19, which can extract the sample timing without needing frequency synchronisation. It comprises also a frequency acquisition circuit 392 which requires the frequency of the main reference subcarrier as will be described in greater detail below. In fact, two putative subcarrier frequencies are extracted, and one is supplied to each of two multipliers 394a,394b acting as down converters on the filtered input signal. On each of the two down converted frequencies, the signal is fed (after deletion of guard samples in guard sample deletion circuits 395a,395b, and integration over a symbol period in integrators 396a,396b), to respective preliminary decision circuits 383x,383y, each of the types shown in Figure 22. The stream of symbol samples on each frequency are then fed to a unique word detector circuit 376a or 376b comprising a coincidence register comparing the stored frames synchronising unique word with the contents of the window of symbol samples passing through a shift register.

When either one of the unique word detectors 376 detects the new unique word, the frequency with which the signal fed to the unique word detector was demodulated is selected as the main reference subcarrier frequency, and the succeeding symbols on the main reference subcarrier at that frequency are decoded by the ensemble plan receiver 373, to detect how many channels are present on the ensemble signal and thereafter set the bandwidth of the filter 335 to enable reception as described above.

Referring to Figure 24, the frequency acquisition circuit 392 is shown in greater detail. Samples from the receive filter 393 pass to a circuit 395c which deletes the guard samples under control of the timing synchronisation circuit 374 of Figure 19, and the resulting samples are integrated into half symbol periods (i.e. sixteen successive channel samples are integrated). The pairs of half symbols in each symbol period (synchronised by the timing synchronisation circuit 374) are distributed in round robin fashion between five frequency estimator circuit 3921a-3921e.

Thus, one of the five frequency estimators 3921 will receive the reference symbols, and will hence (where, as in this embodiment, the reference symbols all have the same phase) have successive samples all in the same phase when the correct frequency is acquired. The other four frequency estimators will receive data symbols, which will therefore be of varying phases. The rate of operation of the frequency estimators is 2 half symbol samples every 5 symbol periods; i.e. 2/5 the symbol rate.

Each frequency estimator 3921 supplies an estimated frequency to a decision logic circuit 3922, which decides which of the five frequency estimator circuits 3921 is receiving the reference symbols, and uses the outputs thereof to generate, in this embodiment, two putative subcarrier frequency estimates which are supplied respectively to the two multipliers 394a,394b.

The operation of each frequency estimator 3921 will now be described in greater detail with reference to Figure 25. The frequency estimator comprises a fine frequency estimator 3923 comprising three branches 392a,392b, 392c, which are equivalent to the branches 372a,372b,372c of Figure 20 except that the delay in each branch is twice as many stages, since the input samples each represent only half a symbol period. Thus, in the first branch 3923a, the phase difference between each half symbol sample and the half symbol sample one reference symbol period previously (5 symbol periods previously) is taken, whereas in the second branch the phase difference between each half symbol sample and the half symbol sample 4 reference symbol periods previously is taken, and in the third branch the phase difference between each half symbol sample and the half symbol sample 16 reference symbol periods previously is taken.

As described above with reference to Figure 20, the output of the fine frequency estimator 3923 is a frequency phasor which is accurate, but ambiguous by a frequency equal to the reference symbol rate (i.e. 888 Hz). In this embodiment, the averaging in each of the three sections 3923a-c is over 200 half symbol sample periods (100 reference symbol periods, 500 symbol periods). The output of this fine frequency estimator is employed by the detection logic 3922 to detect which of the frequency estimators 3921a,3921e is receiving the reference symbols; since the symbols on the other frequency estimators 3921 are of arbitrary phase, the magnitude of the output of the fine frequency estimator 3932 which carries the reference symbols will be significantly higher than the magnitude of the output of the other frequency estimators, and its phase will be almost constant over time whereas the outputs of the other frequency estimators will exhibit a random phase behaviour.

To resolve the frequency ambiguity in the fine frequency estimate generated by the fine frequency estimator 3923, a coarse frequency estimator 3924 is provided, comprising two branches 3924a and 3924b. In the first branch, a one sample delay 3925a is provided. Thus, in the first branch 3924a, the phase difference between the first half of one reference symbol and the second half of the reference symbol which preceded it (five symbol periods ago) is taken, followed by the phase difference between the second half of the reference symbol and the first half of the same reference symbol, and so on, in alternation. A gate 3926a is provided to block every second phase difference, clocked so as to pass only those differences corresponding to the difference between the first half of one reference symbol and the second half of the symbol which preceded it. Thus, the first section 3924a produces a measure of the phase change over 4½ symbol periods.

In the second section 3924b, a three sample delay 3925b is provided which enables the extraction, on alternate samples, of the phase difference between the second half of one reference symbol period and the first half of the reference symbol period which preceded it (five symbol periods previously), and the first half of a reference symbol period and the second half of the reference symbol which preceded it nine symbol periods previously.

Again, a gate circuit 3926b passes only alternate samples, namely only those samples corresponding to the phase difference between the second half of a reference symbol period and the first half of the immediately preceding reference symbol (5½ symbol periods previously). Therefore, the second section 3924b generates a frequency phasor corresponding to the phase shift over 5½ symbol periods.

The output (A) of the fine frequency estimator 3923 is conjugated and the conjugate supplied to multipliers 3927a,3927b, so as to subtract the phase of the fine frequency phasor (A) from the output (C) of the short delay stage 3924a and the output (B) of the long delay stage 3924b. This has the effect of rotating each of these in the complex plane by the subtraction of the phase of the fine frequency phasor (A), as shown in the transition from Figure 26a to Figure 26b.

Next, the output of the multiplier 3927a is conjugated and supplied to a complex adder 3928 receiving the output of the multiplier 3927b, so as to invert the phase angle of the phasor C and add it to the phasor B. The resulting phasor D is output as a coarse frequency estimate.

The operation of the coarse frequency estimator 3924 will now be explained in greater detail. The fine frequency estimate A is ambiguous in multiples of 888Hz (the reference symbol repetition rate). The outputs of the two stages 3924a,3924b of the coarse frequency estimator 3924 are liable to a similar level of ambiguity, since they measure phase changes in intervals of 4½ and 5½ symbol periods (as opposed to the fine frequency phasor, which measures phase changes every five symbol periods corresponding to one reference symbol repetition period).

However, the phase difference between the fine frequency estimate phasor A and the longer delayed phasor B corresponds to the phase change in half a symbol period (the difference between the phase change in 5 symbol periods and the phase change in 5½ symbol periods). Similarly, the phase difference between the fine frequency phasor A and the phasor C generated by the shorter delay branch 3924a corresponds to minus the phase change over half a symbol period (the difference between the phase change over 5 symbol periods and the phase change over 4½ symbol periods). In fact, the periods concerned are not exactly +/- ½ a symbol repetition period because of the 4 guard samples. Thus, by measuring either one of these phase differences, a frequency estimate which is accurate to about twice the reciprocal of the symbol repetition rate (i.e. 5kHz) can be obtained. The bandwidth of 5kHz, rather than 4.44kHz, is due to the presence of the guard samples. It will be clear from Figure 26 that the phasor D corresponds to this phase change over (approximately) half a symbol period and is unambiguous to within 5kHz.

This method of frequency estimation can, of course, be used in applications other than the system described above. Equally, finer divisions than half a symbol period may be made, to further improve the resolution of ambiguity.

Whilst the phasor D is unambiguous, it is much less accurate than the fine frequency phasor A due to the short averaging time used. Accordingly, it is used by the detection logic 3922 merely to resolve the frequency ambiguity in the fine frequency phasor A. The detection logic, on receipt of the fine frequency phasor A, detects which of the possible fine frequency values ($\alpha$, $\Delta F+\alpha$, $2\Delta F+\alpha$ etc) the coarse frequency phasor D is closest to, and selects that frequency value as correct.

The detection logic 3922 detects the maximum fine frequency phasor from each of the frequency estimators 3921; and if the maximum phasor A is found on the same estimator output for two of the last three estimates then acquisition is established, if the corresponding three frequency estimates (using the coarse phasor to resolve the ambiguity) are within 20Hz of each other.

It is found that the coarse frequency estimators 3924 are sufficiently noisy that it may take an undesirably long time for the average, over time, coarse frequency estimate phasor D to reach a constant level. However, it is found that in 99.7% of cases, after less than ¼ second, only two possible coarse frequency estimates need be considered; the possible fine frequency phasor closest to the coarse frequency phasor typically dithers between the same two values.

Accordingly, the detection logic 3922 measures, over time, the commonest occurring coarse frequency estimator values, from the frequency estimator 3921 which is detected to be carrying the reference symbols, calculates two frequency estimates using the two dithering values of the fine frequency phasor A, and supplies the corresponding two frequencies to the two multipliers 394a,394b.

Since one of the two frequencies is 99.7% likely to be correct, one of the unique word detectors 398a, 398b will detect the start of a frame within half a second, at which time the frequency on which the unique word was detected is accepted as the correct reference subcarrier frequency.

It will therefore be seen that the frequency estimation process described herein is capable of both accurate frequency estimation (due to the three stage delay-multiply-add process) and low ambiguity. The ambiguity resolution over a bandwidth greater than the symbol repetition period is achieved by splitting each symbol period into fractions, so as to pass within each fraction a bandwidth which is a multiple of the symbol repetition frequency. This also enables resolution on the order of the symbol repetition rate whilst working at the much slower reference symbol repetition rate, which reduces the processing capability required.

It will be apparent that the coarse frequency estimate could be derived without the use of fine frequency phasor A by taking the difference between the phasors B and C (corresponding to the phase change over one symbol period). However, this is not preferred, for two reasons. Firstly, both the phase of B and C are noisy, and the use of the fine frequency phasor A reduces somewhat the noise in the result. Secondly, the use of the fine frequency phasor A enables the phase change over half a symbol period to be extracted (rather than over one symbol period), thus increasing the range over which the phasor is unambiguous.

Having acquired the unique word, the frequency is completely acquired and the start of the frame period is established. The data following the unique word on the reference channel is then decoded by whichever preliminary detector 383x or 383y is receiving the correct frequency, and supplied to the ensemble plan receiver 373 which reads the number of channels and subcarriers present. The ensemble plan receiver 373 then sets up the receive filter 335 with a bandwidth sufficient for the ensemble to be received, and the frequency estimate is supplied to the multiplier 371. Operation of the receiver of Figure 18 then continues as described.

Referring to Figure 27, the deformatter 370 receives, in parallel, the subcarriers generated by the baseband processing circuit of 330 of Figure 21. A reference symbol extracting circuit 328 extracts every fourth and fifth symbol on the reference subcarriers and subtracts the fourth from the fifth, so as to eliminate the reference information and reconstitute the data symbol. The symbols from the subcarriers are then time multiplexed onto a sample de-interleaver circuit 327. The sample de-interleaver circuit 327 is functionally the reverse of the bit interleaver circuit 127 at the transmitter, and comprises 64 columns and c rows (where c is the number of channels).

At the same time as the samples are read into the sample de-interleaver 327, the sample powers or amplitudes are accumulated in a summer 329. The accumulated power for each group of samples (corresponding to a sample from each of the channels) is used to control the gain of an amplifier 329b so as to perform automatic gain control, prior to quantization to 3 bits in a quantizer 329c. Performing the power integration whilst reading the samples into the de-interleaver 327 avoids the need for further delay due to automatic gain control.

The coarsely quantized samples are then fed, through a zero stuffing circuit 326 (which inserts zeros to compensate for the code puncturing circuit 126 at the transmitter), to a Viterbi decoder 325. Where the convolutional coder is the above mentioned STEL-2040 ASIC, the Viterbi decoder 325 may be performed by the same component.

The stream of bits from the Viterbi decoder 325 are fed through a descrambler 324 (e.g. a standard V.35 descrambler integrated circuit) operating to reverse the scrambling performed by the scrambler 124 at the transmitter, and the descrambled bit stream is distributed amongst a datagram output 304, a B4 encoded output port 303b, and a B6 stream which is padded intermittently with zeros by a fill circuit 323 (to fill the bits punctured at the transmitter by the puncture circuit 123) byte de-interleaved by a de-interleaver circuit 323 comprising a random access memory and addressing circuitry functionally identical to the byte interleaver 122 at the transmitter, and Reed-Solomon decoded by a decoder circuit 321 (which, when the encoder is the LSI logic L64711, may be the LSI logic L64714 integrated circuit device). The decoded output stream of bits is distributed amongst parallel pins of the B6 output port 303a.

The decoding process is illustrated in steps 2005-2001 of Figure 10b.

Alternative receiver embodiments

Referring to Figure 28, the channel compensation performed in the baseband processing circuit shown in Figure 21 can be improved if the channel estimate on each reference subcarrier takes account of channel information from the neighbouring subcarriers.

As shown in Figure 28, in this case, the structure of the preliminary detector of Figure 22 is modified so that the conjugate of the channel response derived from the reference subcarrier is fed to a respective multiplier 3836a-c on the reference subcarrier and each of the subcarriers which neighbour it in frequency. A preliminary decision is then performed by a hard decision circuit 383a-383c on each of the subcarriers, and the signal from each of the subcarriers is multiplied by the conjugate of the symbol decision at a respective multiplier 385a-385c.

The result, on each subcarrier, is a series of channel samples which are summed together at a summing node 3891 to provide an improved channel estimate supplied to the time domain filter 387 for the reference subcarrier.

Referring to Figures 29a-c, different preliminary detector architectures are equally possible to that shown in Figure 22.

For example, the circuit shown in Figure 29a comprises a decision directed carrier recovery circuit, in which the input signal is first multiplied by the conjugate of the local reference and then detected. The decision is used to recover the current carrier sample, and a sliding window is used to produce an average carrier sample over a number of past symbol periods. The average carrier serves as the local reference of the next detection. The detected data is passed to ambiguity detection and correction logic where it is delayed by a number of samples equalling 1.5 times the reference symbol rate. The output of the delay line is multiplied by an ambiguity correction signal and the resulting signal represents a preliminary decision generated by the detector. While the detected data is held within the delay line, the reference symbols are monitored to detect phase ambiguities. A correctly detected reference symbol is declared when the current detection agrees with either of the previous reference symbol.

Figure 29b shows a Viterbi and Viterbi type preliminary detector, as disclosed in greater detail in "Non linear estimation of PSK-modulated carrier phase with applications to burst digital transmission", IEEE Trans. Inform. Theory, Vol. IT-29, No. 4, pp. 543-551, July 1983. In this type of detector, the carrier phase estimated is computed by removing the transmitted modulation using a special fourth power non linearity which maintains the input vector magnitude but multiplies its phase by four. Further details are to be found in the above referenced paper.

Figure 29c shows a TRIM detector, which computes a maximum likelihood estimate of the data over a block consisting of a reference sample and a number of data samples, given an appropriate weighted reference sample. Further details of this type of device are disclosed in S. Crozier and R. Young, "Low complexity non-coherent multi-symbol detector for DMSK signals with maximum likelihood performance", Proceedings of the International Conference on Wireless Communications (Wireless '93), Calgary, Alberta, pp. 367-375, July 1993.

Other possible detectors could be used; for example as described in D. Divsalar and M.K. Simon, "Multiple-symbol differential detection of MPSK", IEEE Trans. Commmun, vol. 38, no. 3, pp. 300-308, March 1990, or K. Mackenthun, "A fast algorithm for maximum likelihood detection of QPSK or $\pi$/4-QPSK Sequences with unknown phase", 3rd International Symposium on Personal, Indoor and Mobile Radio Communications, Boston, Massachusetts, pp. 240-244, October 1992.

Although the above described frequency tracking and frequency estimator circuits have been described for use with a signal which includes reference symbols, it will clear that, where (as disclosed above in relation to the frequency tracking circuit) the multiplexed signal is raised to a higher power M, reference symbols are not necessary. This is applicable equally to the frequency estimator circuit, which would then operate between first and second symbol periods (which might, for convenience, be spaced 4 or 5 symbol periods apart).

In the frequency tracking and frequency acquisition circuits and elsewhere in the receiver, the above description illustrates how reference symbols all having the same, zero, phase may be used. If reference symbols with non zero phase are used, the receiver may at each stage include a subtracter for subtracting the known reference symbol phase from the received reference symbol phase, to form a measure of the phase due to the channel. This is equally applicable where the value of the reference symbol changes over time (as may well be desirable in some applications); in this case, the receiver stores the sequence of known reference symbol phase values and subtracts them in turn from the received reference symbol phase.

Although in the foregoing description the use of guard bands having an amplitude different to the average signal amplitude (e.g. zero value guard bands) has been disclosed, it would be possible to use guard bands having predetermined phase, rather than amplitude, behaviour and to perform long term phase discrimination rather than amplitude discrimination to detect the guard bands for symbol synchronisation.

Although in the foregoing description the Fourier Transformer is used to demodulate the OFDM signal for all multiplex sizes, which is preferred on ground of reduced complexity at the receiver, it is equally possible to provide a set of filters arranged to perform the inverse of the pulse shaping filters at the transmitter, and selected where the received multiplexed signal consists only of a few subcarriers. This provides a slightly improved performance.

Satellite orbit considerations

Where the satellite 200 generates a plurality of spot beams, as for example where the satellites are in low earth orbit (LEO) or medium earth orbits (MEO) at, for example, 10,000 kilometres altitude, the same receiver 300 may receive signals from more than one satellite. Particularly, where the satellites are moving or where the receiver 300 is moving, a handover from one satellite to another may be required.

Since the different satellites may be operating at slightly different frequencies due to the Doppler shift caused by the satellite movement or the movement of the receiver 300, and since the different path lengths to the receiver from the different satellites will lead to slightly different timing, it is advantageous to provide the receiver 300 with a plurality of (for example 2) acquisition circuits 390. Each acquisition circuit 390 acquires the signal from only one satellite, and the receiver includes a decision circuit for switching reception from the satellite acquired by the current acquisition circuit to the satellite acquired by the alternative acquisition circuit on the basis of number of errors received, signal strength, geographical position, or some other criterion.

In one method of implementing a non geostationary satellite system, channel frequencies are assigned based on a pattern of regions on the earth's surface. Therefore, at any given location, a given service will always be transmitted in a single given frequency channel regardless of which satellite is servicing that location. The satellite beams may be continuously steered to remain pointing at a particular region on the earth's surface. At some point, the satellite may pass the frequencies in question over to another satellite. In one embodiment according to the present invention, on each occasion where a group of frequencies corresponding to a geographical area are handed over from one satellite to the next in this manner, the first satellite may increase the speed of transmission of services for a period prior to handover, for example, by expanding the number of channels in the multiplexed signal, thus allowing the receiver 300 to buffer information prior to handover to decrease the loss of information whilst re-acquiring the second satellite.

Other alternatives and modifications

It will be apparent that many modifications and substitutions may be made to the above-described embodiments without departing from the invention. Some particular examples will now be described.

Rather than using zero-valued guard samples, any other values which do not coincide with the average data symbol magnitude may be used.

Reference information may be added to every subcarrier, or to some number other than every third and likewise, may be added more or less frequently than every fifth data symbol. Rather than employing constant-valued reference information, a sequence of values known to the transmitter and receiver may be used.

Other types of Reed-Solomon code may be used (e.g. a (255,239) code or a (255,213) code).

Equally, other types of forward error correcting code could be used, or convolutional coding alone could be relied on. Equally, parallel concatenated recursive systemic convolutional codes with interleaving between the component codes ("Turbo" codes), as described in "New Shannon Limit Error Correcting Coding and Decoding Turbo codes", C. Berron, A. Glavieux and P. Thitimasajshima; Proc. ICC '93, May 1993 (and performed by the CAS 5093 codec available from ComAtlas, France) may be used.

Rather than merely using pulse shaping filters in the case of small numbers of subcarriers, it would also be possible to use pulse shaping filtering on the edge subcarriers of a multiplexed signal of any kind, producing the other subcarriers either using an Inverse Fourier Transformer, or some other suitable means.

Where the invention is employed with spot beams from satellites, it may be desirable to modify the above embodiment to improve the bandwidth efficiency (possibly at a cost in power efficiency). This may be achieved by increasing the puncturing rate to achieve a rate of 3/4 (i.e. puncturing 1/3 of the bits), using for example, the 2 in 6 mask described in "Rate-Compatible Punctured Convolutional codes (RCPC Codes) and their applications", J. Hagenauer; IEEE Trans. Commun., Vol 36, pp 389-400, April 1998.

Although phase shift keying (PSK) using two or four states has been described, it is equally possible to extend the invention to use more phase states (for example 8-PSK). Alternatively, other modulation schemes such as quadrature amplitude modulation (QAM) may be used. So called "pragmatic coding" techniques, described in "A pragmatic approach to trellis-coded modulation", Viterbi et al, IEEE Communications Magazine, 1989 may be used on the in-phase and quadrature components separately.

In one particular embodiment a 16-QAM constellation is employed, and groups of four bits are encoded, the first two bits being encoded in the in phase (I) component and the second two bits in the quadrature (Q) component. Within the bits coded in each component, the first bit is a sign bit (i.e. plus or minus) and the second bit is an amplitude level bit. This scheme gives a spectral efficiency of two bits per symbol.

Since QAM signals, unlike PSK signals, do not have constant envelope, rather than multiplying by the complex conjugate to correct for the phase of the channel, the receiver effects a complex division to correct the phase and normalise the amplitude of the sample with respect to the channel.

In each of the in phase and quadrature channels, pulse amplitude modulation may be used, with a first number of levels ($M_I$) in the in phase channel and a second number of levels ($M_Q$) in the quadrature channel. Where two channels are present on a subcarrier, this in general produces quadrature amplitude modulation, and where only a single channel is present (i.e. the in phase channel) this results in M-level pulse amplitude modulation.

Whilst a method of combining the reference information with data symbols has been described utilising the Hadamard transformation, other orthogonal transformations which combine the reference and data streams orthogonally, over more than one symbol period, may be employed.

Whilst a transmitter which can vary the size of the ensemble of subcarriers, and a receiver which can operate with a variable number of subcarriers, have both been described, it will be recognised that it would be possible to provide in the system at least one transmitter which operates only with a fixed predetermined ensemble size, and such a transmitter is within the scope of the present invention; likewise it would be possible to provide a receiver capable of receiving only one ensemble size (although in this case the receiver would only be capable of receiving certain signals within the scope of the invention).

Although the peak to mean reduction circuit 132 and peak clipper circuit 136 of the transmitter have been described as separate, successive, stages it will be clear that they could in fact be performed at one and the same time by a single calculating device (e.g. DSP device) in a single calculation stage. It will equally be apparent that, rather than employing thresholds and linear attenuation as described, an appropriate non-linear attenuation could be employed to achieve a similar effect.

Although the transmitter and receiver stations described above each include all the elements necessary for respectively transmission or reception, it will be recognised that, as is conventional in electrical systems, the elements of each station could be dispersed to several physically separate locations; elements of each system could even be positioned in orbit on one of the satellites 200. The present invention therefore extends to parts and sub-components of the inventive system described therein.

Whilst broadcasting has been described, the invention could also be used in one-to-one (narrow casting) telecommunications, or even for storage and reading of data onto a record medium (e.g. a magnetic disc).

In particular, the invention can advantageously be employed in asymmetrical communications, in which large volumes of data are transmitted downwards (to a user) from, for example, a database host storing files of image, text and/or sound data (for example, in a multimedia format) and a narrow bandwidth return (uplink) signalling channel is provided to enable users to request the transmission of such data.

Thus, mobile terminal users can gain access to high bandwidth services such as video-on-demand, or access to the Internet. The return signalling channel could use any convenient technology (for example, it could be an Aloha channel at a frequency different from, or unused by, the multiplex).

In such asymmetric systems, the OFDM transmitter does, of course, still broadcast the multiplex signal, but some address or identification data indicates the particular receiver or receivers for which it is intended, and those receivers ignore signals not addressed to them. Alternatively, the multiplex may be selectively encoded or encrypted for access only by such receivers, which therefore contain corresponding decoders or decrypters, of known type.

Accordingly, in the light of the foregoing and other embodiments apparent to the skilled man, the invention is not to be limited to the above described embodiments.

## Claims

1. A signal broadcasting RF transmitter apparatus comprising means for generating an RF frequency-multiplexed signal (S) comprising a plurality of frequency-spaced subcarriers in a band, **characterised by** means for periodically inserting data (E) specifying the subcarriers present onto a first, predetermined, subcarrier.

2. Apparatus according to claim 1, further comprising means (150) for varying the number of said transmitted subcarriers.

3. Apparatus according to claim 1 or 2, in which the first subcarrier is at a predetermined, frequency-constant, spectral position ($f_R$) relative to the edge of the band irrespective of the number of subcarriers.

4. Apparatus according to claim 3, in which the first subcarrier is located edgemost, at a constant frequency ($f_R$), in the band.

5. Apparatus according to any of claims 1 to 4, comprising means (130) for modulating each said subcarrier.

6. Apparatus according to claim 5 in which one said channel is modulated onto one of a pair of quadrature components of said subcarrier.

7. Apparatus according to claim 6 in which each said channel amplitude-modulates the respective quadrature component of said subcarrier.

8. Apparatus according to claim 7 in which said amplitude modulation is binary.

9. Apparatus according to any of claims 1 to 5, comprising means (130) for modulating at least two data channels onto a subcarrier to form each symbol thereon.

10. Apparatus according to any of claims 6 to 9, in which all channels contribute the same energy to said signal(S).

11. Apparatus according to any of claims 6 to 10 further comprising means for allocating channels to subcarriers such as to provide at least one outer edge subcarrier carrying either one or two channels in dependence on whether the number of channels is odd or even, and, where the number of channels exceeds three, one or more inner subcarriers between said outer edge subcarrier and said reference subcarrier, each inner subcarrier carrying two channels.

12. Apparatus according to any preceding claim, comprising means (130) for selectively applying either BPSK or QPSK modulation at the same symbol rate to a subcarrier.

13. Apparatus according to any preceding claim, comprising a configurable filter (135) with a pass band set in dependence upon the number of subcarriers present.

14. A frequency-multiplexed RF signal (S) comprising a plurality of frequency-spaced subcarriers, **characterised in that** it includes a first subcarrier at a predetermined frequency ($f_R$) and **in that** said first subcarrier carries periodic data (E) specifying the other subcarriers present in the frequency multiplexed signal.

15. An orthogonal frequency multiplexed RF signal (S) carrying a first plurality of channels on a second, smaller, plurality of subcarriers, each channel modulating a quadrature component of one of said subcarriers.

16. A signal (S) according to claim 15 in which said channels amplitude modulate said subcarriers.

17. A signal (S) as claimed in claim 15, comprising a plurality of orthogonal information-bearing subcarriers, the first outer sidelobes of the highest and lowest frequency said subcarriers being partially attenuated by filtering.

18. An RF receiver apparatus comprising means for receiving an RF frequency multiplexed signal (S) comprising a plurality of frequency-spaced subcarriers in a band, **characterised by** means (350) for reading data (E) specifying the subcarriers present from a first, predetermined, subcarrier and for configuring the receiver to receive said subcarriers.

**19.** Apparatus according to claim 18 comprising a configurable filter (335) with a pass band set in dependence upon said data (E).

**20.** An OFDM receiver comprising a filter and a demodulator (339) for demodulating a first plurality of channels from a second, smaller, plurality of subcarriers, said demodulator being arranged to demodulate each channel from one quadrature component of one subcarrier.

**21.** A receiver as claimed in claim 20, wherein the filter has a pass band arranged to pass the subcarriers of said OFDM signal (S) and at least a portion of the first outer sidelobes of the highest and lowest subcarriers present therein, and to attenuate frequencies corresponding to the spectral positions where the second and further outer sidelobes of said highest and lowest frequency subcarriers would be, and a demodulator for demodulating the filtered signal.

**22.** A receiver according to claim 21 further comprising a control circuit (373) for setting the bandwidth of said filter (335) between at least first and second different values corresponding to at least first and second respective different numbers of subcarriers.

**23.** A receiver according to claim 21 or claim 22 in which the transition frequency of the filter (335) passes through said first outer sidelobes of said highest and lowest frequency subcarriers.

**24.** A receiver according to any of claims 21 to 23 in which the filter (335) has regular nulls which lie within said sidelobes, away from the nulls between said sidelobes.

**25.** An OFDM transmitter comprising an OFDM generator (120, 130) for generating an ensemble of orthogonal, information-carrying frequency subcarriers, and a transmit filter (135) for passing the subcarriers and at least a portion of the first sidelobes of the highest and lowest frequency subcarriers, and attenuating the second and subsequent sidelobes of said highest and lowest frequency subcarriers.

**26.** A transmitter according to claim 25, in which the filter (135) has regular nulls which lie within said sidelobes, away from the nulls between said sidelobes.

**27.** A transmitter according to claim 25 or claim 26 comprising a control circuit (160) for controlling the number of said subcarriers, and for controlling the bandwidth of said filter (135) to match the number of said subcarriers.

**28.** A transmitter according to any of claims 25 to 27 in which the transition frequency of the filter (135) passes through said first outer sidelobes of said highest and lowest frequency subcarriers.

**29.** A method of receiving an OFDM signal (S) comprising filtering said signal to pass all the OFDM subcarriers and at least a portion of the first outer sidelobes of the highest and lowest frequency information-carrying subcarriers, and to attenuate frequencies outside the frequency of the second outer sidelobes of the said highest and lowest frequency subcarriers.

**30.** A method of filtering an orthogonal frequency division multiplexed signal (S) comprising a plurality of orthogonal, information-carrying subcarriers each having a (sin x/x) spectral form, consisting of filtering said plurality of subcarriers so as to pass all said subcarriers and at least a portion of the first sidelobe of the highest and lowest subcarriers, and to attenuate the second and further sidelobes of said highest and lowest frequency subcarriers.

**31.** A method according to claim 29 or claim 30 in which the filtering transition frequency passes through the first outer sidelobes of the said highest and lowest frequency subcarriers.

**32.** A method according to any of claims 29 to 31 in which the filtering applies nulls within each of the second and further sidelobes, away from the nulls therebetween.

## Patentansprüche

**1.** Signalausstrahlungs-RF-Sendegerät mit einer Einrichtung zum Erzeugen eines RF-Multiplexfrequenz-Signals (S) mit mehreren in Frequenzabstand stehenden Subträgern in einem Band, **gekennzeichnet durch** eine Einrichtung zum periodischen Einfügen von die vorhandenen Subträger spezifizierenden Daten (E) in einen ersten vorbestimmten Subträger.

**2.** Gerät nach Anspruch 1, ferner mit einer Einrichtung (150) zum Variieren der Anzahl der gesendeten Subträger.

**3.** Gerät nach Anspruch 1 oder 2, in dem der erste Subträger an einer vorbestimmten, Frequenz-konstanten Spektralposition ($f_R$) relativ zu dem Bandende unabhängig von der Anzahl der Subträger liegt.

**4.** Gerät nach Anspruch 3, in dem der erste Subträger bei einer konstanten Frequenz ($f_R$) am äußersten Ende des Bandes liegt.

**5.** Gerät nach einem der Ansprüche 1 bis 4 mit einer Einrichtung (130) zum Modulieren jedes Subträgers.

**6.** Gerät nach Anspruch 5, in dem einer der Kanäle auf eine Komponente eines Paars von Quadraturkomponenten des Subträgers moduliert ist.

**7.** Gerät nach Anspruch 6, in dem jeder Kanal die jeweilige Quadraturkomponente des Subträgers amplitudenmoduliert.

**8.** Gerät nach Anspruch 7, in dem die Amplitudenmodulation binär ist.

**9.** Gerät nach einem der Ansprüche 1 bis 5 mit einer Einrichtung (130) zum Modulieren wenigstens zweier Datenkanäle auf einen Subträger, um jedes Symbol darauf zu bilden.

**10.** Gerät nach einem der Ansprüche 6 bis 9, in dem alle Kanäle die gleiche Energie zu dem Signal (S) beitragen.

**11.** Gerät nach einem der Ansprüche 6 bis 10, ferner mit einer Einrichtung zum Zuteilen von Kanälen auf Subträger, um wenigstens einen Außenende-Subträger, der einen oder zwei Kanäle trägt, jenachdem ob die Anzahl der Kanäle ungerade oder gerade ist, und, wenn die Anzahl der Kanäle drei übersteigt, einen oder mehrere innere Subträger zwischen dem Außenende-Subträger und dem Referenz-Subträger bereitzustellen, wobei jeder innere Subträger zwei Kanäle trägt.

**12.** Gerät nach einem der vorstehenden Ansprüche mit einer Einrichtung (130) zum selektiven Anwenden einer BPSK- oder QPSK-Modulation bei gleicher Symbolrate auf einen Subträger.

**13.** Gerät nach einem der vorstehenden Ansprüche mit einem konfigurierbaren Filter (135) mit einem in Abhängigkeit von der Anzahl der vorhandenen Subträger eingestellten Durchlaßband.

**14.** Multiplexfrequenz-RF-Signal (S) mit mehreren in Frequenzabstand stehenden Subträgern, **dadurch gekennzeichnet, daß** es einen ersten Subträger bei einer vorbestimmten Frequenz ($f_R$) aufweist, und der erste Subträger periodische Daten (E) trägt, die die anderen in dem Multiplexfrequenz-Signal vorhandenen Subträger spezifiziert.

**15.** Orthogonales Multiplexfrequenz-RF-Signal (S), das eine erste Mehrzahl von Kanälen auf einer zweiten, kleineren Mehrzahl von Subträgern trägt, wobei jeder Kanal eine Quadraturkomponente von einem der Subträger moduliert.

**16.** Signal (S) nach Anspruch 15, in dem die Kanäle die Subträger amplitudenmodulieren.

**17.** Signal (S) nach Anspruch 15, mit mehreren orthogonalen, Information tragenden Subträgern, wobei die ersten äußeren Seitenkeulen der Subträger der höchsten und der tiefsten Frequenz durch Filtern teilweise gedämpft werden.

**18.** RF-Empfängergerät mit einer Einrichtung zum Empfangen eines RF-Multiplexfrequenz-Signals (S) mit mehreren in Frequenzabstand stehenden Subträgern in einem Band, **gekennzeichnet durch** eine Einrichtung (350) zum Lesen von die vorhandenen Subträger spezifizierenden Daten (E) von einem ersten, vorbestimmten Subträger und zum Konfigurieren des Empfängers zum Empfangen der Subträger.

**19.** Gerät nach Anspruch 18, mit einem konfigurierbaren Filter (335) mit einem in Abhängigkeit von den Daten (E) eingestellten Durchlaßband.

20. OFDM-Empfänger mit einem Filter und einem Demodulator (339) zum Demodulieren einer ersten Mehrzahl von Kanälen aus einer zweiten, kleineren Mehrzahl von Subträgern, wobei der Demodulator zum Demodulieren jedes Kanals aus einer Quadraturkomponente eines Subträgers ausgelegt ist.

21. Empfänger nach Anspruch 20, wobei der Filter ein Durchlaßband, das zum Durchlassen der Subträger des OFDM-Signals (S) und wenigstens eines Teils der ersten äußeren Seitenkeulen des höchsten und des tiefsten darin vorhandenen Subträgers ausgelegt ist, sowie zum Dämpfen von Frequenzen entsprechend der Spektralpositionen, an denen zweite und weitere äußere Seitenkeulen der Subträger der höchsten und der tiefsten Frequenz sein würden, und einen Demodulator zum Demodulieren des gefilterten Signals aufweist.

22. Empfänger nach Anspruch 21, ferner mit einer Steuerschaltung (373) zum Einstellen der Bandbreite des Filters (335) zwischen wenigstens einem ersten und einem zweiten davon verschiedenen Wert entsprechend zu wenigstens einer ersten und einer zweiten entsprechend verschiedenen Anzahl von Subträgern.

23. Empfänger nach Anspruch 21 oder 22, in dem die Übergangsfrequenz des Filters (335) die ersten äußeren Seitenkeulen der Subträger der höchsten und der tiefsten Frequenz durchläßt.

24. Empfänger nach einem der Ansprüche 21 bis 23, in dem der Filter (335) reguläre Nulldurchgänge aufweist, die innerhalb der Seitenkeulen entfernt von den Nulldurchgängen zwischen den Seitenkeulen liegen.

25. OFDM-Sender mit einem OFDM-Generator (120, 130) zum Erzeugen eines Ensembles orthogonaler, Information tragender Frequenz-Subträger und einem Sendefilter (135) zum Durchlassen der Subträger und wenigstens eines Teils der ersten Seitenkeulen der Subträger der höchsten und der tiefsten Frequenz und zum Dämpfen der zweiten und folgenden Seitenkeulen der Subträger der höchsten und der tiefsten Frequenz.

26. Sender nach Anspruch 25, in dem der Filter (135) reguläre Nulldurchgänge aufweist, die innerhalb der Seitenkeulen entfernt von den Nulldurchgängen zwischen den Seitenkeulen liegen.

27. Sender nach Anspruch 25 oder 26 mit einer Steuerschaltung (160) zum Steuern der Anzahl der Subträger und zum Steuern der Bandbreite des Filters (135) zur Anpassung an die Anzahl von Subträgern.

28. Sender nach Anspruch 25 bis 27, in dem die Übergangsfrequenz des Filters (135) die ersten äußeren Seitenkeulen der Subträger der höchsten und der tiefsten Frequenz durchläßt.

29. Verfahren zum Empfangen eines OFDM-Signals (S), wobei das Signal so gefiltert wird, daß alle OFDM-Subträger und wenigstens ein Teil der ersten äußeren Seitenkeulen der Information tragenden Subträger der höchsten und der tiefsten Frequenz durchgelassen wird, und zum Dämpfen der Frequenzen außerhalb der Frequenz der zweiten äußeren Seitenkeulen der Subträger der höchsten und der tiefsten Frequenz.

30. Verfahren zum Filtern eines orthogonalen Multiplexfrequenzteilungs-Signals (S) mit mehreren orthogonalen, Information tragenden Subträgern, die jeweils eine (sin x/x)-Spektralform aufweisen, wobei die mehreren Subträger so gefiltert werden, daß alle Subträger und wenigstens ein Teil der ersten Seitenkeule des höchsten und des tiefsten Subträgers durchgelassen wird und zweite und weitere Seitenkeulen der Subträger der höchsten und der tiefsten Frequenz gedämpft werden.

31. Verfahren nach Anspruch 29 oder 30, in dem die Filterübergangsfrequenz die ersten äußeren Seitenkeulen der Subträger der höchsten und der tiefsten Frequenz durchläßt.

32. Verfahren nach einem der Ansprüche 29 bis 31, in dem die Filterung Nulldurchgänge innerhalb jedes der zweiten und weiteren Seitenkeulen entfernt von den Nulldurchgängen dazwischen anwendet.

## Revendications

1. Appareil émetteur radioélectrique de diffusion de signaux, comprenant des moyens pour générer un signal radioélectrique multiplexé en fréquence (S) comprenant une pluralité de sous-porteuses à fréquences espacées dans une bande, **caractérisé par** des moyens pour insérer périodiquement des données (E), précisant les sous-porteuses présentes, dans une première sous-porteuse prédéterminée.

2. Appareil selon la revendication 1, comprenant en outre des moyens (150) pour faire varier le nombre desdites sous-porteuses transmises.

3. Appareil selon la revendication 1 ou 2, dans lequel la première sous-porteuse occupe une position spectrale ($f_R$) prédéterminée, à fréquence constante, par rapport au bord de la bande indépendamment du nombre de sous-porteuses.

4. Appareil selon la revendication 3, dans lequel la première sous-porteuse est placée la plus proche du bord, à une fréquence constante ($f_R$), dans la bande.

5. Appareil selon l'une quelconque des revendications 1 à 4, comprenant des moyens (130) pour moduler chacune desdites sous-porteuses.

6. Appareil selon la revendication 5, dans lequel une desdites voies est modulée dans l'une d'une paire de composantes en quadrature de ladite sous-porteuse.

7. Appareil selon la revendication 6, dans lequel chacune desdites voies module en amplitude la composante en quadrature respective de ladite sous-porteuse.

8. Appareil selon la revendication 7, dans lequel ladite modulation d'amplitude est binaire.

9. Appareil selon l'une quelconque des revendications 1 à 5, comprenant des moyens (130) pour moduler au moins deux voies de données dans une sous-porteuse pour former chaque symbole sur elle.

10. Appareil selon l'une quelconque des revendications 6 à 9, dans lequel toutes les voies contribuent à la même énergie dudit signal (S).

11. Appareil selon l'une quelconque des revendications 6 à 10, comprenant en outre des moyens pour affecter des voies à des sous-porteuses de manière à prévoir au moins une sous-porteuse de bord extérieur transportant une ou deux voies selon si le nombre de voies est impair ou pair, et, quand le nombre de voies dépasse trois, une ou plusieurs sous-porteuses intérieures entre ladite sous-porteuse de bord extérieur et ladite sous-porteuse de référence, chaque sous-porteuse intérieure transportant deux voies.

12. Appareil selon l'une quelconque des revendications précédentes, comprenant des moyens (130) pour appliquer de manière sélective une modulation de phase à 2 états ou à 4 états à la même cadence de symbole à une sous-porteuse.

13. Appareil selon l'une quelconque des revendications précédentes, comprenant un filtre configurable (135) possédant une bande passante réglée en fonction du nombre de sous-porteuses présentes.

14. Signal radioélectrique multiplexé en fréquence (S), comprenant une pluralité de sous-porteuses à fréquences espacées, **caractérisé en ce qu'**il comprend une première sous-porteuse à une fréquence prédéterminée ($f_R$) et **en ce que** ladite première sous-porteuse transporte des données périodiques (E) précisant les autres sous-porteuses présentes dans le signal multiplexé en fréquence.

15. Signal radioélectrique de multiplexage fréquentiel orthogonal (S), transportant une première pluralité de voies sur une seconde, plus petite, pluralité de sous-porteuses, chaque voie modulant une composante en quadrature de l'une desdites sous-porteuses.

16. Signal (S) selon la revendication 15, dans lequel lesdites voies modulent en amplitude lesdites sous-porteuses.

17. Signal (S) selon la revendication 15, comprenant une pluralité de sous-porteuses utiles orthogonales, les premiers lobes latéraux extérieurs desdites sous-porteuses de plus grande et plus petite fréquences étant partiellement atténués par filtrage.

18. Appareil récepteur radioélectrique, comprenant des moyens pour recevoir un signal radioélectrique multiplexé en fréquence (S) comprenant une pluralité de sous-porteuses à fréquences espacées dans une bande, **caractérisé par** des moyens (350) pour lire des données (E) précisant les sous-porteuses présentes à partir d'une première sous-porteuse prédéterminée, et pour configurer le récepteur afin de recevoir lesdites sous-porteuses.

**19.** Appareil selon la revendication 18, comprenant un filtre configurable (335) possédant une bande passante réglée en fonction desdites données (E).

**20.** Récepteur OFDM, comprenant un filtre et un démodulateur (339) pour démoduler une première pluralité de voies à partir d'une seconde, plus petite, pluralité de sous-porteuses, ledit démodulateur étant agencé pour démoduler chaque voie à partir d'une seule composante en quadrature d'une seule sous-porteuse.

**21.** Récepteur selon la revendication 20, dans lequel le filtre possède une bande passante prévue pour laisser passer les sous-porteuses dudit signal OFDM (S) et au moins une partie des premiers lobes latéraux extérieurs des plus grande et plus petite sous-porteuses présentes dedans, et pour atténuer des fréquences qui correspondent aux positions spectrales que les deuxièmes lobes latéraux extérieurs et les suivants desdites sous-porteuses de plus grande et plus petite fréquences pourraient occuper, et un démodulateur pour démoduler le signal filtré.

**22.** Récepteur selon la revendication 21, comprenant en outre un circuit de réglage (373) pour régler la bande passante dudit filtre (335) entre au moins une première et une seconde valeurs différentes correspondant à au moins un premier et un second nombres respectifs différents de sous-porteuses.

**23.** Récepteur selon la revendication 21 ou 22, dans lequel la fréquence de transition du filtre (335) passe à travers lesdits premiers lobes latéraux extérieurs desdites sous-porteuses de plus grande et plus petite fréquences.

**24.** Récepteur selon l'une quelconque des revendications 21 à 23, dans lequel le filtre (335) possède des zéros réguliers qui tombent à l'intérieur desdits lobes latéraux, loin des zéros entre lesdits lobes latéraux.

**25.** Emetteur OFDM, comprenant un générateur OFDM (120, 130) pour générer un ensemble de sous-porteuses utiles orthogonales, et un filtre d'émission (135) pour laisser passer les sous-porteuses et au moins une partie des premiers lobes latéraux des sous-porteuses de plus grande et plus petite fréquences, et atténuer les deuxièmes lobes latéraux et les suivants desdites sous-porteuses de plus grande et plus petite fréquences.

**26.** Emetteur selon la revendication 25, dans lequel le filtre (135) possède des zéros réguliers qui tombent à l'intérieur desdits lobes latéraux, loin des zéros entre lesdits lobes latéraux.

**27.** Emetteur selon la revendication 25 ou 26, comprenant un circuit de réglage (160) pour régler le nombre desdites sous-porteuses, et pour régler la bande passante dudit filtre (135) afin de l'adapter au nombre desdites sous-porteuses.

**28.** Emetteur selon l'une quelconque des revendications 25 à 27, dans lequel la fréquence de transition du filtre (135) passe à travers lesdits premiers lobes latéraux extérieurs desdites porteuses de plus grande et plus petite fréquences.

**29.** Procédé de réception d'un signal OFDM (S), comprenant un filtrage dudit signal pour laisser passer toutes les sous-porteuses OFDM et au moins une partie des premiers lobes latéraux extérieurs des sous-porteuses utiles de plus grande et plus petite fréquences, et pour atténuer des fréquences à l'extérieur de la fréquence des deuxièmes lobes latéraux extérieurs desdites sous-porteuses de plus grande et plus petite fréquences.

**30.** Procédé de filtrage d'un signal de multiplexage fréquentiel orthogonal (S) comprenant une pluralité de sous-porteuses utiles orthogonales ayant chacune une forme spectrale en (sin x/x), consistant à filtrer ladite pluralité de sous-porteuses de manière à laisser passer toutes lesdites sous-porteuses et au moins une partie du premier lobe latéral des plus grande et plus petite sous-porteuses, et à atténuer les deuxièmes lobes latéraux et les suivants desdites sous-porteuses de plus grande et plus petite fréquences.

**31.** Procédé selon la revendication 29 ou 30, dans lequel la fréquence de transition du filtrage passe à travers les premiers lobes latéraux extérieurs desdites sous-porteuses de plus grande et plus petite fréquences.

**32.** Procédé selon l'une quelconque des revendications 29 à 31, dans lequel le filtrage applique des zéros à l'intérieur de chacun des deuxièmes lobes latéraux et des suivants, loin des zéros entre eux.

FIG.1

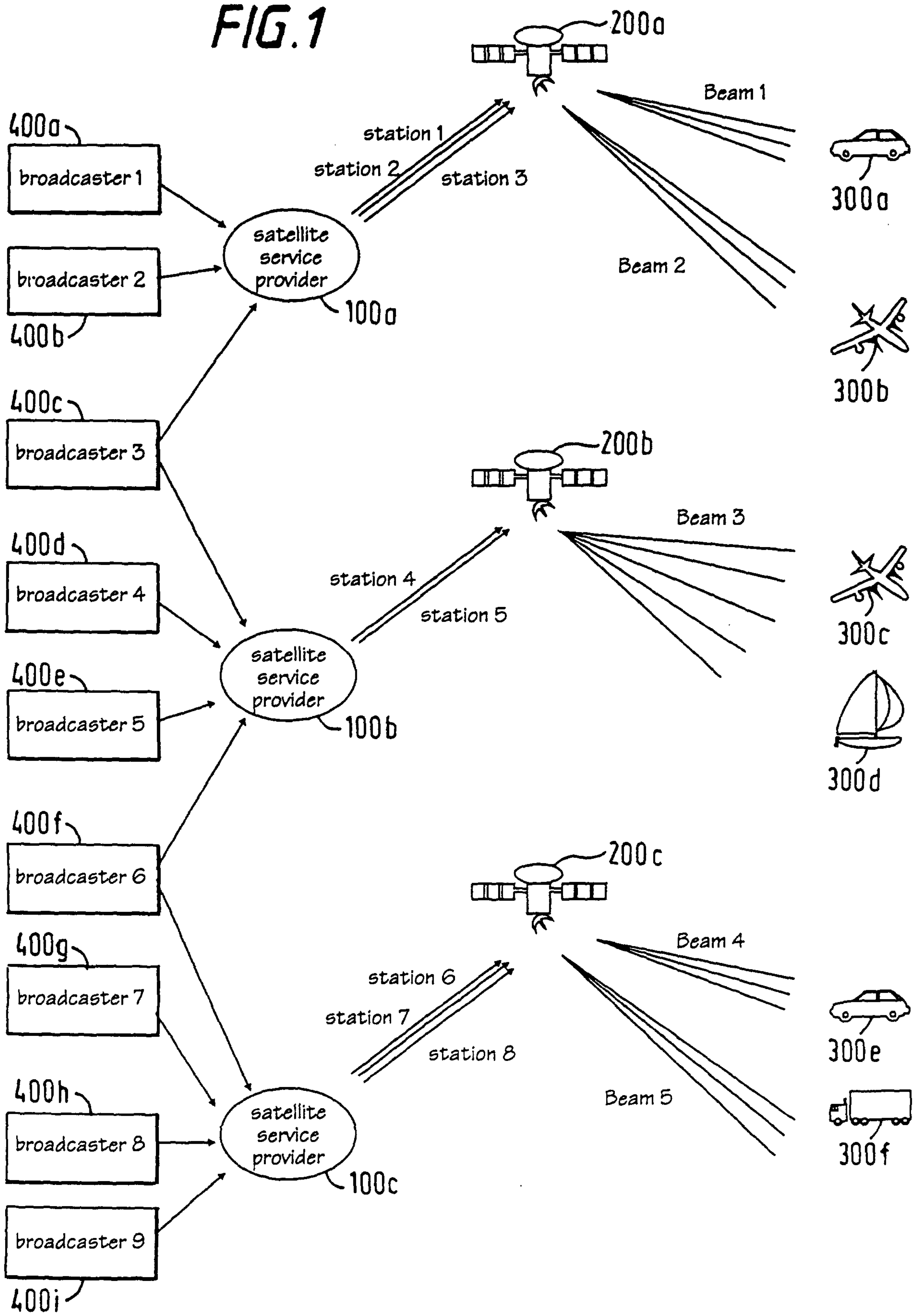
200a
Beam 1
400a
broadcaster 1
station 1
station 2
station 3
satellite service provider
broadcaster 2
400b
100a
Beam 2
300a
300b
400c
broadcaster 3
200b
Beam 3
400d
broadcaster 4
station 4
station 5
300c
400e
broadcaster 5
satellite service provider
100b
300d
400f
broadcaster 6
200c
400g
broadcaster 7
Beam 4
station 6
station 7
station 8
300e
400h
broadcaster 8
satellite service provider
Beam 5
300f
100c
broadcaster 9
400i

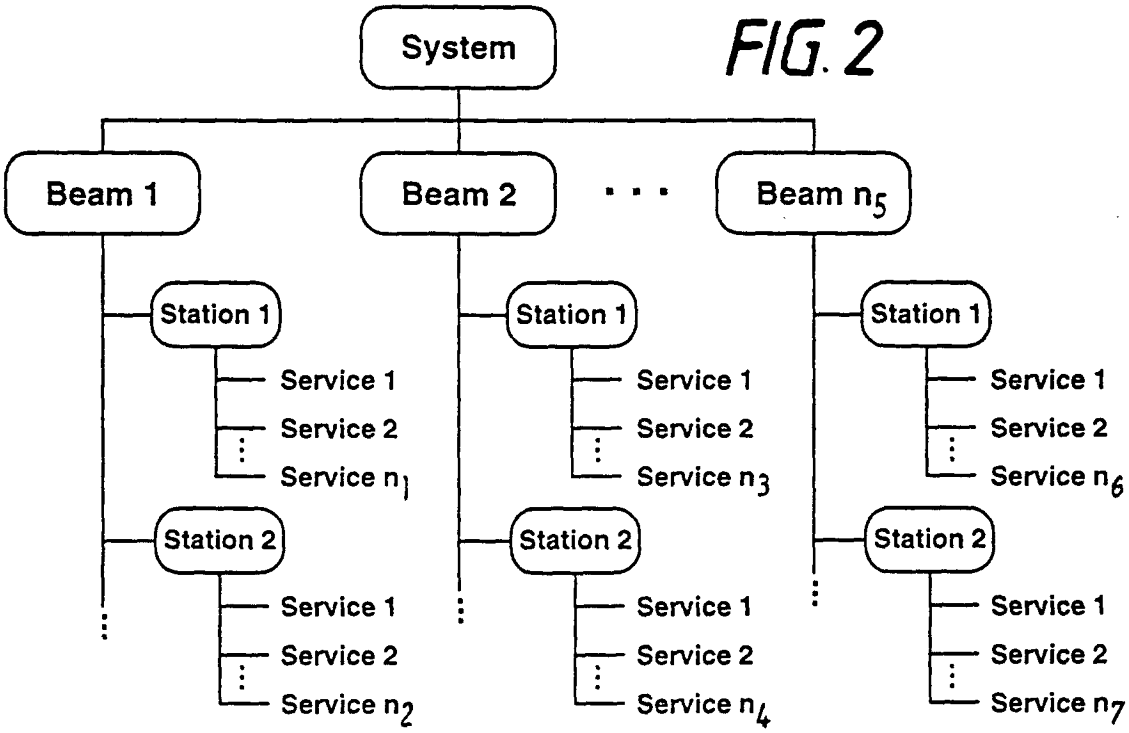
System
Beam 1
Beam 2
Beam n5
Station 1
Service 1
Service 2
Service n1
Station 2
Service 1
Service 2
Service n2
Station 1
Service 1
Service 2
Service n3
Station 2
Service 1
Service 2
Service n4
Station 1
Service 1
Service 2
Service n6
Station 2
Service 1
Service 2
Service n7

FIG. 2

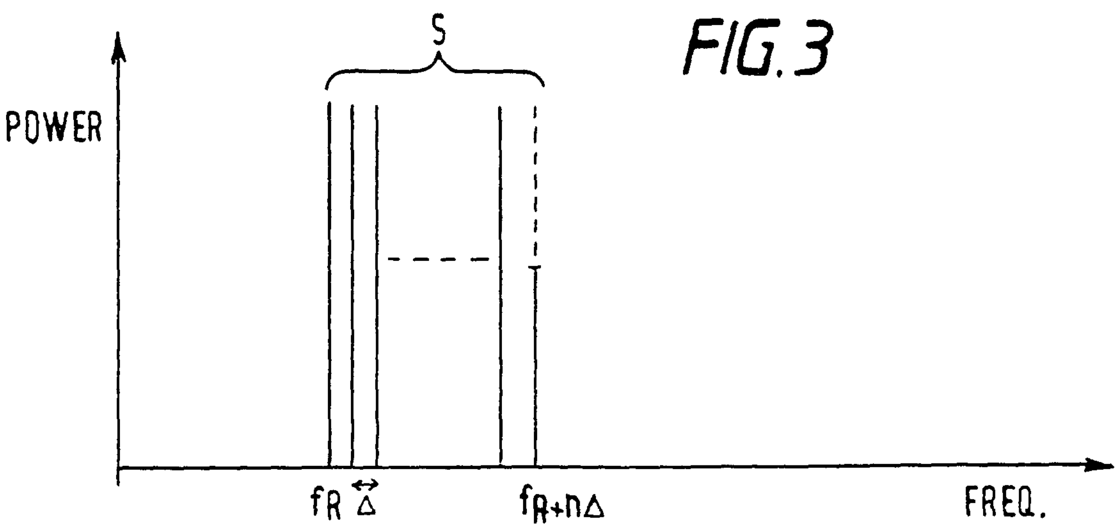
S
POWER
fR
Δ
fR+nΔ
FREQ.

FIG. 3

FIG. 4

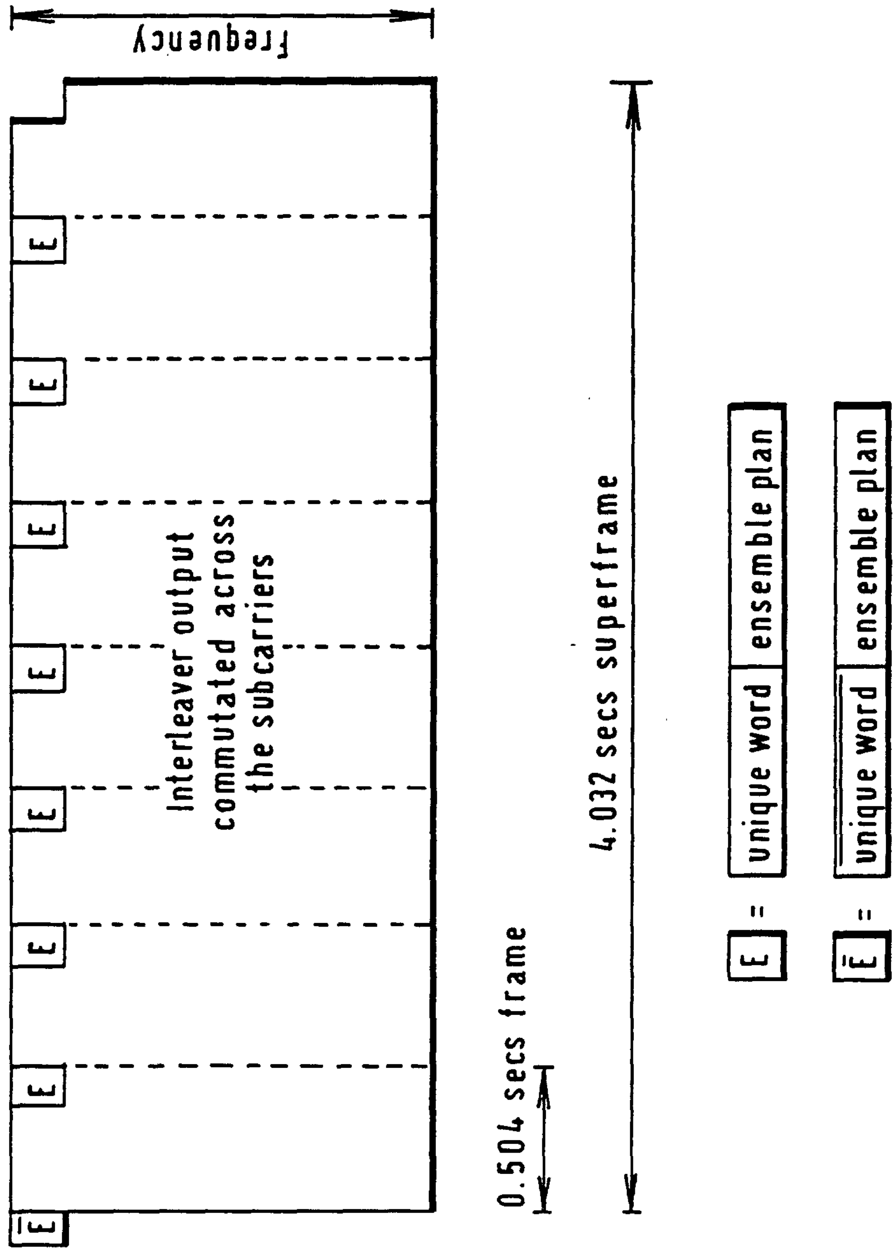
Frequency
Interleaver output
commutated across
the subcarriers
0.504 secs frame
4.032 secs superframe
E = unique word ensemble plan
Ē = unique word ensemble plan

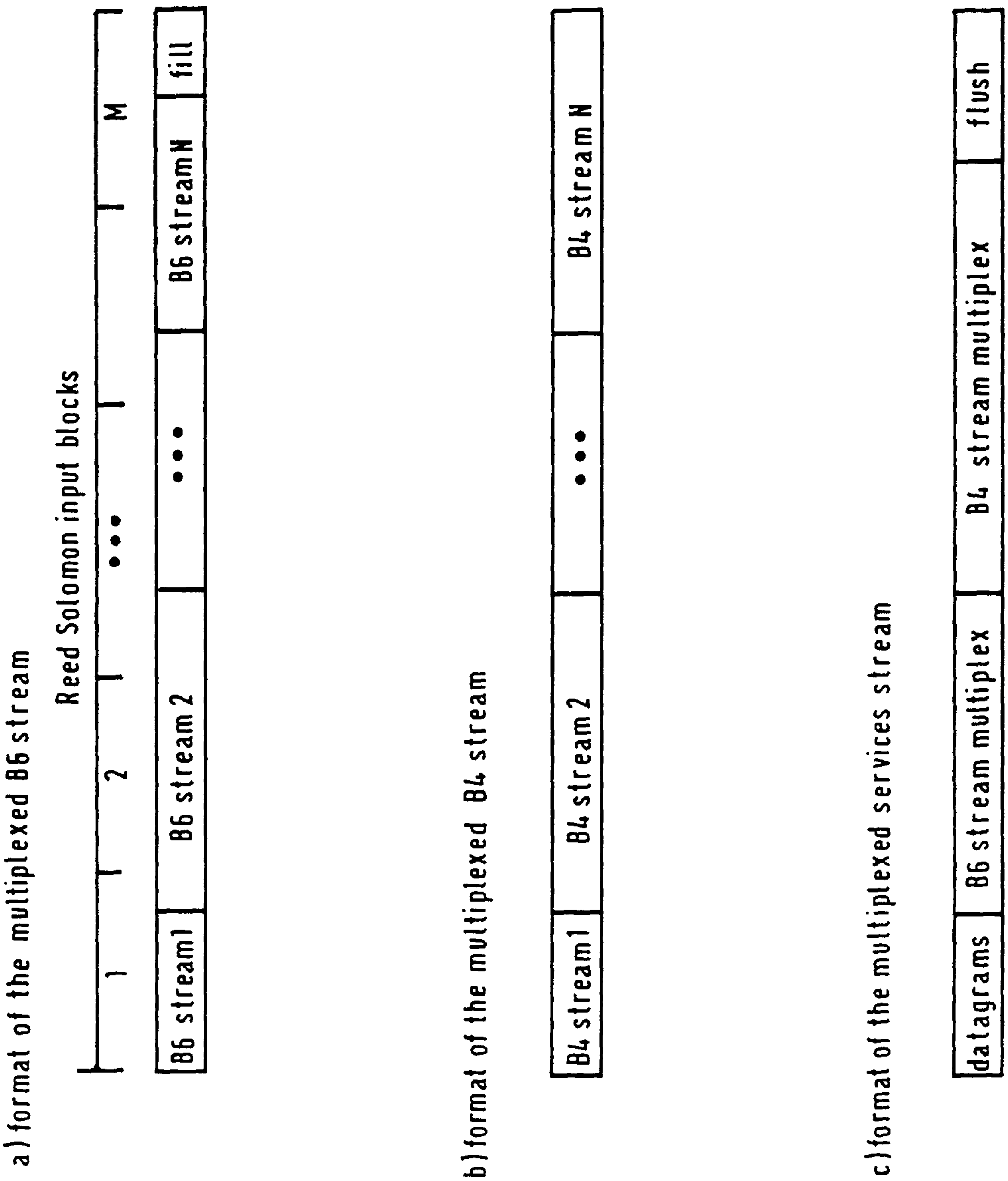
a) format of the multiplexed B6 stream
Reed Solomon input blocks
1
2
M
B6 stream1
B6 stream2
B6 streamN
fill
b) format of the multiplexed B4 stream
B4 stream1
B4 stream2
B4 stream N
c) format of the multiplexed services stream
datagrams
B6 stream multiplex
B4 stream multiplex
flush

FIG. 5

FIG.6a

transmitted subcarriers
MR=main ref; R,r=ref; D,d=data
uppercase=full, lowercase=half

| ensemble configur. | | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|---|
| 0 | MR | . | . | . | . | . | . | . | . | . | . | . | . | . | . | . | . | |
| 1 | MR | d | . | . | . | . | . | . | . | . | . | . | . | . | . | . | . | |
| 2 | MR | D | . | . | . | . | . | . | . | . | . | . | . | . | . | . | . | |
| 3 | MR | D | d | . | . | . | . | . | . | . | . | . | . | . | . | . | . | |
| 4 | MR | D | D | . | . | . | . | . | . | . | . | . | . | . | . | . | . | |
| 5 | MR | D | D | r | . | . | . | . | . | . | . | . | . | . | . | . | . | |
| 6 | MR | D | D | R | . | . | . | . | . | . | . | . | . | . | . | . | . | |
| 7 | MR | D | D | R | d | . | . | . | . | . | . | . | . | . | . | . | . | |
| 8 | MR | D | D | R | D | . | . | . | . | . | . | . | . | . | . | . | . | |
| 9 | MR | D | D | R | D | d | . | . | . | . | . | . | . | . | . | . | . | |
| 10 | MR | D | D | R | D | D | . | . | . | . | . | . | . | . | . | . | . | |
| 11 | MR | D | D | R | D | D | r | . | . | . | . | . | . | . | . | . | . | |
| 12 | MR | D | D | R | D | D | R | . | . | . | . | . | . | . | . | . | . | |
| 13 | MR | D | D | R | D | D | R | d | . | . | . | . | . | . | . | . | . | |
| 14 | MR | D | D | R | D | D | R | D | . | . | . | . | . | . | . | . | . | |
| 15 | MR | D | D | R | D | D | R | D | d | . | . | . | . | . | . | . | . | |
| 16 | MR | D | D | R | D | D | R | D | D | . | . | . | . | . | . | . | . | |
| 17 | MR | D | D | R | D | D | R | D | D | r | . | . | . | . | . | . | . | |
| 18 | MR | D | D | R | D | D | R | D | D | R | . | . | . | . | . | . | . | |
| 19 | MR | D | D | R | D | D | R | D | D | R | d | . | . | . | . | . | . | |
| 20 | MR | D | D | R | D | D | R | D | D | R | D | . | . | . | . | . | . | |
| 21 | MR | D | D | R | D | D | R | D | D | R | D | d | . | . | . | . | . | |
| 22 | MR | D | D | R | D | D | R | D | D | R | D | D | . | . | . | . | . | |
| 23 | MR | D | D | R | D | D | R | D | D | R | D | D | r | . | . | . | . | |
| 24 | MR | D | D | R | D | D | R | D | D | R | D | D | R | . | . | . | . | |
| 25 | MR | D | D | R | D | D | R | D | D | R | D | D | R | d | . | . | . | |
| 26 | MR | D | D | R | D | D | R | D | D | R | D | D | R | D | . | . | . | |
| 27 | MR | D | D | R | D | D | R | D | D | R | D | D | R | D | d | . | . | |
| 28 | MR | D | D | R | D | D | R | D | D | R | D | D | R | D | D | . | . | |
| 29 | MR | D | D | R | D | D | R | D | D | R | D | D | R | D | D | r | . | |
| 30 | MR | D | D | R | D | D | R | D | D | R | D | D | R | D | D | R | . | |
| 31 | MR | D | D | R | D | D | R | D | D | R | D | D | R | D | D | R | d | |
| 32 | MR | D | D | R | D | D | R | D | D | R | D | D | R | D | D | R | D | |

→ Frequency

FIG. 6b

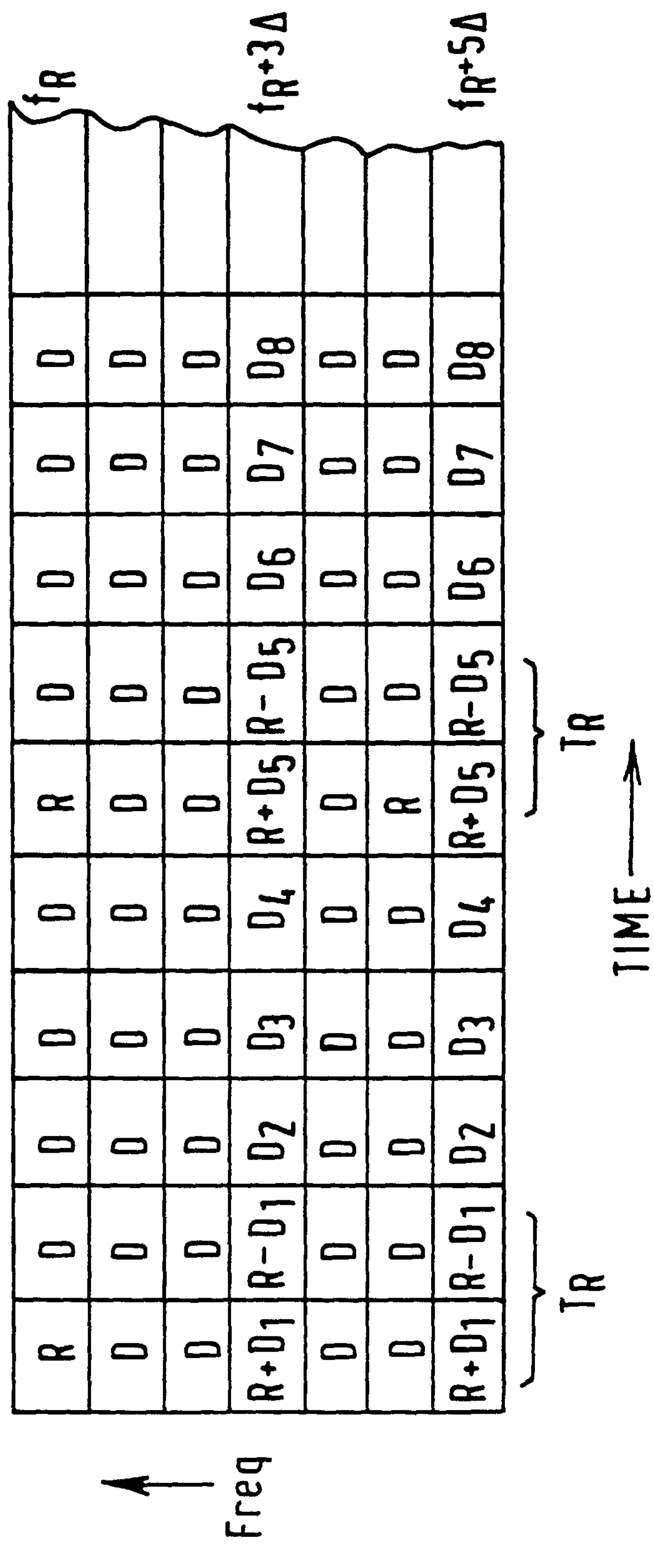

$f_R$
$f_R+3\Delta$
$f_R+5\Delta$
R
D
R+D1
R−D1
D2
D3
D4
R+D5
R−D5
D6
D7
D8
TR
TR
TIME
Freq

FIG. 7

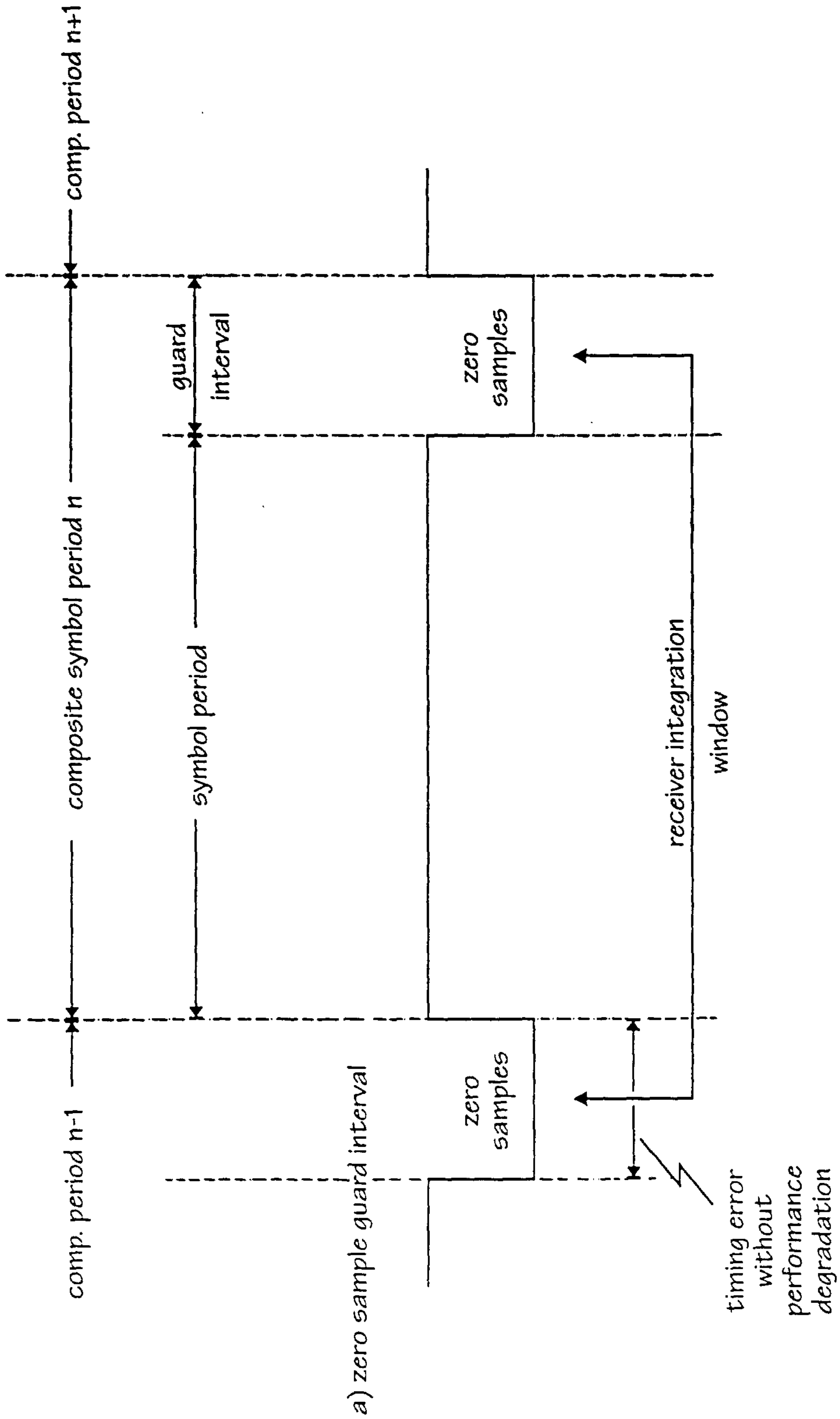
comp. period n-1
composite symbol period n
comp. period n+1
symbol period
guard interval
zero samples
zero samples
receiver integration window
timing error without performance degradation
a) zero sample guard interval

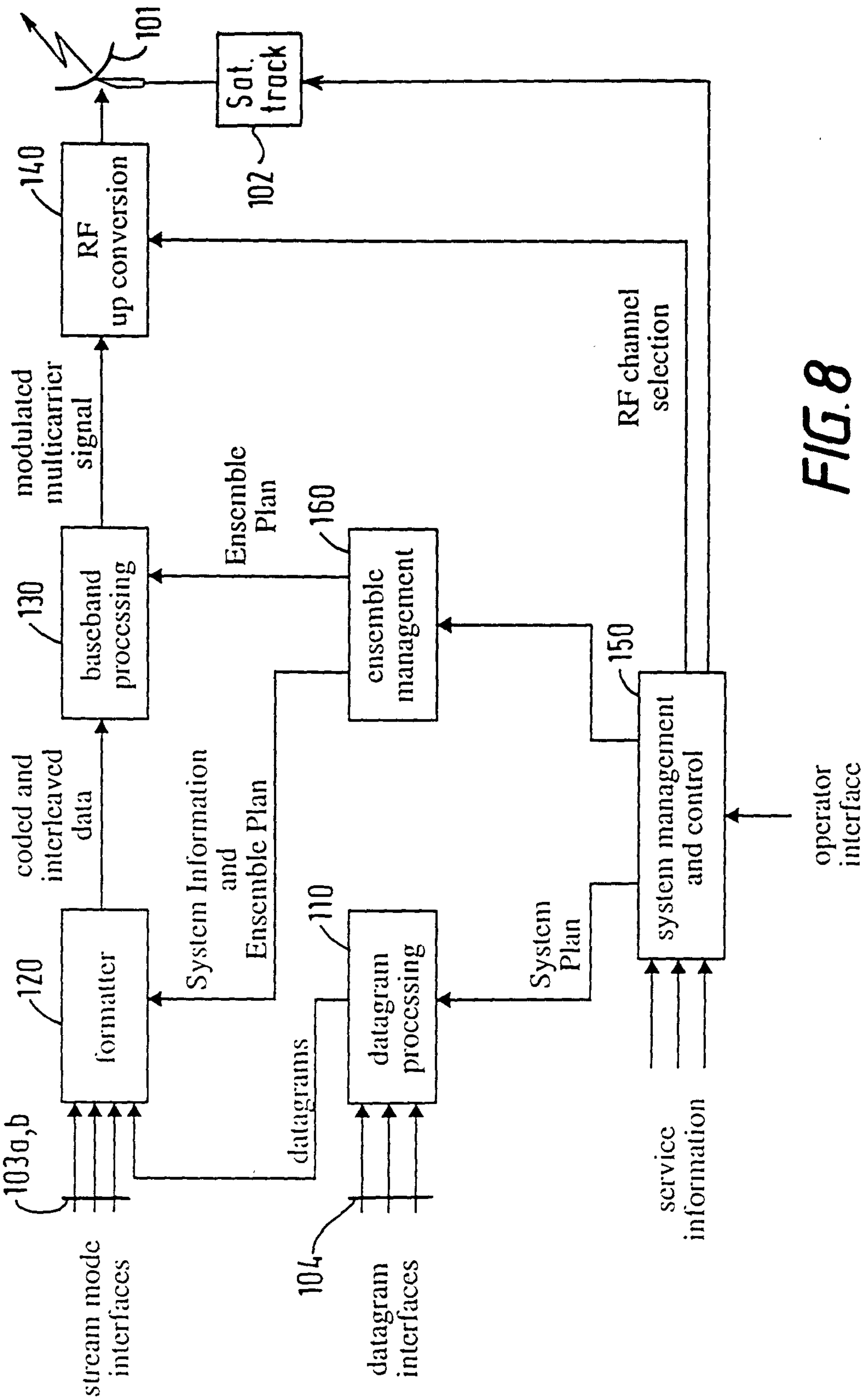
stream mode interfaces
103a,b
104
datagram interfaces
datagrams
120
formatter
110
datagram processing
service information
coded and interleaved data
System Information and Ensemble Plan
System Plan
130
baseband processing
160
ensemble management
Ensemble Plan
150
system management and control
operator interface
modulated multicarrier signal
140
RF up conversion
RF channel selection
101
102
Sat. track

FIG. 8

FIG. 9

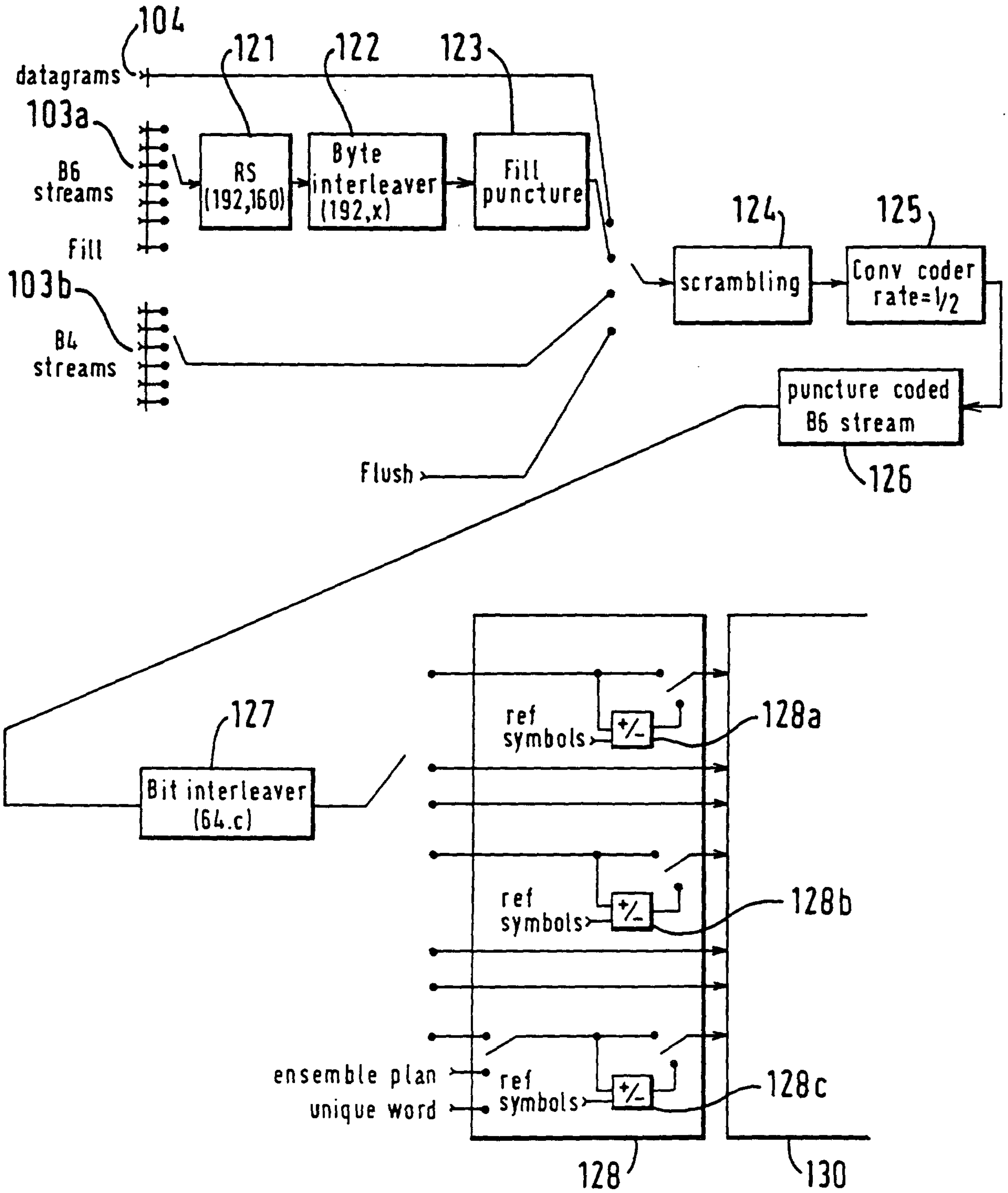
104
datagrams
121
122
123
103a
B6 streams
RS (192,160)
Byte interleaver (192,x)
Fill puncture
Fill
124
125
scrambling
Conv coder rate=1/2
103b
B4 streams
puncture coded B6 stream
Flush
126
127
Bit interleaver (64.c)
ref symbols
+/-
128a
ref symbols
128b
ensemble plan
unique word
ref symbols
128c
128
130

FIG. 10

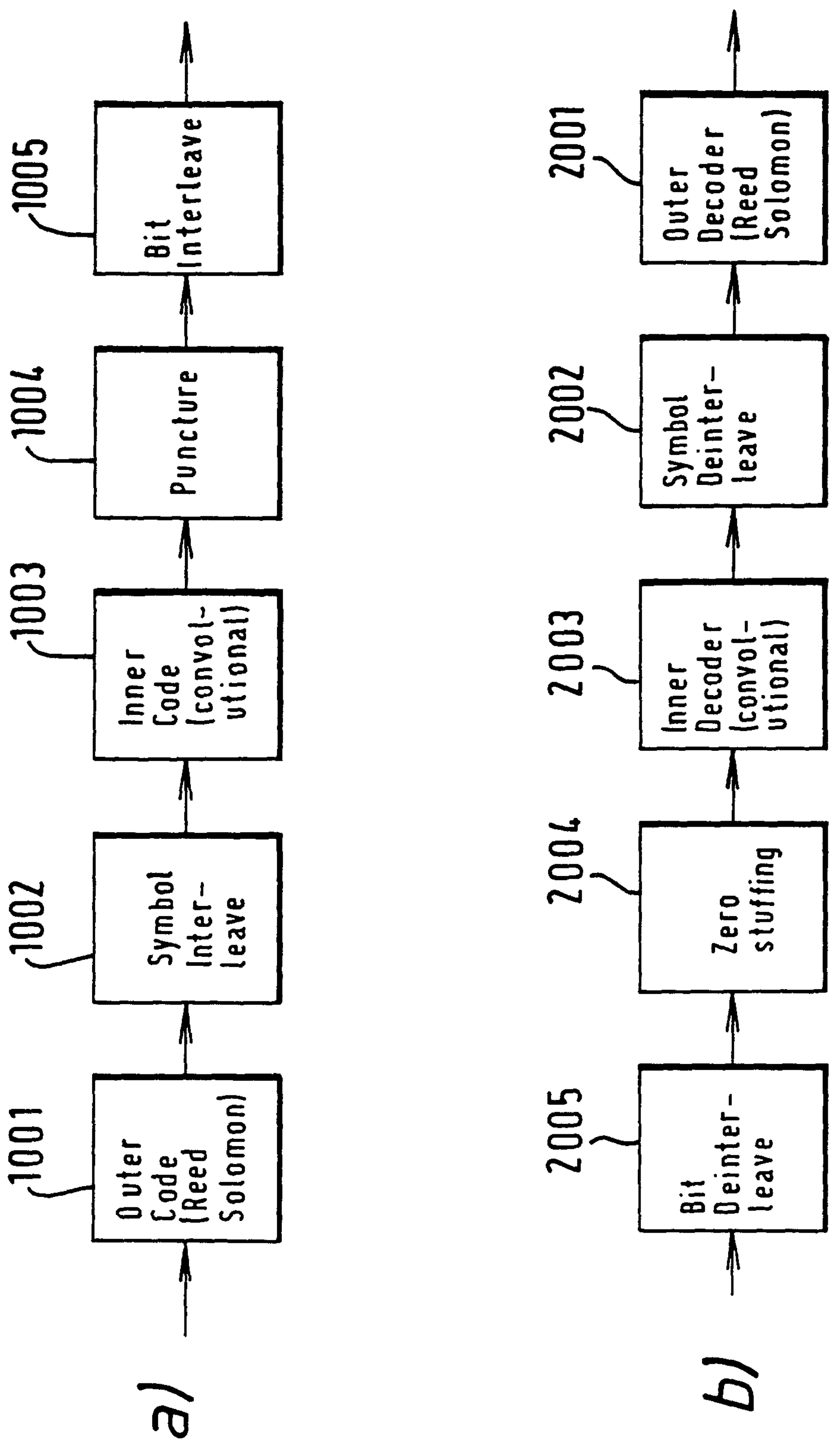
a)
1001
Outer Code (Reed Solomon)
1002
Symbol Inter-leave
1003
Inner Code (convol-utional)
1004
Puncture
1005
Bit Interleave
b)
2005
Bit Deinter-leave
2004
Zero stuffing
2003
Inner Decoder (convol-utional)
2002
Symbol Deinter-leave
2001
Outer Decoder (Reed Solomon)

FIG.11

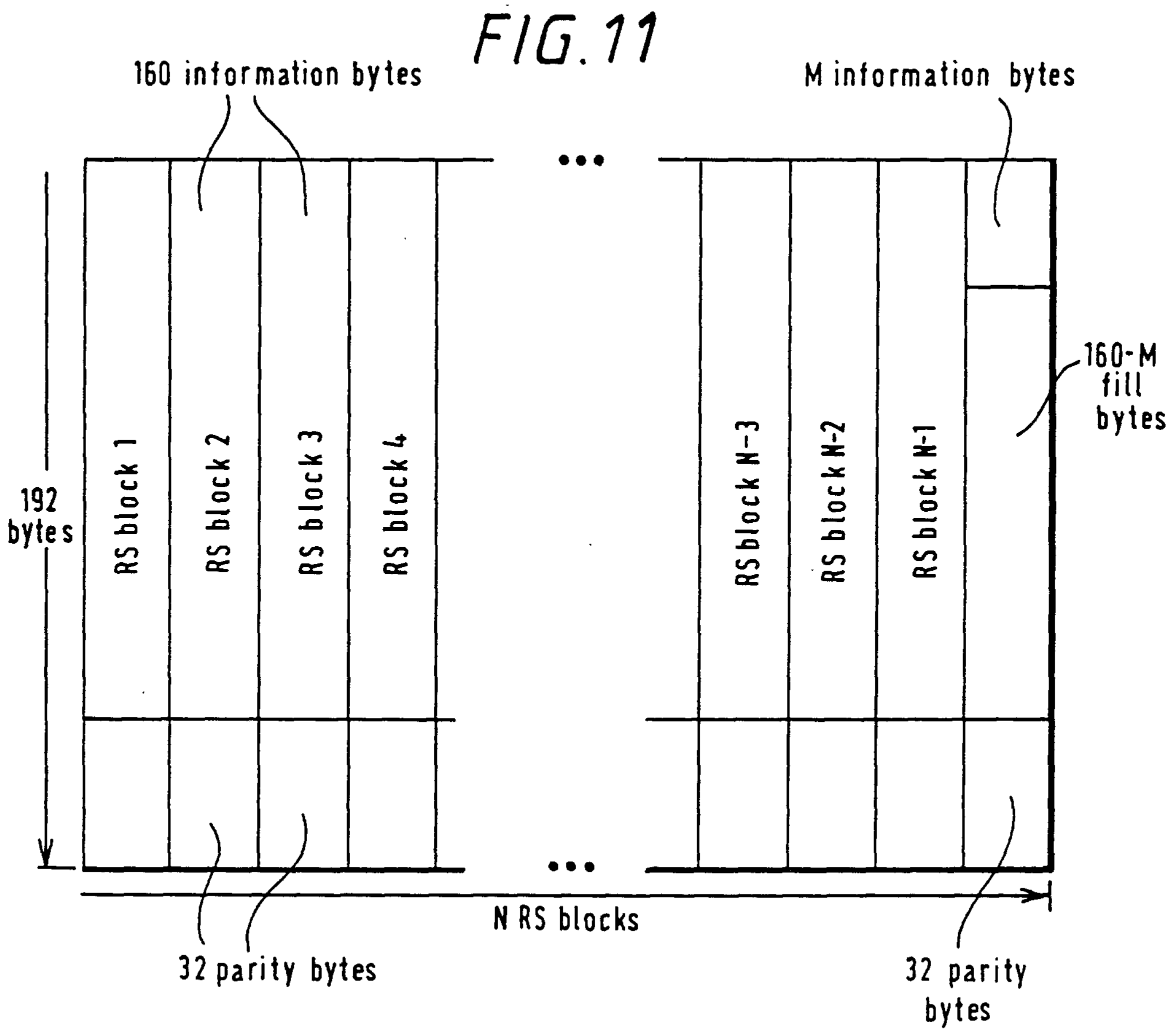
160 information bytes
M information bytes
192 bytes
RS block 1
RS block 2
RS block 3
RS block 4
RS block N-3
RS block N-2
RS block N-1
160-M fill bytes
N RS blocks
32 parity bytes
32 parity bytes

FIG. 12

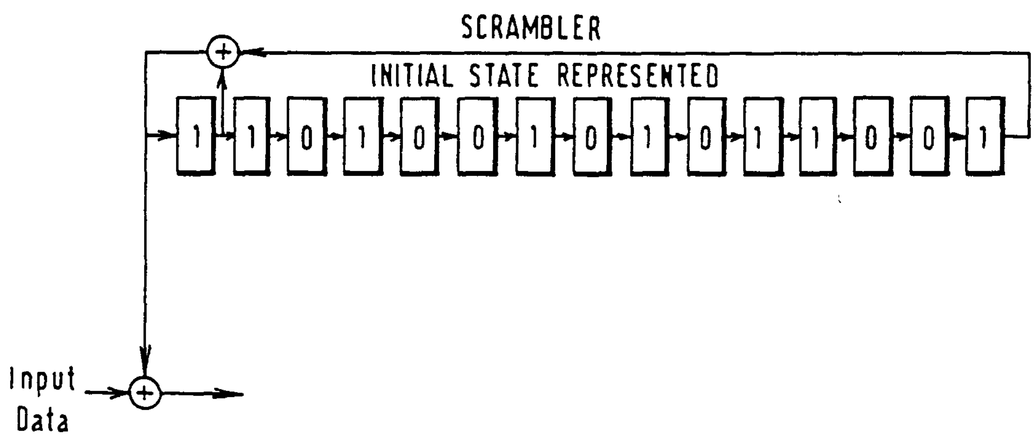
SCRAMBLER
INITIAL STATE REPRESENTED
1 1 0 1 0 0 1 0 1 0 1 1 0 0 1
Input Data

FIG. 13

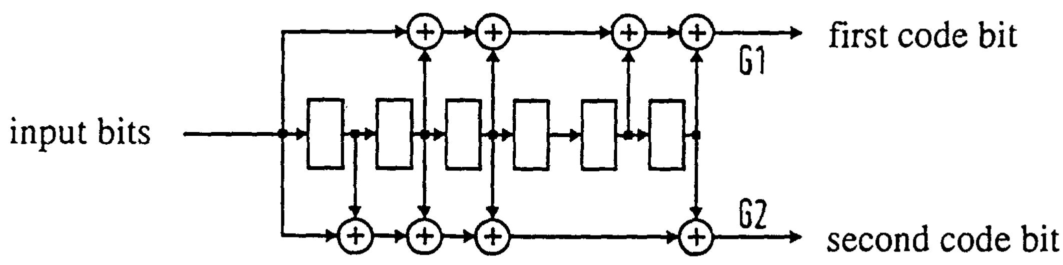

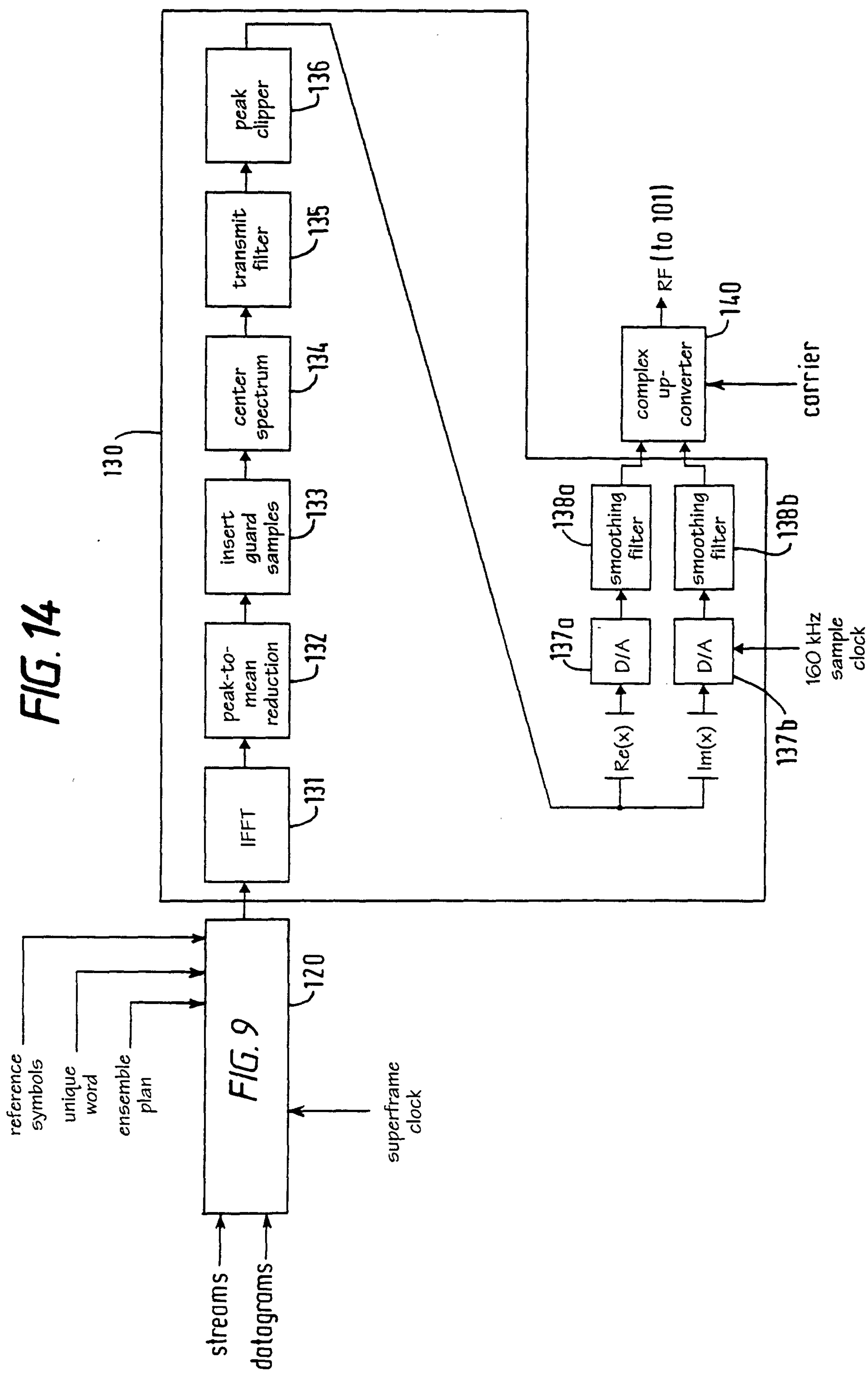
reference symbols
unique word
ensemble plan
streams
datagrams
FIG. 9
120
superframe clock
130
IFFT
131
peak-to-mean reduction
132
insert guard samples
133
center spectrum
134
transmit filter
135
peak clipper
136
Re(x)
Im(x)
D/A
137a
D/A
137b
160 kHz sample clock
smoothing filter
138a
smoothing filter
138b
complex up-converter
140
carrier
RF (to 101)

FIG. 14

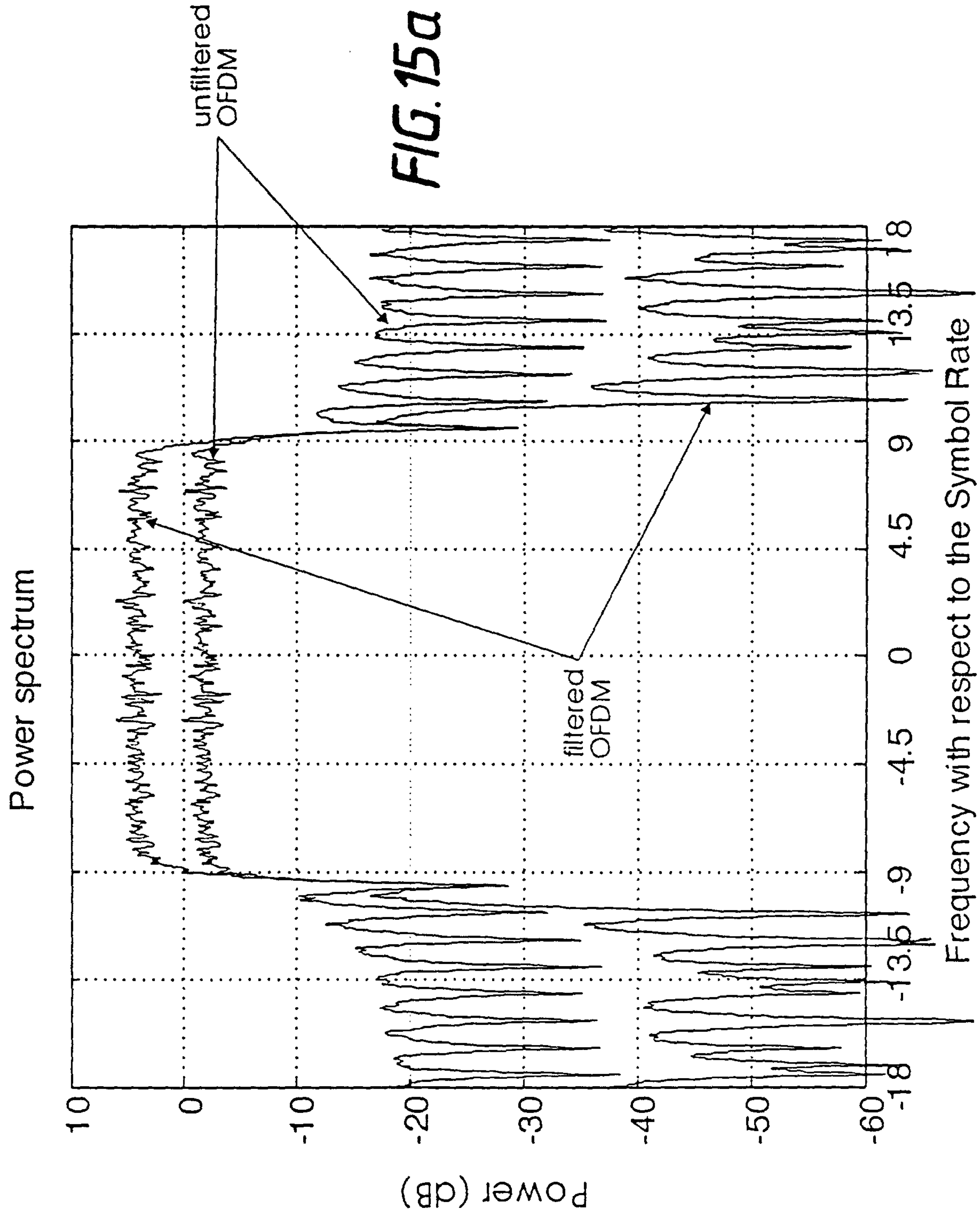
Power spectrum
Power (dB)
10
0
-10
-20
-30
-40
-50
-60
-18
-13.5
-9
-4.5
0
4.5
9
13.5
18
Frequency with respect to the Symbol Rate
unfiltered
OFDM
filtered
OFDM

FIG. 15a

FIG.15b

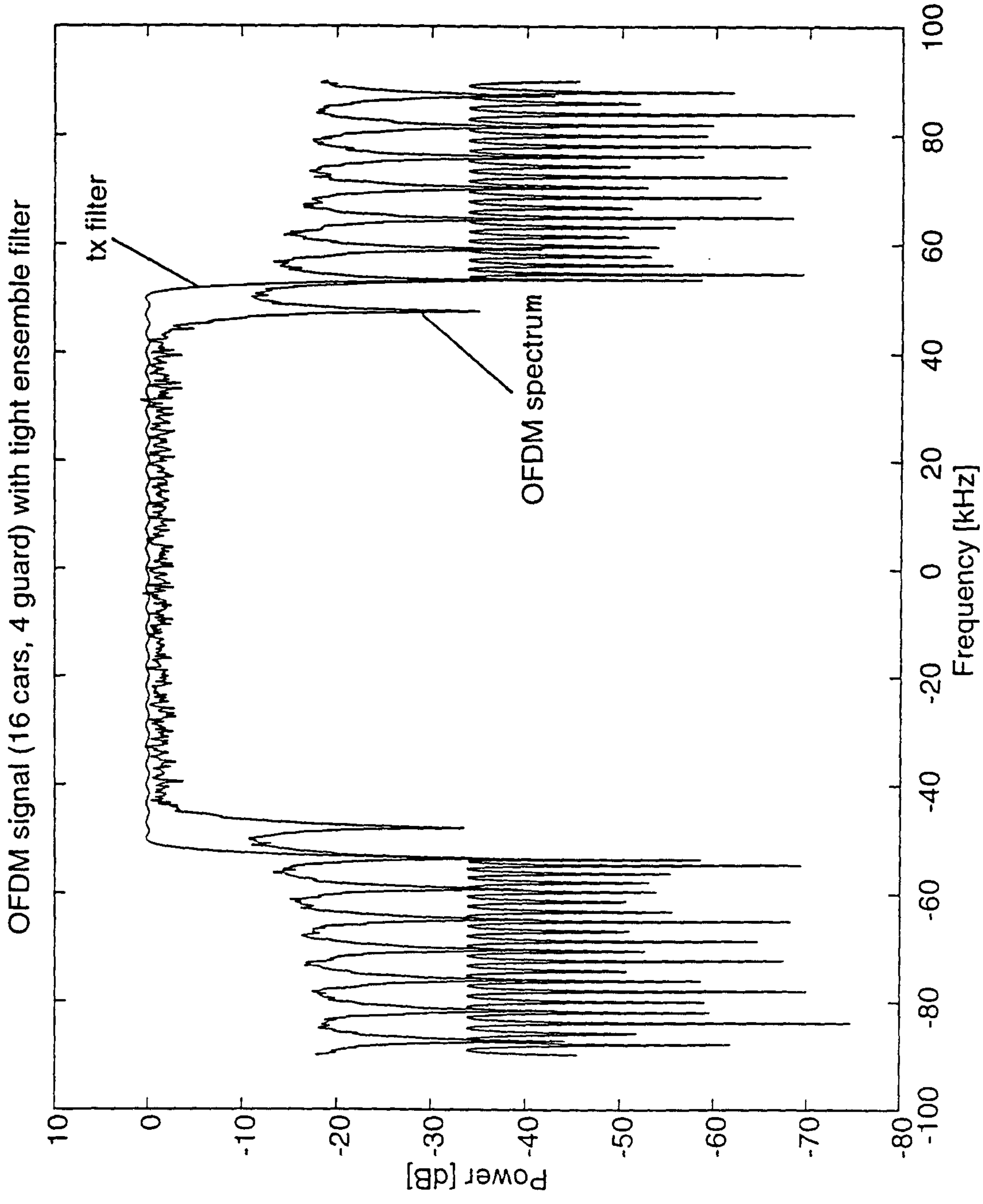
OFDM signal (16 cars, 4 guard) with tight ensemble filter
tx filter
OFDM spectrum
Power [dB]
Frequency [kHz]
10
0
-10
-20
-30
-40
-50
-60
-70
-80
-100
-80
-60
-40
-20
0
20
40
60
80
100

FIG. 16a

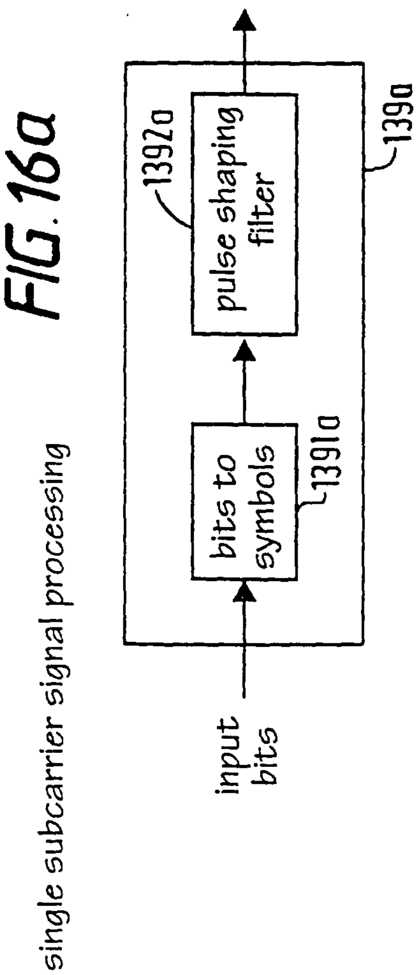


FIG. 16b

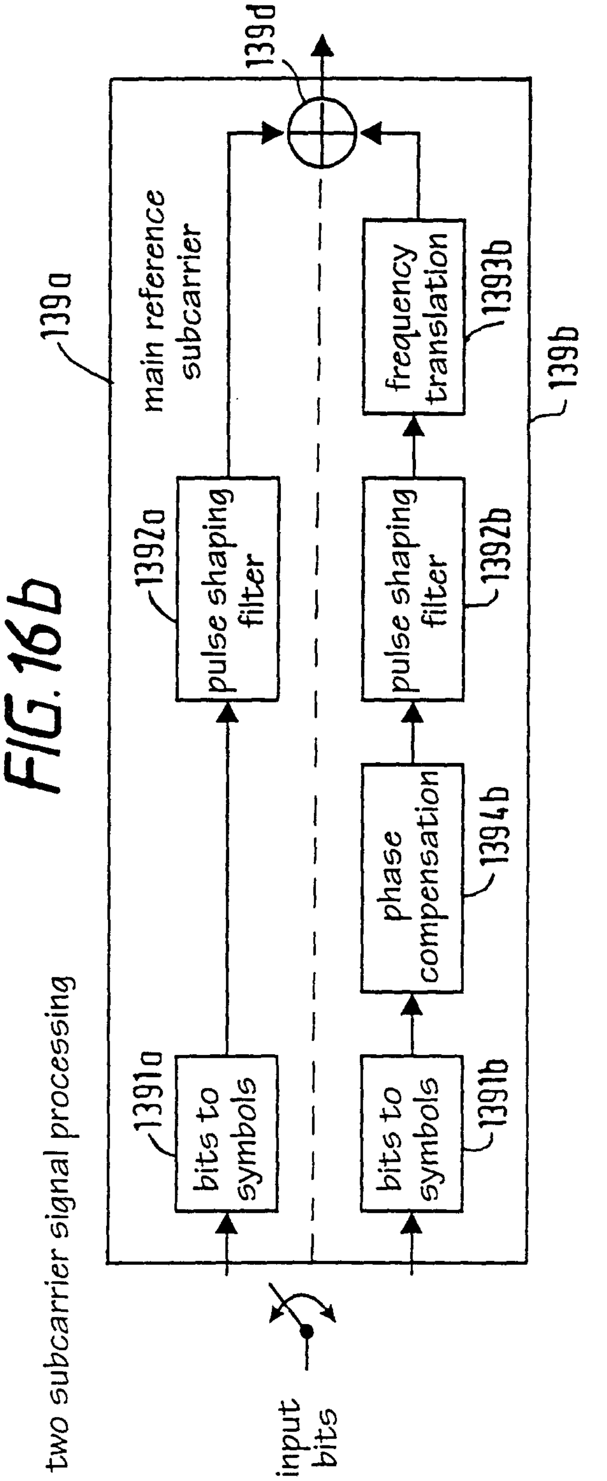

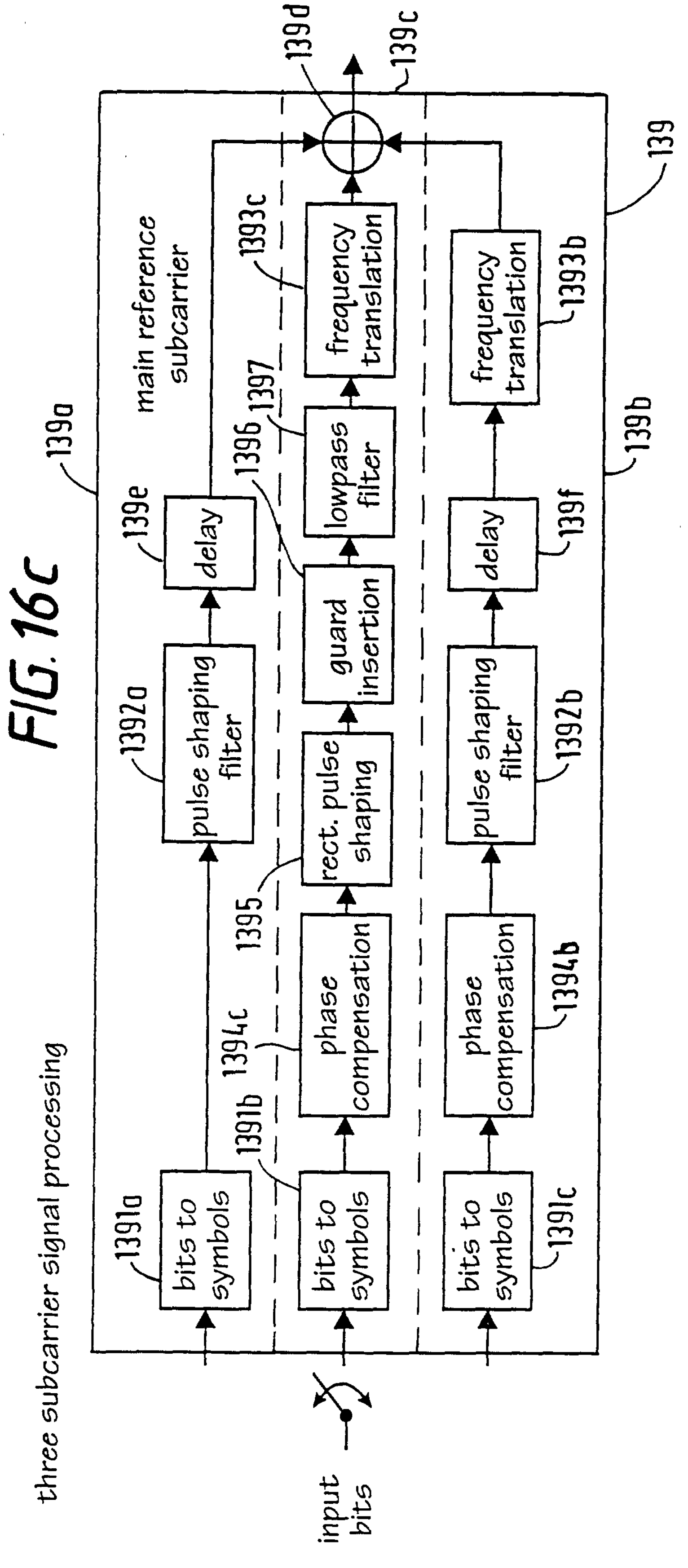
three subcarrier signal processing
main reference subcarrier
input bits
bits to symbols
1391a
bits to symbols
1391b
bits to symbols
1391c
phase compensation
1394c
phase compensation
1394b
pulse shaping filter
1392a
rect. pulse shaping
1395
pulse shaping filter
1392b
guard insertion
1396
delay
139e
delay
139f
lowpass filter
1397
frequency translation
1393c
frequency translation
1393b
139a
139b
139c
139d
139

FIG. 16c

FIG. 17

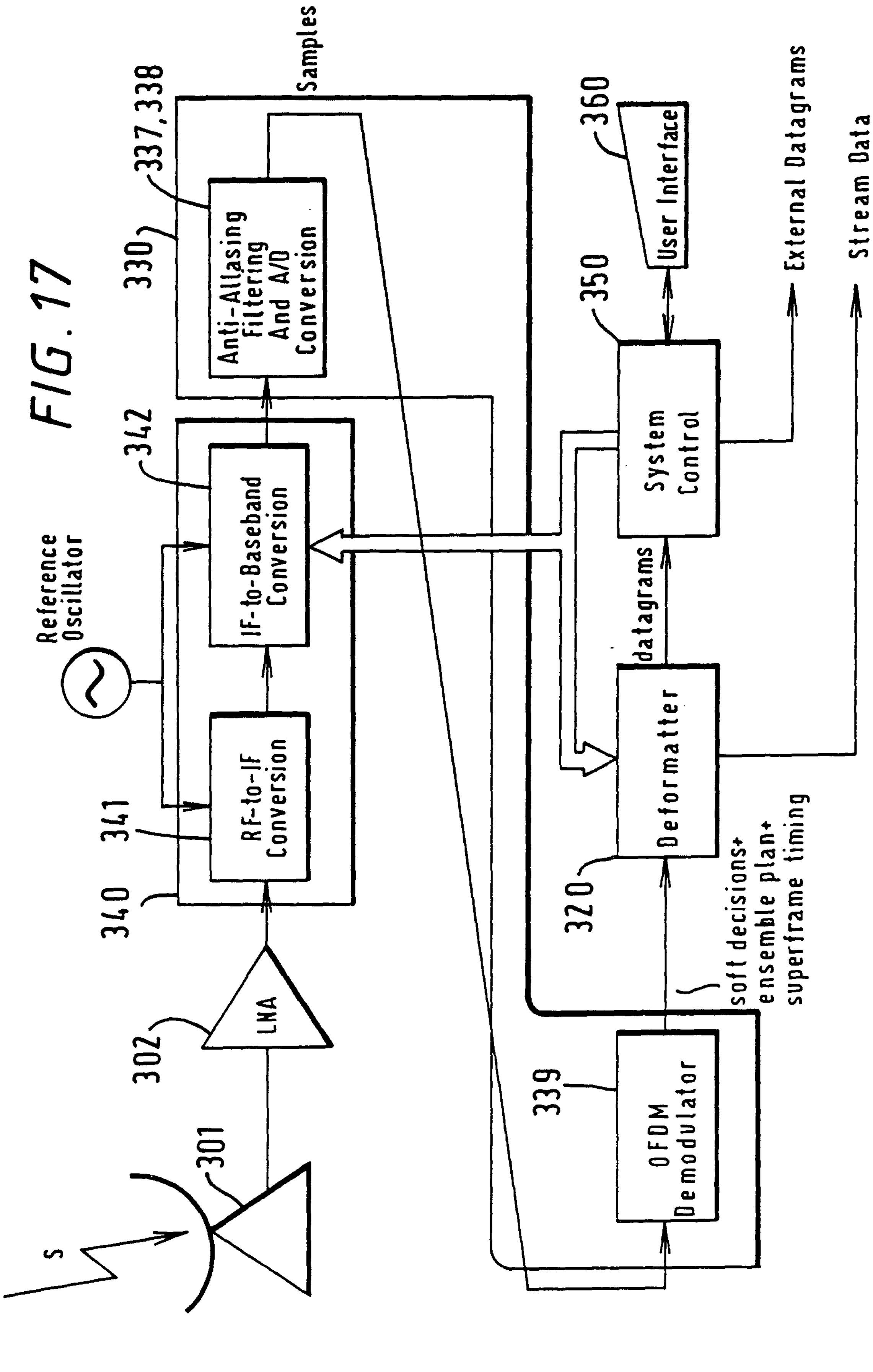
S
301
302
LNA
340
341
RF-to-IF Conversion
Reference Oscillator
342
IF-to-Baseband Conversion
330
337,338
Anti-Aliasing Filtering And A/D Conversion
Samples
339
OFDM Demodulator
soft decisions+
ensemble plan+
superframe timing
320
Deformatter
datagrams
350
System Control
360
User Interface
External Datagrams
Stream Data

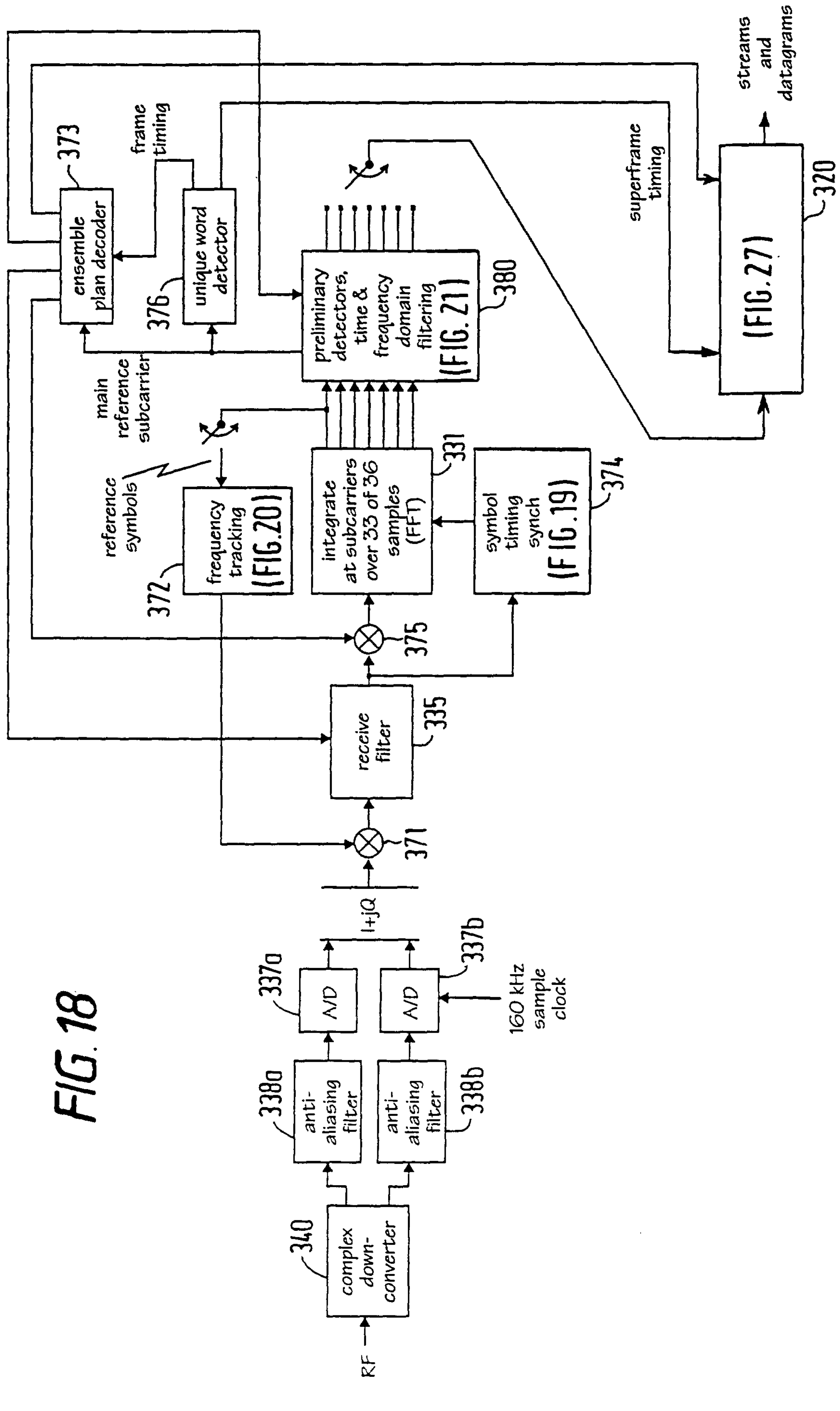
RF
complex down-converter
340
anti-aliasing filter
338a
anti-aliasing filter
338b
A/D
337a
A/D
337b
160 kHz sample clock
I+jQ
371
receive filter
335
375
frequency tracking (FIG.20)
372
reference symbols
integrate at subcarriers over 33 of 36 samples (FFT)
331
symbol timing synch (FIG.19)
374
main reference subcarrier
preliminary detectors, time & frequency domain filtering (FIG.21)
380
ensemble plan decoder
373
unique word detector
376
frame timing
superframe timing
(FIG.27)
320
streams and datagrams

FIG. 18

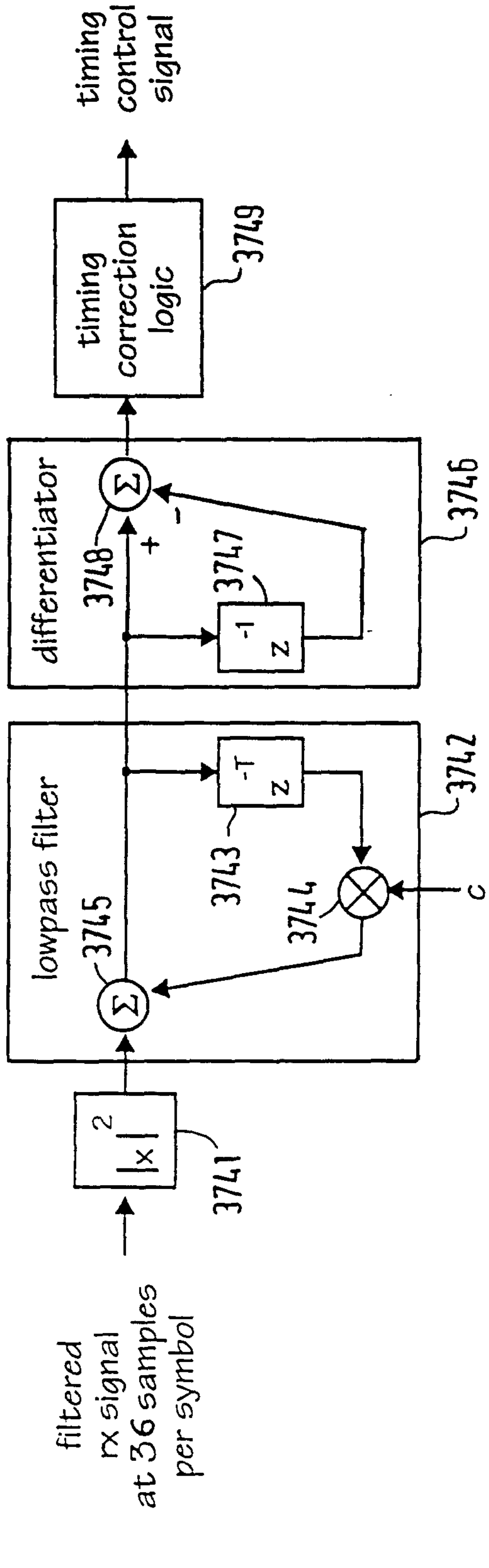
filtered
rx signal
at 36 samples
per symbol
$|x|^2$
3741
lowpass filter
3745
3743
3744
c
3742
differentiator
3748
3747
+
−
3746
timing
correction
logic
3749
timing
control
signal

FIG.19

FIG. 20

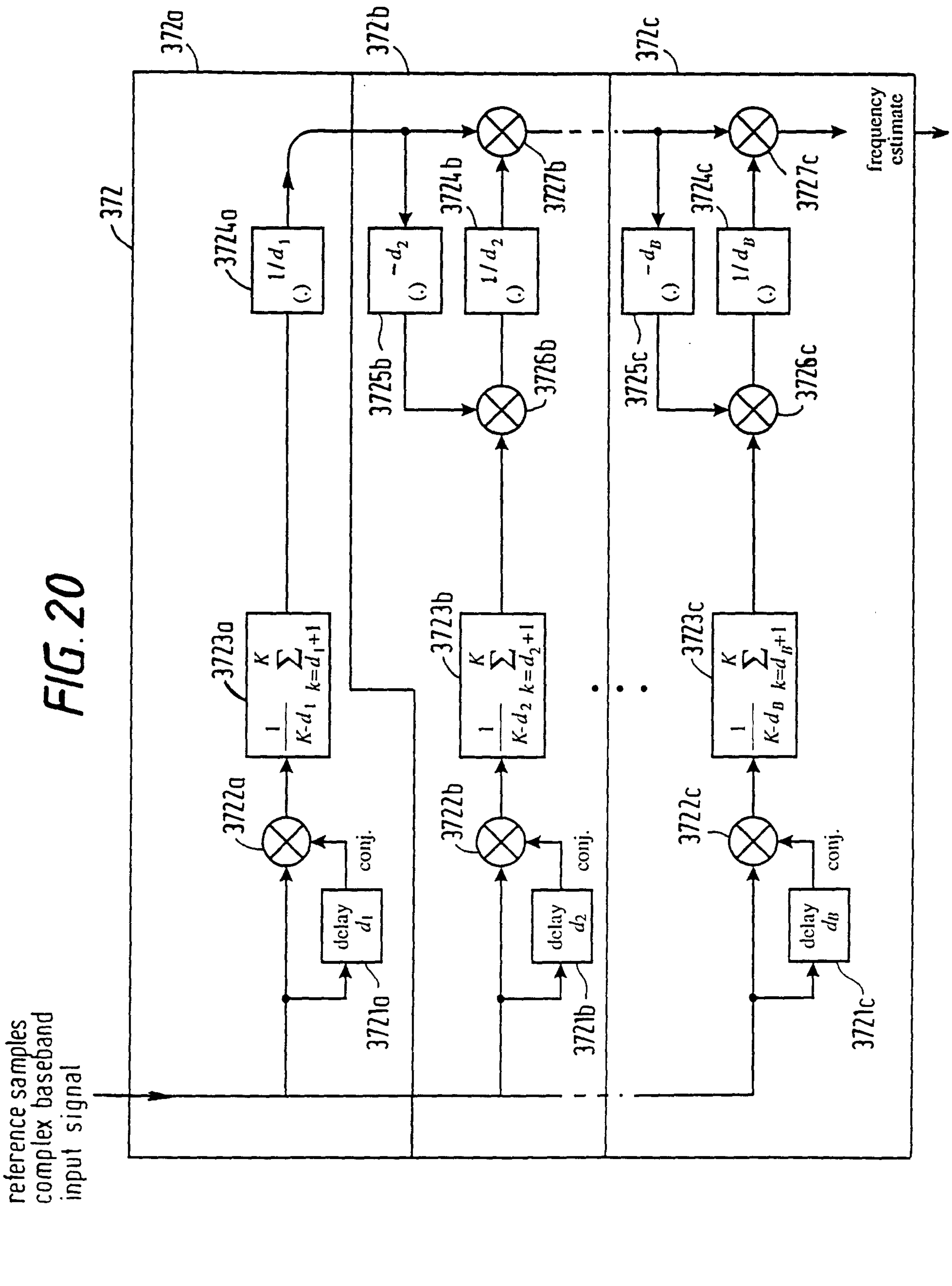
reference samples complex baseband input signal
372
372a
372b
372c
3721a
3721b
3721c
delay $d_1$
delay $d_2$
delay $d_B$
conj.
3722a
3722b
3722c
3723a
3723b
3723c
$\frac{1}{K-d_1}\sum_{k=d_1+1}^{K}$
$\frac{1}{K-d_2}\sum_{k=d_2+1}^{K}$
$\frac{1}{K-d_B}\sum_{k=d_B+1}^{K}$
3724a
3724b
3724c
$(.)^{1/d_1}$
$(.)^{1/d_2}$
$(.)^{1/d_B}$
3725b
3725c
$(.)^{-d_2}$
$(.)^{-d_B}$
3726b
3726c
3727b
3727c
frequency estimate

FIG. 21

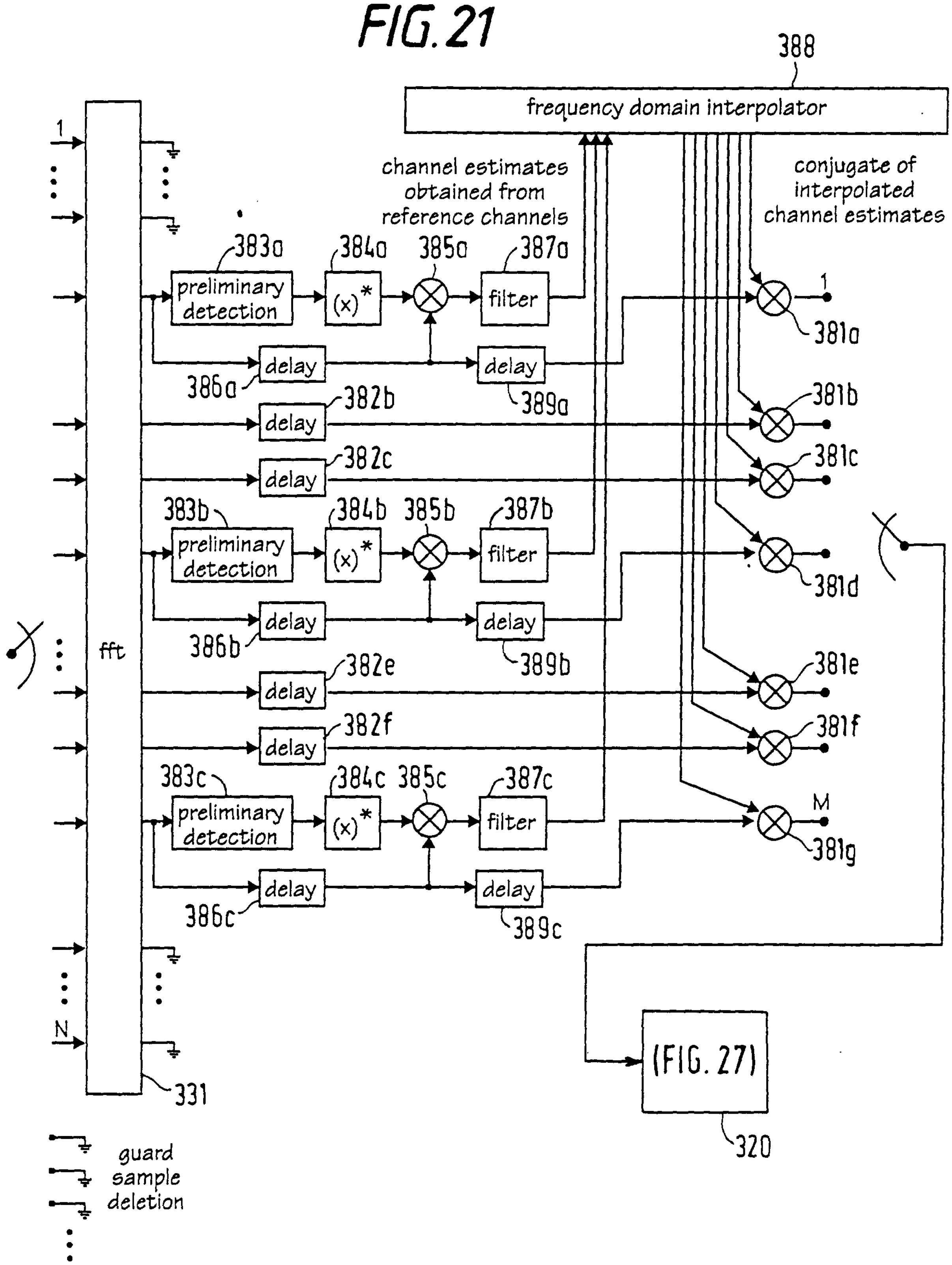
388
frequency domain interpolator
channel estimates obtained from reference channels
conjugate of interpolated channel estimates
1
N
fft
331
383a
preliminary detection
384a
(x)*
385a
387a
filter
386a
delay
389a
382b
382c
383b
384b
385b
387b
386b
389b
382e
382f
383c
384c
385c
387c
386c
389c
381a
381b
381c
381d
381e
381f
381g
M
(FIG. 27)
320
guard sample deletion

FIG. 22

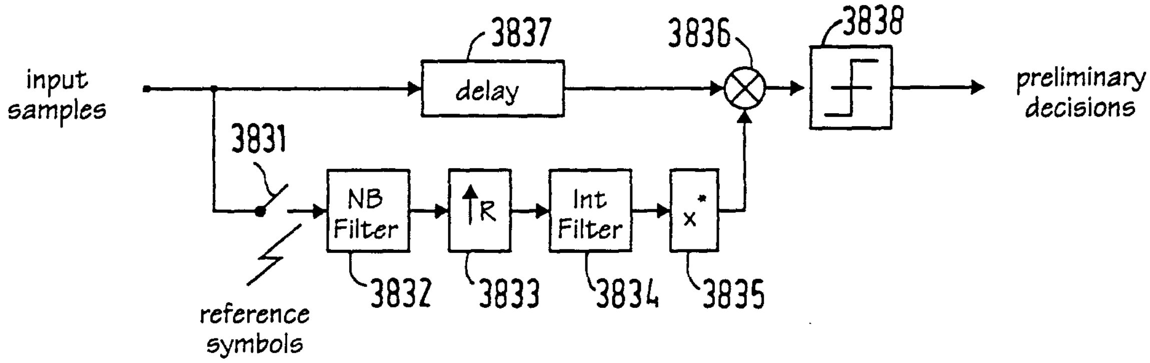
input samples
3837
delay
3836
3838
preliminary decisions
3831
NB Filter
R
Int Filter
x*
reference symbols
3832
3833
3834
3835

FIG. 24

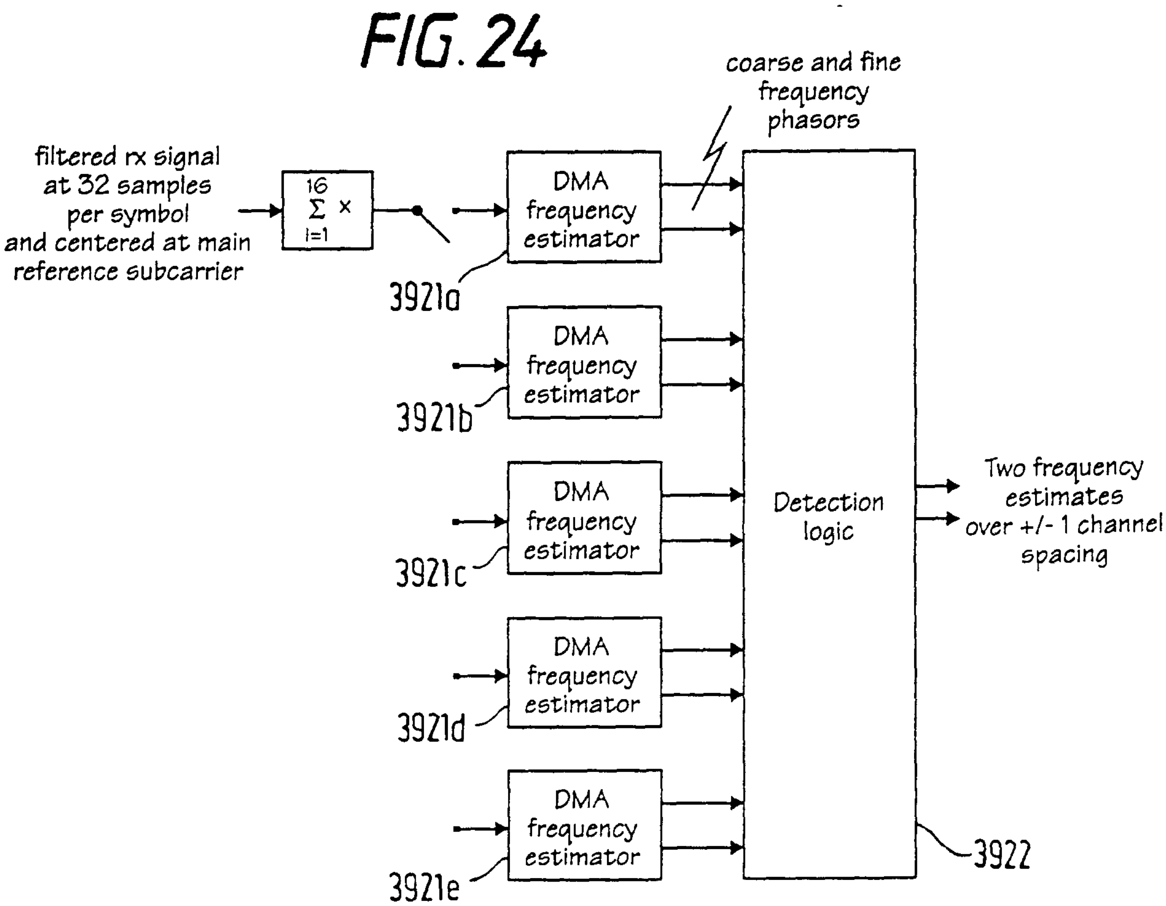
coarse and fine frequency phasors
filtered rx signal at 32 samples per symbol and centered at main reference subcarrier
16 Σ x i=1
DMA frequency estimator
3921a
DMA frequency estimator
3921b
DMA frequency estimator
3921c
DMA frequency estimator
3921d
DMA frequency estimator
3921e
Detection logic
Two frequency estimates over +/- 1 channel spacing
3922

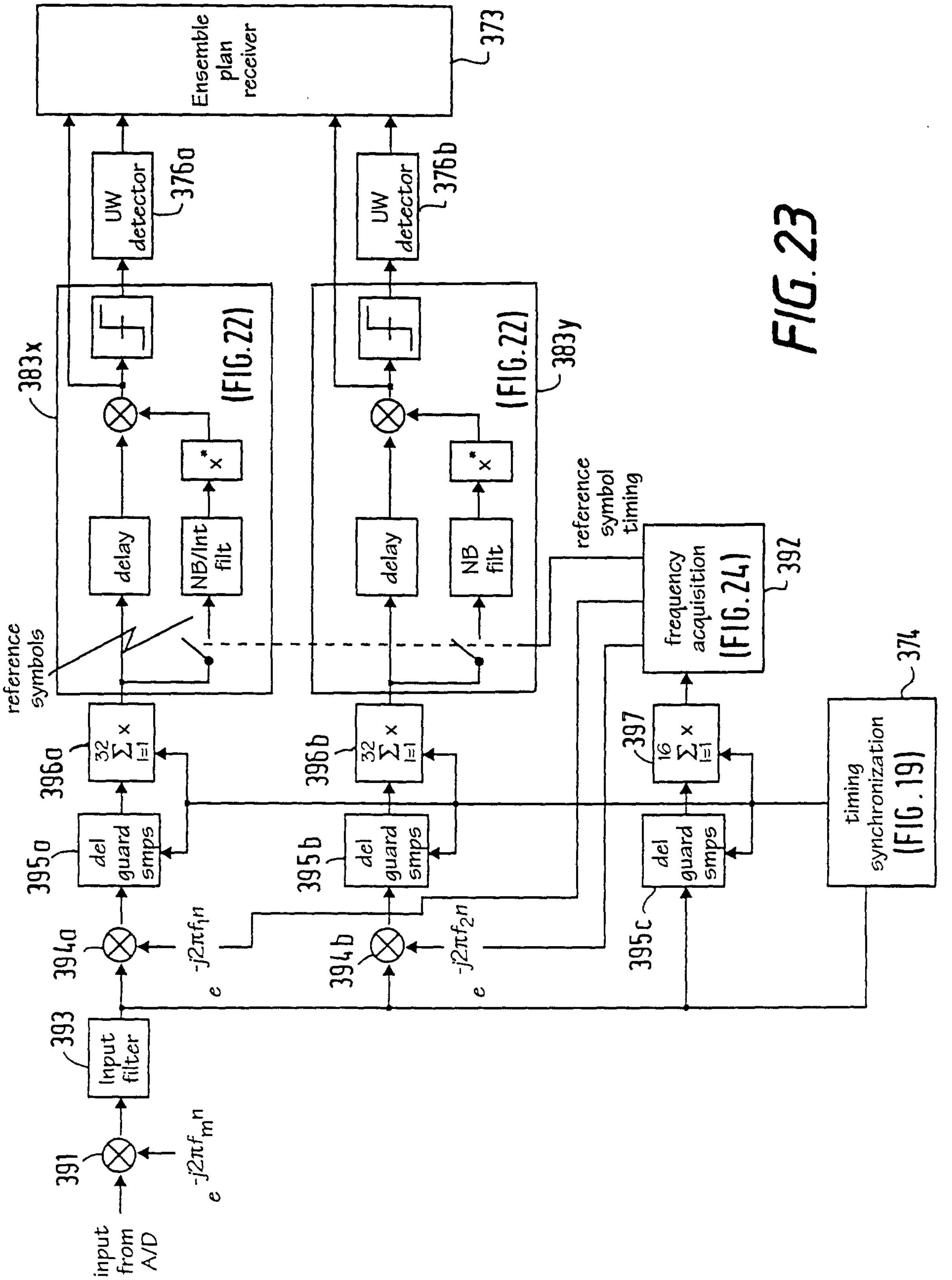

input from A/D
391
$e^{-j2\pi f_m n}$
393
Input filter
394a
$e^{-j2\pi f_1 n}$
394b
$e^{-j2\pi f_2 n}$
395a
395b
395c
del guard smps
396a
396b
397
$\sum_{l=1}^{32} x$
$\sum_{l=1}^{16} x$
reference symbols
delay
NB/Int filt
NB filt
$x^*$
(FIG.22)
383x
383y
UW detector
376a
376b
Ensemble plan receiver
373
reference symbol timing
frequency acquisition (FIG.24)
392
timing synchronization (FIG.19)
374


FIG. 23

FIG. 25

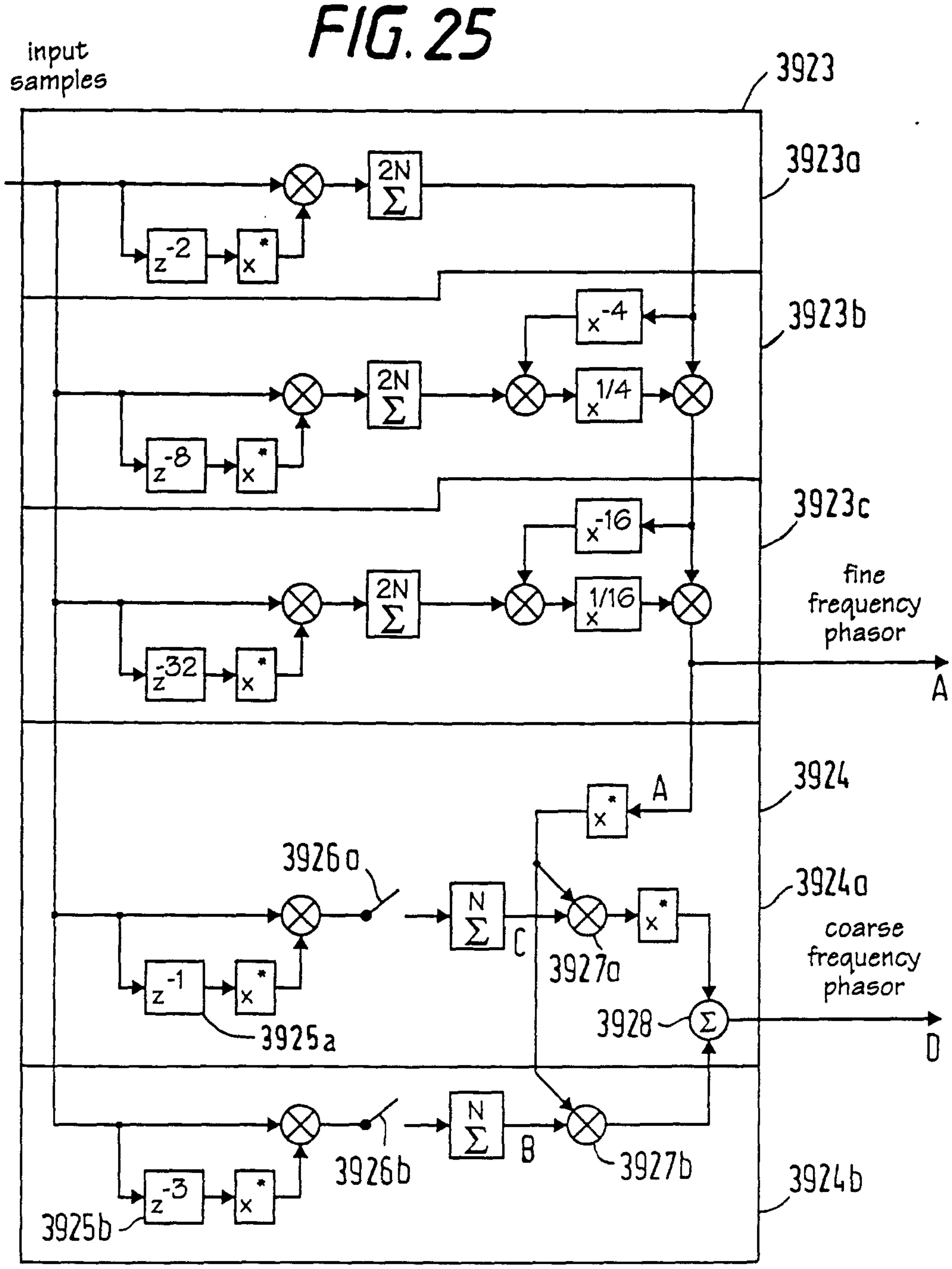
input samples
3923
3923a
2N Σ
$z^{-2}$
$x^*$
3923b
$x^{-4}$
$x^{1/4}$
$z^{-8}$
3923c
$x^{-16}$
$x^{1/16}$
$z^{-32}$
fine frequency phasor
A
3924
A
3926a
N Σ
C
3927a
3924a
coarse frequency phasor
$z^{-1}$
3925a
3928
Σ
D
N Σ
B
3926b
3927b
3924b
$z^{-3}$
3925b

FIG. 26

a) long and short delay phasors relative to the ambiguous phasor

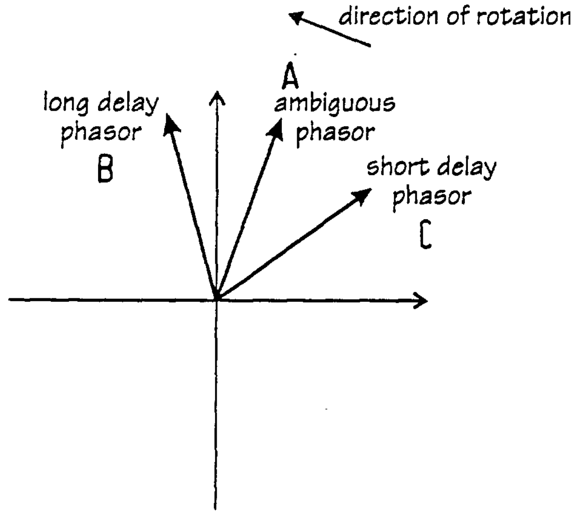


b) long and short delay phasors after rotation by the ambiguous phasor

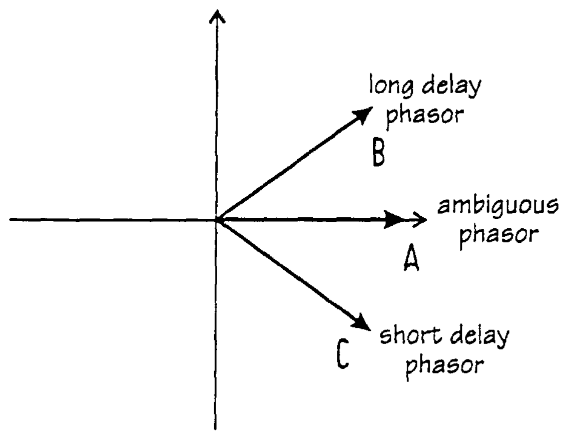


c) final unambiguous frequency phasor

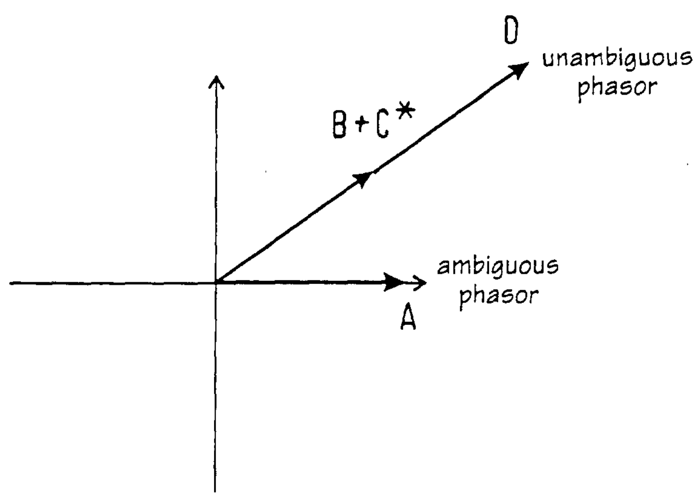

FIG. 27

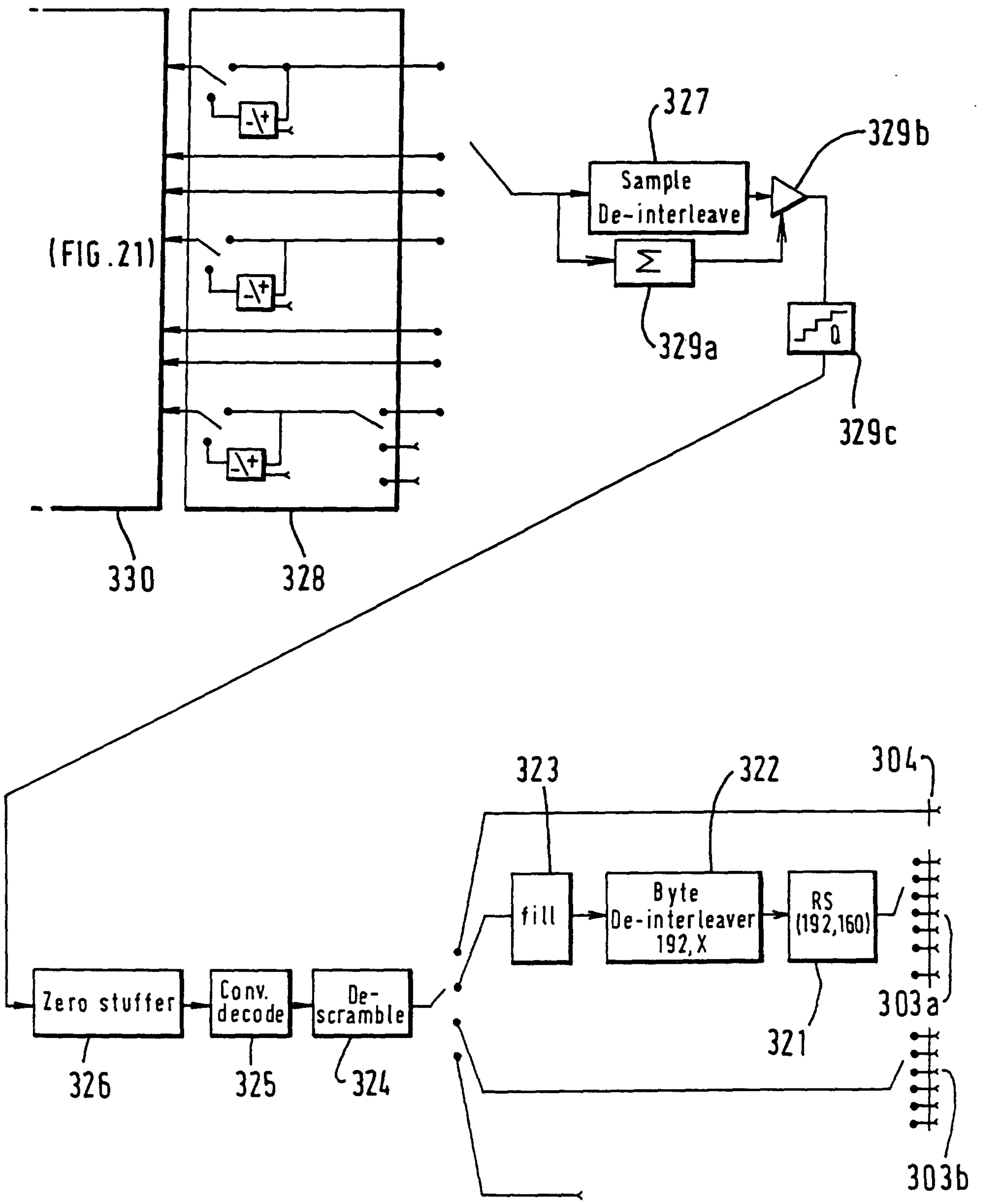
(FIG.21)
330
328
327
Sample
De-interleave
329b
Σ
329a
Q
329c
Zero stuffer
326
Conv.
decode
325
De-
scramble
324
323
fill
322
Byte
De-interleaver
192, X
RS
(192,160)
321
304
303a
303b

FIG.28

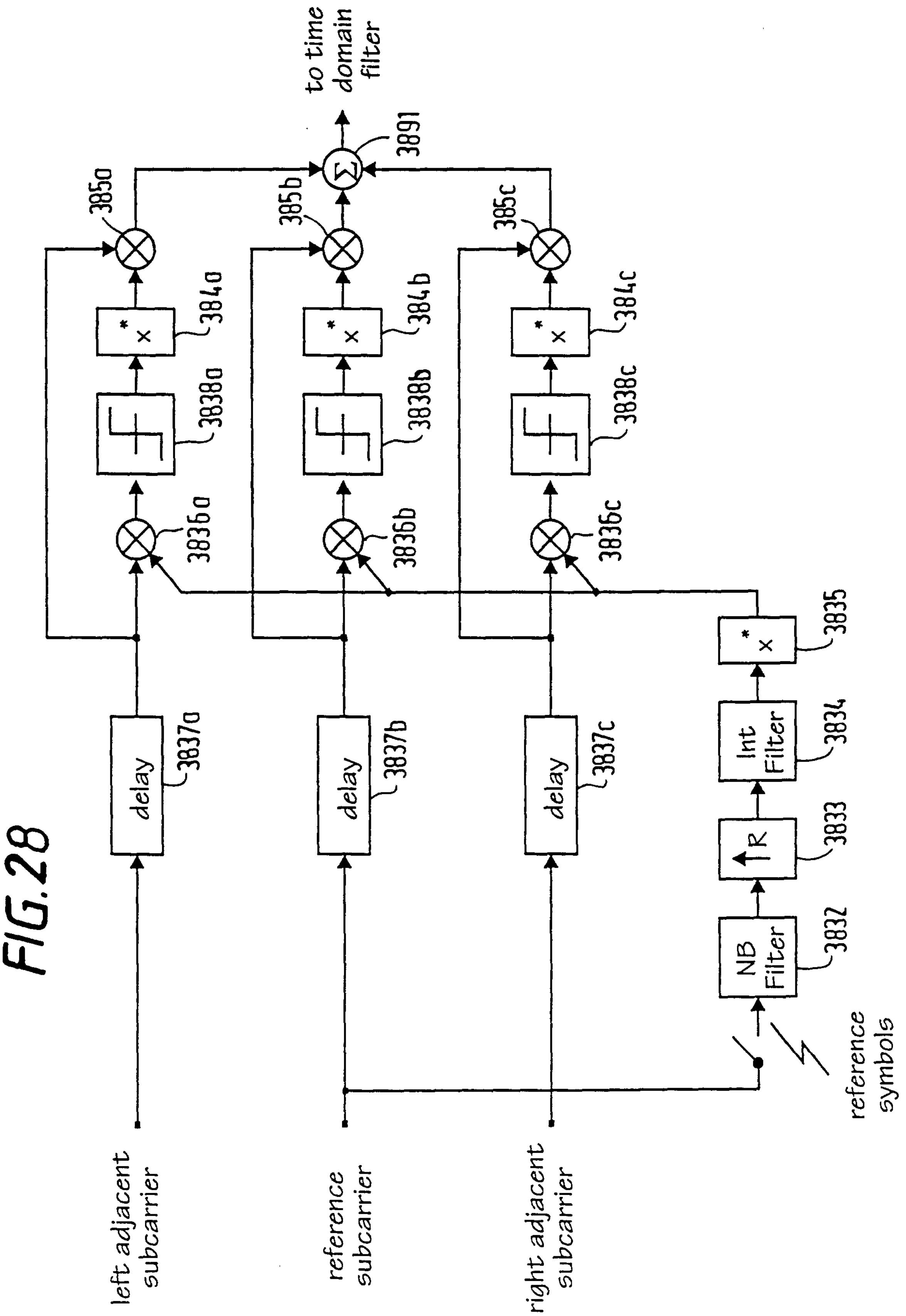
left adjacent subcarrier
reference subcarrier
right adjacent subcarrier
delay
3837a
3837b
3837c
3836a
3836b
3836c
3838a
3838b
3838c
384a
384b
384c
385a
385b
385c
3891
Σ
to time domain filter
reference symbols
NB Filter
3832
R
3833
Int Filter
3834
3835

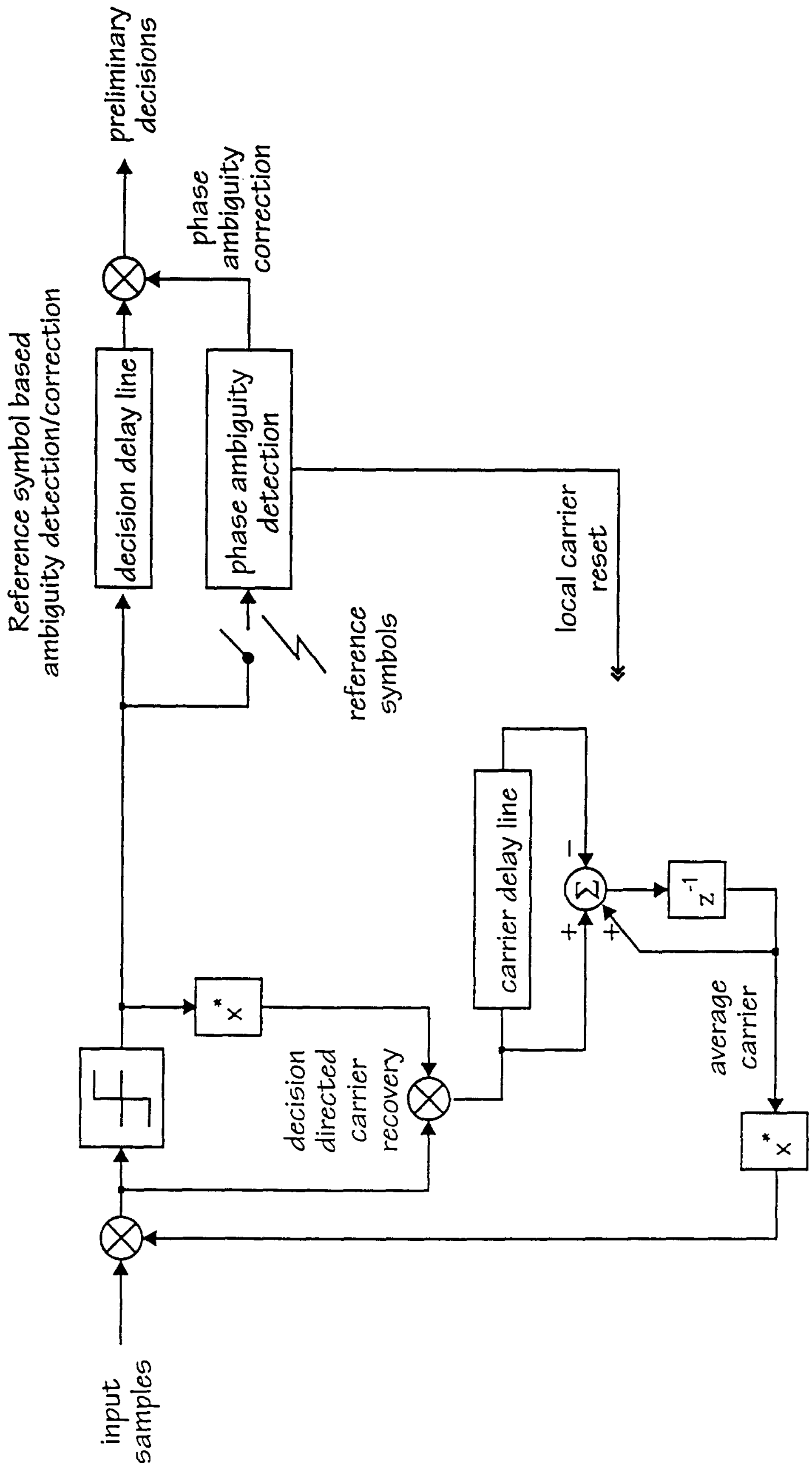
Reference symbol based ambiguity detection/correction
preliminary decisions
phase ambiguity correction
decision delay line
phase ambiguity detection
reference symbols
local carrier reset
input samples
decision directed carrier recovery
carrier delay line
average carrier

FIG. 29a

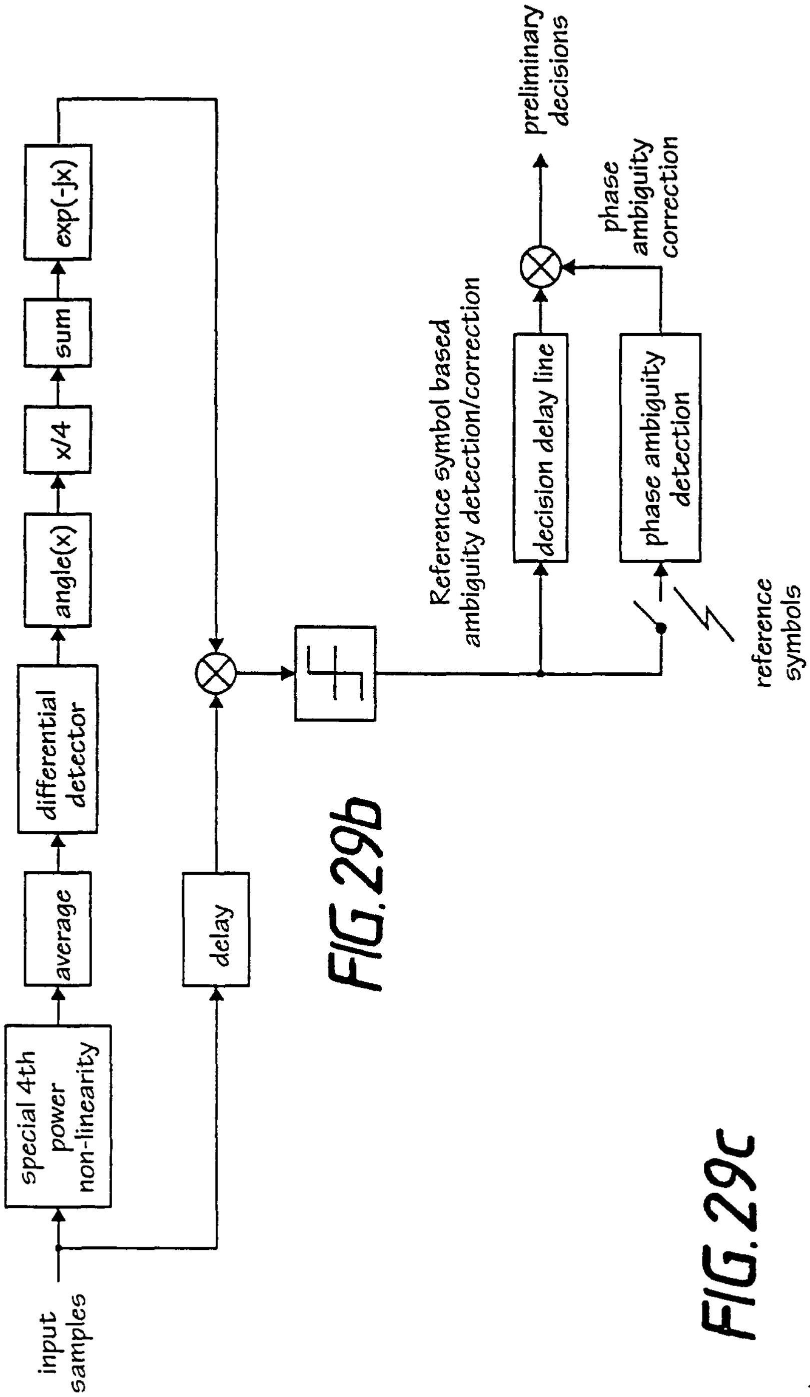


FIG.29b

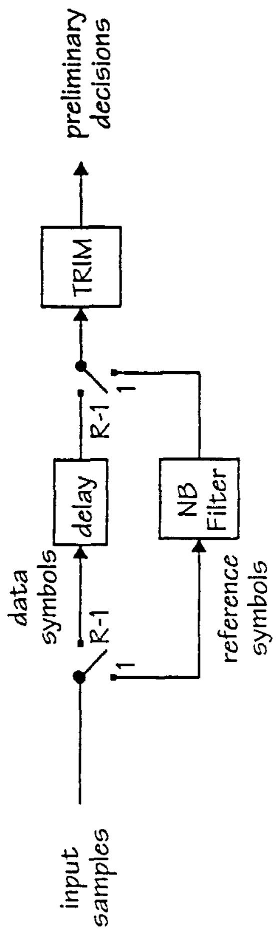


FIG.29c